Europäisches Patentamt

European Patent Office

Office européen des brevets

(19)

(11) Veröffentlichungsnummer : **0 527 866 B1**

(12) # EUROPÄISCHE PATENTSCHRIFT

(45) Veröffentlichungstag der Patentschrift :
13.04.94 Patentblatt 94/15

(51) Int. Cl.$^5$ : **G11C 29/00**

(21) Anmeldenummer : **91909228.8**

(22) Anmeldetag : **08.05.91**

(86) Internationale Anmeldenummer :
**PCT/EP91/00865**

(87) Internationale Veröffentlichungsnummer :
**WO 91/17545 14.11.91 Gazette 91/26**

(54) **INTEGRIERTER HALBLEITERSPEICHER MIT PARALLELTESTMÖGLICHKEIT UND REDUNDANZVERFAHREN.**

(30) Priorität : **10.05.90 EP 90108836**

(43) Veröffentlichungstag der Anmeldung :
**24.02.93 Patentblatt 93/08**

(45) Bekanntmachung des Hinweises auf die Patenterteilung :
**13.04.94 Patentblatt 94/15**

(84) Benannte Vertragsstaaten :
**AT DE FR GB IT NL**

(56) Entgegenhaltungen :
**EP-A- 0 186 040
EP-A- 0 283 906
DE-A- 3 916 533
US-A- 4 541 090**

(73) Patentinhaber : **SIEMENS AKTIENGESELLSCHAFT
Wittelsbacherplatz 2
D-80333 München (DE)**

(72) Erfinder : **MUHMENTHALER, Peter
Gustav-Heinemann-Ring 29
D-8000 München 83 (DE)**
Erfinder : **OBERLE, Hans, Dieter
Edelweissstr. 82
D-8031 Puchheim (DE)**
Erfinder : **PEISL, Martin
Rohdestr. 4
D-8000 München 60 (DE)**
Erfinder : **SAVIGNAC, Dominique
Bahnhofstr. 2
D-8045 Ismaning (DE)**

EP 0 527 866 B1

## Beschreibung

Die Erfindung betrifft einen integrierten Halbleiterspeicher mit einer Paralleltesteinrichtung, der in mehrere Blockgruppen eingeteilt ist, sowie ein Verfahren zum Ersetzen defekter Speicherzellen durch redundante Speicherzellen.

Ein entsprechender integrierter Halbleiterspeicher ist beispielsweise aus der EP-A 0 186 051 bekannt. Beim Testen dieses Speichers wird jeweils eine Speicherzelle einer Blockgruppe zusammen mit je einer Speicherzelle aus jeder der restlichen Blockgruppen gleichzeitig gemeinsam auf ihre Funktion geprüft. Wenn nun eine (oder mehrere) der gemeinsam geprüften Speicherzellen fehlerhaft sind, so kennt man aufgrund der an den Halbleiterspeicher angelegten Adressierungsdaten zwar die Position der geprüften Speicherzellen innerhalb der Blockgruppen, man weiß jedoch nicht, ob nur eine einzige oder mehrere der gleichzeitig getesteten Speicherzellen defekt sind, d.h. man weiß auch nicht, ob eine Blockgruppe oder ob mehrere Blockgruppen defekte Speicherzellen enthalten. Ebensowenig kann man die betroffene(n), fehlerhafte(n) Blockgruppe(n) identifizieren. Will man, aus welchem Grund auch immer, die defekte(n) Speicherzelle(n) und/oder deren Blockgruppe(n) identifizieren, so ist man gezwungen, den Halbleiterspeicher nochmals zu testen und ihn dabei konventionell zu betreiben, d.h. keine Benutzung der Paralleltestmöglichkeit und somit auch kein Ausnützen der in der obengenannten Schrift angegebenen Testzeitreduktion beim Testen ohne Paralleltestmöglichkeit. Ein weiterer Nachteil ist es, daß ein Fehler, der in allen gleichzeitig getesteten Speicherzellen auftritt, nicht erkennbar ist.

In "IEEE Transactions on Computers", Vol. 38, No. 3, March 1989, Seiten 394 bis 407, "Parallel Testing..." ist ein Halbleiterspeicher mit lediglich einer einzigen Blockgruppe offenbart, bei dem jeweils eine Gruppe von Speicherzellen entlang einer Wortleitung gleichzeitig testbar ist. Nachteil dieses Halbleiterspeichers ist, daß ein Fehler, der bei allen gleichzeitig getesteten Speicherzellen der Gruppe auftritt, nicht erkannt wird. Weiterhin ist es nachteilig, daß für jede Gruppe von Speicherzellen eine eigene Paralleltesteinrichtung benötigt wird.

Die EP-A 0 055 129 offenbart einen Halbleiterspeicher mit derselben Organisation wie die EP-A 0 186 051, bei dem auch ein Fehler erkannt wird, der an allen gleichezeitig getesteten Speicherzellen auftritt. Allerdings ist es auch hier nicht möglich, defekte Speicherzellen zu lokalisieren (außer alle gleichzeitig getesteten Speicherzellen sind defekt), wie bezüglich EP-A 0 186 051 bereits beschrieben.

Aus der EP-A 0 283 906 ist ein integrierter Halbleiterspeicher mit einer Paralleltesteinrichtung und mehreren Blockgruppen bekannt, bei dem in einer Testbetriebsart mehrere Gruppen von Speicherzellen gleichzeitig auf Funktion testbar sind, wobei jede Gruppe entlang einer jeweiligen Wortleitung innerhalb einer jeweiligen Blockgruppe der Blockgruppen angeordnet ist. Die beim Testen ausgelesenen Daten sind durch die Paralleltesteinrichtung auswertbar.

Aufgabe der vorliegenden Erfindung ist es, den eingangs beschriebenen Speicher so weiterzubilden, daß er folgende Vorgaben erfüllt:

- Auftretende Fehler an gleichzeitig getesteten Speicherzellen sollen unabhängig von der Anzahl der Defekte erkennbar sein,
- die Position defekter Speicherzellen soll in einem einzigen Prüfdurchlauf ermittelbar sein,
- der notwendige Platz- und Schaltelementaufwand für die Paralleltesteinrichtung soll möglichst gering sein.

Weiterhin soll ein Verfahren angegeben werden, das es ermöglicht, vollautomatisch, d.h. ohne Zwischenschaltung menschlicher Tätigkeit, einen in Form eines noch nicht in eine Gehäuse vergossenen Halbleiterchips vorliegenden Halbleiterspeicher sowohl im Paralleltestverfahren auf Funktion testen zu können wie auch als defekt erkannte Speicherzellen durch redundante Speicherzellen ersetzen zu können.

Ein entsprechendes Verfahren ist bislang noch nicht bekannt. Die Fachwelt geht bislang nach folgendem Schema vor:

- Testen des Halbleiterspeichers im Paralleltestverfahren,
- ist mindestens eine Speicherzelle des Halbleiterspeichers defekt, so erfolgt ein erneuter Testdurchlauf in einem Normalbetrieb, wobei die Adressen der defekten Speicherzellen festgestellt und festgehalten werden,
- anschließend werden in einem weiteren, durch notwendige menschliche Tätigkeiten von den Testdurchläufen getrennten Arbeitsschritt, die defekten Speicherzellen durch redundante Speicherzellen nach vorbekannten Algorithmen unter Verwendung der festgehaltenen Adressen ersetzt.

Diese Aufgabe wird gelöst mit den Merkmalen der Patentansprüche 1 und der Patentansprüche 79 und 80. Vorteilhafte Aus- und Weiterbildungen sind in Unteransprüchen gekennzeichnet.

Nachstehend wird die Erfindung anhand der Zeichnung beschrieben. Es zeigen:

Die Figur 1 den erfindungsgemäßen Speicher im Überblick,

die Figuren 2 bis 12 eine erste Ausführungsform mit vorteilhaften Ausgestaltungen,

die Figuren 13 bis 23 eine zweite Ausführungsform mit vorteilhaften Ausgestaltungen,

die Figur 24 die Kombination weiterer vorteilhafter Ausführungsformen.

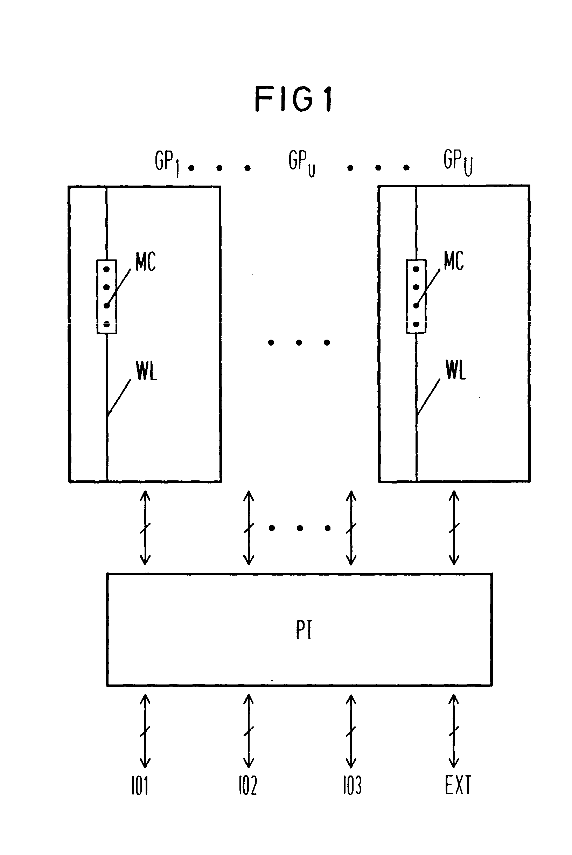

Ein erfindungsgemäßer Halbleiterspeicher mit Speicherzellen MC und mit einer Testeinrichtung PT nach Figur 1 enthält U Blockgruppen $GP_{1...U}$, allgemein $GP_u$. Zur Durchführung eines Paralleltests (= Testbetriebsart), d.h. eines Tests, bei dem viele Speicherzellen MC gleichzeitig (= innerhalb eines Speicherzyklus) getestet werden, die in einer Normalbetriebsart, wie ihn Anwender des Halbleiterspeichers durchführen, nicht gleichzeitig beschreibbar und/oder lesbar sind, ist die Paralleltesteinrichtung PT vorgesehen. Sie dient sowohl einem Einschreiben von in den Halbleiterspeicher einzuschreibenden Daten als auch einem Auslesen der in den Halbleiterspeicher eingeschriebenen Daten aus diesem, und zwar sowohl in der Normalbetriebsart wie auch in der Testbetriebsart. Eine Benutzung der Paralleltesteinrichtung PT sowohl in der Normal- wie auch in der Testbetriebsart ist bei keiner der vorgenannten Schriften möglich. Die Paralleltesteinrichtung PT und die Blockgruppen $GP_u$ sind über Daten-, Adreß- und Steuerleitungen miteinander verbunden, was in Figur 1 nur schematisch durch bidirektionale Pfeile dargestellt ist. Die Paralleltesteinrichtung PT ist weiterhin über Steuer- und Adreßleitungen ($\overline{RAS}$,...,ADR) mit Anschlüssen ("Ext" in Figur 1) des Halbleiterspeichers verbunden. Merkmale des Halbleiterspeichers, die deren Normalbetriebsart dienen und nicht durch für die Testbetriebsart vorgesehene Elemente beeinflußt sind, werden nachstehend nicht beschrieben, da sie dem Stand der Technik entsprechen können und deshalb nicht Bestandteil der vorliegenden Erfindung sind.

In der Testbetriebsart sind, mittels der Paralleltesteinrichtung PT, mehrere Gruppen von jeweils M Speicherzellen MC gleichzeitig auf Funktion testbar. Jede Gruppe von M Speicherzellen MC ist entlang einer jeweiligen Wortleitung WL angeordnet. Alle innerhalb eines Speicherzyklus ausgelesenen Daten sind in der Paralleltesteinrichtung PT auswertbar; das Ergebnis der Auswertung liegt dann, für jede Gruppe von Speicherzellen MC getrennt, an I/O-Datenleitungen IO1, IO2, gegebenenfalls IO3 an. Bei einem zur Durchführung des Testbetriebes notwendigen Einschreiben von Daten liegen diese an den I/O-Datenleitungen der 1. und 2. Art (IO1, IO2) an, gegebenenfalls auch an denen der 3. Art IO3. Die I/O-Datenleitungen IO1, künftig "I/O-Datenleitungen erster Art" genannt, sind, wie üblich, wenigstens mittelbar über Anschlußflächen PD des Halbleiterchips mit Anschlußbeinchen (Pins) des Halbleiterspeichers verbunden. Sie sind somit dem Anwender des fertig in ein Gehäuse eingekapselten Halbleiterspeichers elektrisch zugänglich. Die I/O-Datenleitungen IO2, IO3, künftig benannt als "I/O-Datenleitungen zweiter Art" bzw. "I/O-Datenleitungen dritter Art" können zwar auf dem Halbleiterchip mit Hilfsanschlußflächen PDx bzw. PDy verbunden sein. Diese sind jedoch nicht notwendigerweise an Anschlußpins des in ein Gehäuse eingekapselten Halbleiterspeichers elektrisch herausgeführt. Damit sind sie einem Anwender des Halbleiterspeichers elektrisch unzugänglich. Zwar ist der Anwender des Halbleiterspeichers dadurch von der Durchführung des Testbetriebes im Sinne der vorliegenden Erfindung ausgeschlossen. Der Hersteller des Halbleiterspeichers kann jedoch bis zur Montage des Halbleiterchips in ein Gehäuse in vollem Umfang den Paralleltestbetrieb ausüben. Somit kann er mittels eines zum Durchführen des Testbetriebs angeschlossenen Testautomaten die Ergebnisse automatisch erfassen und weiter auswerten (z.B. in Abhängigkeit von den für den jeweiligen Test an den Halbleiterspeicher angelegten Speicheradressen ADR). Sind diese Hilfsanschlußflächen PDx, PDy auf dem Halbleiterchip vorgesehen, so können diese, da das bekannte Bonden von Anschlußdrähten zu den Anschlußpins entfällt, geometrisch betrachtet kleiner ausgeführt sein als die normalen Anschlußflächen PD. Weiterhin können auch den I/O-Datenleitungen IO2, IO3 zugehörige Treiber kleiner dimensioniert werden als entsprechende Treiber für die I/O-Datenleitungen IO1, weil erstere keine so großen Lasten treiben müssen wie letztere (z.B. lange Leitungen auf einem Board, auf dem der Halbleiterspeicher montiert ist). Dieses minimiert den notwendigen Platzbedarf für diese Treiber ebenfalls. Wären die Hilfsanschlußflächen PDx, PDy mit Anschlußpins verbunden, so müßte deren Anzahl erhöht werden. Damit wäre dieser Halbleiterspeicher nicht mehr pin-kompatibel mit entsprechenden Halbleiterspeichern der Konkurrenz.

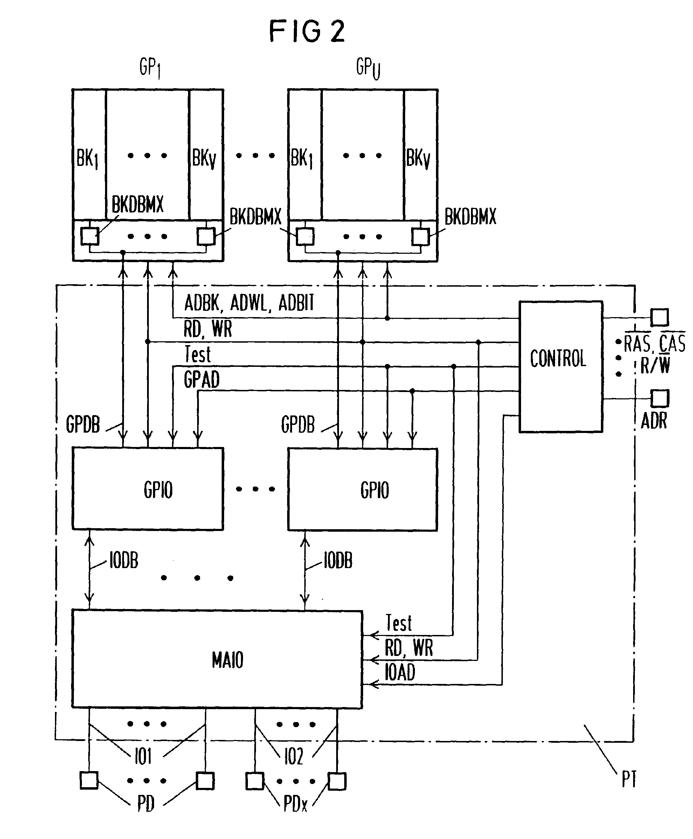

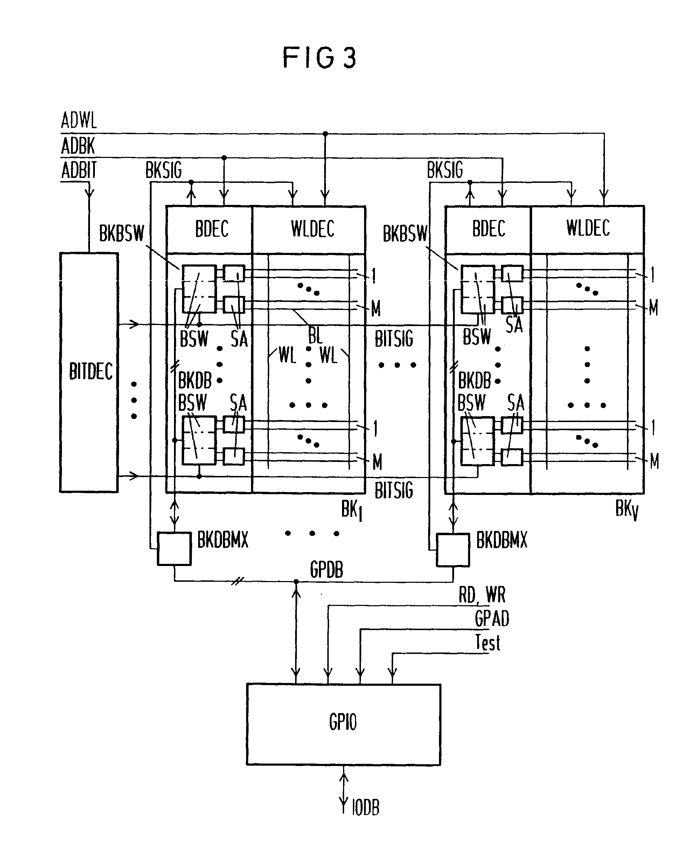

Figur 2 zeigt eine erste Ausführungsform des erfindungsgemäßen Halbleiterspeichers in einer globalen Übersicht. Mögliche, erfindungsgemäße Aus- und Weiterbildungen dazu zeigen die Figuren 3 bis 12.

Figur 2 zeigt, in Auswahl, zwei Blockgruppen $GP_I$, $GP_U$, wobei dazwischenliegende, nicht dargestellte Blockgruppen durch Punkte angedeutet sind. Jede Blockgruppe $GP_u$ (u = I...U) enthält V Speicherblöcke $BK_{I...V}$, allgemein $BK_v$ (v = I...V), wobei jeweils nur die Speicherblöcke $BK_I$, $BK_V$ dargestellt sind. Die Speicherblöcke $BK_v$ enthalten die Speicherzellen MC des Halbleiterspeichers, matrixförmig angeordnet entlang Wortleitungen WL und Bitleitungen BL (dargestellt in Figur 3). Im Betrieb ist zu jedem Zeitpunkt maximal ein Speicherblock $BK_v$ je Blockgruppe $GP_u$ auswählbar, d.h. insgesamt sind maximal U Speicherblöcke $BK_v$ des Halbleiterspeichers gleichzeitig auswählbar. Die mögliche, nähere Ausgestaltung eines Speicherblockes ist nachstehend bezüglich Figur 3 näher beschrieben.

Figur 2 zeigt auch die Paralleltesteinrichtung PT in einer globalen Übersicht. Sie enthält U Gruppenein-/Ausgabeeinheiten GPIO, wobei jede einer der U Blockgruppen $GP_u$ zugeordnet ist. Jede Gruppenein-/ausgabeeinheit GPIO ist eingangsmäßig mit einem Gruppendatenbus GPDB verbunden, dessen Entstehung und Funktion in

EP 0 527 866 B1

Figur 3 und nachfolgende Figuren näher erläutert wird. Er führt in die Speicherzellen MC einzuschreibende bzw. aus diesen auszulesende Daten. Ausgangsmäßig ist sie mit einem Ein-/Ausgabedatenbus IODB verbunden. Alle Gruppenein-/ausgabeeinheiten GPIO sind gemeinsam durch ein Testsignal Test und einen Gruppenadreßbus GPAD angesteuert sowie durch wenigstens ein Steuersignal WR, RD zum Schreiben von Daten in die Speicherzellen MC und zu deren Auslesen. Dieses Steuersignal kann als ein einziges Steuersignal ausgeführt sein, wobei ein Schreiben durchführbar ist, wenn es einen ersten logischen Pegel aufweist und wobei ein Lesen durchführbar ist, wenn es einen zweiten logischen Pegel aufweist, der zum ersten logischen Pegel komplementär ist. In dieser Ausführung entspricht es praktisch dem R/W-Signal R/$\overline{\text{W}}$, das bekanntlich jeder Schreiblesespeicher (RAM) als extern anlegbares Steuersignal aufweist, und das auch der Halbleiterspeicher nach der vorliegenden Erfindung aufweist. Bei den hier beschriebenen Ausführungsbeispielen ist es allerdings in Form von zwei separaten Steuersignalen angenommen (Schreibsteuersignal WR und Lesesteuersignal RD), die aus dem genannten R/W-Signal R/$\overline{\text{W}}$ abgeleitet sind.

Die Paralleltesteinrichtung PT enthält weiterhin eine Zellenfeldein-/Ausgabeeinheit MAIO. Diese ist allen Gruppendatenein-/Ausgabeeinheiten GPIO gemeinsam und somit auch allen Blockgruppen GP$_u$ zugeordnet. Sie ist eingangsmäßig mit den Ein-/Ausgabedatenbussen IODB der Gruppendatenein-/Ausgabeeinheiten GPIO verbunden. Ausgangsmäßig ist sie mit P I/O-Datenleitungen der ersten Art IO1 und mit (U-P) I/O-Datenleitungen der zweiten Art IO2 verbunden. Die Zellenfeldein/-ausgabeeinheit MAIO ist angesteuert durch das wenigstens eine Steuersignal RD, WR für Lesen und Schreiben, durch das Testsignal Test und durch einen I/O-Adreßbus IOAD.

Die I/O-Datenleitungen IO1 der ersten Art sind wenigstens mittelbar mit solchen Anschlußflächen PD (allgemein als "Pads" bezeichnet) des Halbleiterspeichers verbunden, die über Anschlußvorrichtungen (allgemein als "Pins" bekannt) des Halbleiterspeichers einem Anwender des Halbleiterspeichers elektrisch zugänglich sind. Die I/O-Datenleitungen IO2 der zweiten Art können, wie dargestellt, wenigstens mittelbar mit Hilfsanschlußflächen PDx (allgemein als "Hilfspads" bekannt) des Halbleiterspeichers verbunden sein, die lediglich auf dem Halbleiterchip selbst zugänglich sind, so daß sie einem Anwender des Halbleiterspeichers (nach Einkapselung des Chips in ein Gehäuse) elektrisch unzugänglich sind. Damit kann der Hersteller des erfindungsgemäßen Halbleiterspeichers alle Vorteile der vorliegenden Erfindung ausnützen, ohne seine Abnehmer daran beteiligen zu müssen. Außerdem ist dadurch der Halbleiterspeicher pin-kompatibel mit entsprechenden anderen Halbleiterspeichern ohne diese Paralleltesteinrichtung.

Weiterhin enthält die Paralleltesteinrichtung PT wenigstens eine Steuereinheit CONTROL. Sie hat Eingänge für dem Halbleiterspeicher von extern zuführbare Adreßsignale ADR und Steuersignale wie z. B. die allgemein bekannten Signale $\overline{\text{RAS}}$ ("Row Address Strobe"), $\overline{\text{CAS}}$ ("Column Address Strobe"), R/$\overline{\text{W}}$ ("Read/Write Enable"). Sie hat Ausgänge für Blockadressen ADBK, Wortleitungsadressen ADWL und Bitgruppenadressen ADBIT. Diese Adressen werden nachstehend anhand von Figur 3 noch näher erläutert. Die Steuereinheit CONTROL hat weiterhin noch Ausgänge für das wenigstens eine Steuersignal zum Schreiben und zum Lesen (WR, RD), für das Testsignal Test, für den Gruppenadreßbus GPAD und für den I/O-Adreßbus IOAD. Das wenigstens eine Steuersignal WR, RD zum Schreiben und Lesen sei hier ausgeführt in Form zweier eigener Steuersignale, nämlich dem bereits genannten Schreibsteuersignal WR und dem (ebenfalls bereits genannten) Lesesteuersignal RD.

Die extern zuführbaren Adreßsignale ADR enthalten, wie allgemein üblich, sogenannte Row-Address-Signale und sogenannte Column-Address-Signale. Die Steuereinheit CONTROL generiert aus den extern zuführbaren Adreßsignalen ADR, z.B. aus einem ersten Teil der Row-Address-Signale, die Blockadressen ADBK. Sie generiert aus den extern zuführbaren Adreßsignalen ADR, z.B. aus einem zweiten Teil der Row-Address-Signale, weiterhin die Wortleitungsadressen ADWL. Außerdem generiert die Steuereinheit CONTROL aus den extern zuführbaren Adreßsignalen ADR, z.B. aus einem ersten Teil der Column-Address-Signale, die Bitgruppenadressen ADBIT, den Gruppenadreßbus GPAD (z.B. aus einem zweiten Teil der Column-Address-Signale) und den I/O-Adreßbus IOAD (z.B. aus einem dritten, letzten Teil der Column-Address-Signale). Die Art der Generierung bereitet dem Fachmann anhand dieser Ausführungen keinerlei Probleme. Im einfachsten Fall speichert er alle Row-Address-Signale und alle Column-Address-Signale mit Hilfe von $\overline{\text{RAS}}$ und $\overline{\text{CAS}}$ in entsprechenden Adreßpuffern zwischen und leitet die obengenannten Teile der (zwischengespeicherten) Row- und Column-Address-Signale weiter an die entsprechenden Ausgänge für die Blockadressen ADBK, die Wortleitungsadressen ADWL, die Bitgruppenadressen ADBIT, den Gruppenadreßbus GPAD und den I/O-Adreßbus IOAD.

Die Steuereinheit CONTROL generiert weiterhin das Lesesteuersignal RD und das Schreibsteuersignal WR, beispielsweise allein aus dem extern anliegenden Signal R/$\overline{\text{W}}$. Weist dieses einen ersten logischen Pegel (z. B. "High") auf, so nehmen das Lesesteuersignal RD einen aktivierten Zustand (z. B. ebenfalls "High") an und das Schreibsteuersignal WR einen inaktiven Zustand (z.B. "Low"). Weist das externe Signal R/$\overline{\text{W}}$ hingegen einen zweiten logischen Pegel (z.B. "Low") auf, der zum ersten logischen Pegel komplementär ist, so nehmen

4

das Lesesteuersignal RD einen inaktiven Zustand (z.B. ebenfalls "Low") an und das Schreibsteuersignal WR einen aktivierten Zustand (z.B. "High").

Außerdem generiert die Steuereinheit CONTROL das Testsignal Test. Dies geschieht, vorzugsweise nach der Norm "JEDEC Standard 21-B" des JEDEC-Committees, mittels einem oder mehreren der extern zuführbaren Adreßsignale ADR und mittels der extern zuführbaren Steuersignale $\overline{RAS}$, $\overline{CAS}$, R/$\overline{W}$. Diese Norm sieht für DRAM's mit Adreßmultiplexbetrieb eine genormte Initialisierungsmöglichkeit für verschiedene Betriebsmodi vor, unter anderem auch für die Möglichkeit, verschiedene Testbetriebsarten aktivieren zu können. Dies erfolgt über eine bestimmte Taktkombination der extern zuführbaren Steuersignale $\overline{RAS}$, $\overline{CAS}$, R/$\overline{W}$ in Verbindung mit bestimmten externen Adreßsignalen ADR.

Die obengenannte JEDEC-Norm sieht für den vorliegenden Fall vor, daß ein Einsprung in den Testbetrieb über einen sogenannten Write-CAS-before-RAS"-Zyklus ("WCBR") erfolgt. Zu Beginn eines solchen Speicherzyklus liegen folgende Signalverhältnisse an den Eingängen des Halbleiterspeichers für die entsprechenden Steuersignale vor: R/$\overline{W}$ und $\overline{CAS}$ sind bereits auf "Low", $\overline{RAS}$ geht auf "Low". Über eine zum Zeitpunkt des Übergangs des Steuersignals $\overline{RAS}$ von "High" auf "Low" anliegende, vom JEDEC-Committee vorgegebene Kombination von extern anlegbaren Adreßsignalen ADR wird dann die für die vorliegende Erfindung maßgebliche Testbetriebsart "eingeschaltet", d.h. die Steuerschaltung CONTROL generiert das bereits genannte Testsignal Test. Für die vorliegende Erfindung kann die Beachtung der JEDEC-Norm (aus wirtschaftlichen oder vertraglichen Gründen) zwar sinnvoll sein, sie ist aber nicht notwendig. Andere Möglichkeiten zur Generierung des Testsignals Test sind möglich und auch vorstellbar (einfachstes Beispiel: Anlegen eines zusätzlichen Signals an einen ansonsten nicht verwendeten Anschluß ("NC-Pin") des Halbleiterspeichers oder Anlegen eines Signals mit Überspannung an einen (ansonsten anderweitig) benutzten Anschluß (z.B. Adreßsignalanschluß).

Ist das Testsignal Test aktiviert, so ist der Halbleiterspeicher in der Testbetriebsart gemäß der vorliegenden Erfindung betreibbar, ansonsten in einer Normalbetriebsart, die allerdings wiederum eine (andere) Testbetriebsart sein kann, welche unabhängig ist von der vorliegenden Erfindung.

Figur 3 zeigt weitere Einzelheiten des erfindungsgemäßen Halbleiterspeichers, die in Figur 2 aus Gründen der Übersichtlich-keit weggelassen wurden. Dargestellt sind zwei (BK$_I$, BK$_V$) der V Speicherblöcke BK$_v$ einer Blockgruppe GP$_u$. Die restlichen, nicht dargestellten Speicherblöcke sind gleich aufgebaut. Jeder Speicherblock BK$_I$, BK$_V$ enthält einen Blockdekoder BDEC. Er dient einer Auswahl des jeweiligen Speicherblocks (z.B. des Speicherblocks BK$_I$) aus der Menge der Speicherblöcke BK$_v$ seiner Blockgruppe GP$_u$. Im Normalbetrieb wie im Testbetrieb werden in allen Blockgruppen GP$_u$ gleichzeitig jeweils ein Speicherblock BK$_v$ je Blockgruppe GP$_u$ ausgewählt. Ein Blockdekoder BDEC wird dann aktiviert, wenn an seinen Eingängen anliegende Blockadressen ADBK (erzeugt durch die Steuereinheit CONTROL) einen für ihn spezifischen Adreßwert aufweisen. Die Blockadressen ADBK weisen dazu eine solche Anzahl einzelner Adreßsignale auf, daß aus ihnen jeder der V Blockdekoder BDEC eine für ihn gültige Adreßkombination dekodieren kann. In diesem Fall aktiviert er ein Blockauswahlsignal BKSIG als Ausgangssignal.

Jeder Speicherblock BK$_v$ enthält weiterhin Wortleitungsdekoder WLDEC, denen, wie üblich, (nicht dargestellte) Wortleitungstreiber nachgeschaltet sind zur Ansteuerung der einzelnen Wortleitungen WL des jeweiligen Speicherblocks BK$_v$. Die Wortleitungsdekoder WLDEC werden einerseits durch die (von der Steuereinheit CONTROL erzeugten) Wortleitungsadressen ADWL und andererseits vom Blockauswahlsignal BKSIG des zugehörigen Blockdekoders BDEC angesteuert. Die Wortleitungsadressen ADWL weisen dazu ebenfalls eine solche Anzahl einzelner Adreßsignale auf, daß aus ihnen jeder der Wortleitungsdekoder WLDEC eines Speicherblocks BK$_v$ eine für ihn gültige Adreßkombination dekodieren kann.

Die Bitleitungen BL eines Speicherblocks BK$_v$ sind jeweils paarweise zusammengefaßt und mit einem Leseverstärker SA verbunden, wie allgemein üblich. An jeden Leseverstärker SA ist auch ein Paar von Verbindungsleitungen mit seinem einen Ende angeschlossen. Beim Einschreiben von Daten in Speicherzellen MC entlang der mit einer der Bitleitungen BL des mit dem jeweiligen Leseverstärker SA verbundenen Bitleitungspaares dienen sie einer Zuführung dieser Daten an den Leseverstärker SA und die damit verbundenen Bitleitungen BL. Beim Auslesen von Daten aus Speicherzellen MC entlang einer der Bitleitungen BL des mit dem jeweiligen Leseverstärker SA verbundenen Bitleitungspaares dienen sie einer Weiterleitung der ausgelesenen, durch den Leseverstärker SA bewerteten und verstärkten Daten.

Am anderen Ende jedes Paares der Verbindungsleitungen ist jeweils ein Bitschalter BSW angeordnet. Jeweils M Bitschalter BSW (M = natürliche Zahl größer 1) sind zu einem Bitschalterblock BKBSW zusammengefaßt. Jeder Bitschalterblock BKBSW ist durch ein Bitgruppen-Auswahlsignal BITSIG angesteuert, sodaß jeweils M Speicherzellen MC gleichzeitig beschreibbar und/oder lesbar sind. Je Blockgruppe GP$_u$ kann dabei ein Bitgruppen-Auswahlsignal BITSIG zur Ansteuerung je eines Bitschalterblockes BKBSW in einem, in mehreren oder in allen (letzteres ist in Figur 3 gezeigt) Speicherblöcken BK$_v$ verwendet werden.

Jeder Speicherblock BK$_v$ weist einen Blockdatenbus BKDB auf, über den die in die Speicherzellen MC des jeweiligen Speicherblocks BK$_v$ einzuschreibenden Daten und die aus diesen (MC) auszulesenden Daten geführt werden. Jeder Blockdatenbus BKDB weist M Paare von Datenleitungen zum Lesen (BKDB-RD) und zum Schreiben (BKDB-WR) auf. Diese können entweder bidirektional oder unidirektional ausgeführt sein. In den Figuren ist jeweils die Variante mit unidirektional betreibbaren Leitungen gezeigt. In dieser Variante weist ein Blockdatenbus BKDB also M Paare von Lesedatenleitungen BKDB-RD und M Paare von Schreibdatenleitungen BKDB-WR auf. Bei der anderen, nicht gezeigten Variante (bidirektional betreibbare Leitungen) weist ein Blockdatenbus BKDB entsprechend M Paare von Datenleitungen auf, die sowohl dem Schreiben wie auch dem Lesen dienen. Dadurch notwendige Anpassungen einzelner Komponenten der vorliegenden Erfindung liegen im Können des Durchschnittsfachmanns, so daß sie hier nicht extra gezeigt werden brauchen, noch dazu, weil sie zum Gedanken der vorliegenden Erfindung nichts beitragen.

Die M Paare von Lesedatenleitungen BKDB-RD sind mit den M Paaren von Verbindungsleitungen jedes Bitschalterblockes BKBSW wahlweise, unter Steuerung des jeweiligen Bitgruppen-Auswahlsignals BITSIG, über den Bitschalterblock BKBSW verbindbar. Ebenso sind die M Paare von Schreibdatenleitungen BKDB-WR mit den M Paaren von Verbindungsleitungen jedes Bitschalterblocks BKBSW wahlweise, unter Steuerung des jeweiligen Bitgruppen-Auswahlsignals BITSIG, über den Bitschalterblock BKBSW verbindbar. Entsprechendes gilt für die nicht gezeigte Variante bidirektional betreibbarer Datenleitungen des Blockdatenbusses BKDB. Dabei sind die M Paare von Datenleitungen, die sowohl dem Lesen wie dem Schreiben dienen, mit den M Paaren von Verbindungsleitungen jedes Bitschalterblocks BKBSW wahlweise, unter Steuerung des jeweiligen Bitgruppen-Auswahlsignals BITSIG, über den Bitschalterblock BKBSW verbindbar.

Figur 3 zeigt einen Bitgruppendekoder BITDEC zur Erzeugung der Bitgruppen-Auswahlsignale BITSIG. Diese werden in einer Anzahl erzeugt, die gleich ist der Anzahl der Bitschalterblöcke BKBSW eines der Speicherblöcke $BK_v$. Sie dienen letztendlich der Anwahl von Bitleitungen BL wie bei bekannten Speichern. Dadurch, daß sie je Bitschalterblock BKBSW, wie beschrieben, jeweils M Bitschalter BSW aktivieren, verbinden sie (im Unterschied zum Stand der Technik) jeweils M Paare von Verbindungsleitungen (die ja wiederum M Paaren von Bitleitungen BL über die jeweiligen Leseverstärker SA zugeordnet sind, wie beschrieben) mit dem Blockdatenbus BKDB. Die Bitgruppen-Auswahlsignale BITSIG sind also in einer Anzahl (A:M) vorhanden, wobei A = Anzahl der Paare von Bitleitungen BL je Wortleitung WL eines Speicherblockes $BK_v$ ist. Die Anzahl der dazu notwendigen Bitgruppenadressen ADBIT ist so groß, daß aus ihnen die (A:M) Bitgruppen-Auswahlsignale BITSIG dekodierbar sind. Je Blockgruppe $GP_u$ ist wenigstens ein Bitgruppendekoder BITDEC erforderlich. In diesem Fall sind seine Bitgruppen-Auswahlsignale BITSIG einem jeweiligen Bitschalterblock BKBSW in allen Speicherblöcken $BK_v$ der jeweiligen Blockgruppe $GP_u$ zugeführt. Es sind jedoch auch, wie bereits beschrieben, mehrere Bitgruppendekoder BITDEC vorsehbar, die dann Bitschalterblöcke BKBSW nur eines Teils der Speicherblöcke $BK_v$ über ihre Bitgruppen-Auswahlsignale BITSIG ansteuern. Im Maximalfall ist für jeden einzelnen der V Speicherblöcke $BK_v$ ein Bitgruppendekoder BITDEC vorsehbar. Vorteile dafür sind nicht ersichtlich, allerdings ein wesentlicher Nachteil: der benötigte Platzaufwand wird entsprechend größer. Der Bitgruppendekoder BITDEC wird von den Bitgruppenadressen ADBIT (erzeugt durch die Steuereinheit CONTROL, wie bereits beschrieben) angesteuert, aus denen er die Bitgruppen-Auswahlsignale BITSIG dekodiert.

Jedem Speicherblock $BK_v$ (in Figur 3 dargestellt die Speicherblöcke $BK_I$, $BK_V$; die restlichen Speicherblöcke sind durch Punkte angedeutet) ist ein Blockdatenbus-Multiplexer BKDBMX zugeordnet. Dieser hat sowohl eine differenziell-verstärkende wie auch eine multiplexende Funktion. Er ist einerseits mit den Schreibdatenleitungen BKDB-WR und den Lesedatenleitungen BKDB-RD des Blockdatenbusses BKDB des jeweiligen Speicherblockes $BK_v$ verbunden. Andererseits ist er mit M Paaren von Datenleitungen zum Schreiben GPDB-WR und zum Lesen GPDB-RD eines Gruppendatenbusses GPDB verbunden. Der Gruppendatenbus GPDB ist mit allen Blockdatenbus-Multiplexern BKDBMX der Speicherblöcke $BK_v$ einer Blockgruppe $GP_u$ verbunden. Ähnlich wie bei den Datenleitungen des Blockdatenbusses BKDB (vgl. die diesbezügliche, vorstehende Beschreibung) können auch die Datenleitungen des Gruppendatenbusses GPDB entweder bidirektional betreibbar oder unidirektional betreibbar ausgeführt sein. Der weiteren Beschreibung wird die unidirektionale Variante zugrundegelegt, so daß der Gruppendatenbus GPDB M Paare von Schreibdatenleitungen GPDB-WR und M Paare von Lesedatenleitungen GPDB-RD aufweist.

Jeder Blockdatenbus-Multiplexer BKDBMX ist durch das Blockauswahlsignal BKSIG des Blockdekoders BDEC desjenigen Speicherblocks $BK_v$ gesteuert, dem der Blockdatenbus-Multiplexer BKDBMX zugeordnet ist. Da, wie eingangs bereits beschrieben, im Betrieb (unabhängig von Test- und Normalbetrieb) in jedem Zeitpunkt jeweils nur ein Speicherblock $BK_v$ einer Blockgruppe $GP_u$ aktivierbar ist, ist jeweils auch nur ein einziger Blockdekoder BDEC und somit nur ein einziges Blockauswahlsignal BKSIG aktiviert. Damit ist immer nur maximal ein einziger der Blockdatenbusse BKDB einer Blockgruppe $GP_u$ über den jeweiligen Blockdatenbus-Multiplexer BKDBMX mit dem Gruppendatenbus GPDB verbunden.

Figur 3 zeigt weiterhin eine der U Gruppenein-/ausgabeeinheiten GPIO der Paralleltesteinrichtung PT mit ihren Anschlüssen, wie in Figur 2 bereits beschrieben. Der Ein-/Ausgabedatenbus IODB kann, ähnlich den Blockdatenbussen BKDB und dem Gruppendatenbus GPDB, ein einziges Datenleitungspaar zum Schreiben und zum Lesen aufweisen (bidirektional). Er kann aber auch, wie in den nachstehenden Figuren beschrieben, ein Paar von Datenleitungen zum Schreiben IODB-WR, $\overline{\text{IODB-WR}}$ und ein Paar von Datenleitungen zum Lesen IODB-RD, $\overline{\text{IODB-RD}}$ aufweisen (unidirektional).

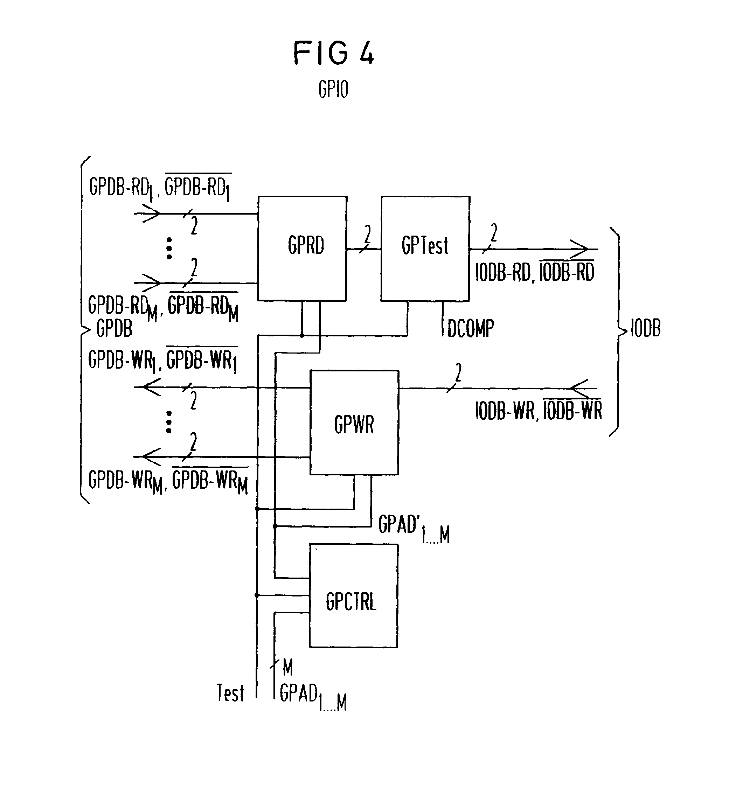

Figur 4 zeigt eine Gruppenein-/ausgabeeinheit GPIO in Blockbilddarstellung. Sie enthält eine Gruppensteuerschaltung GPCTRL, eine Gruppenschreibeinheit GPWR, eine Gruppenleseeinheit GPRD und eine Gruppentesteinheit GPTest. Der Gruppenadreßbus GPAD enthält M Gruppenadreßsignale $GPAD_{1...M}$, allgemein $GPAD_m$, von denen, unabhängig von der Betriebsart, jeweils eines aktiviert ist, d.h. einen ersten logischen Pegel aufweist (z.B. "High") und von denen die restlichen Gruppenadreßsignale deaktiviert sind, d. h. sie weisen einen zweiten logischen Pegel auf (z.B. "Low"), der zum ersten logischen Pegel komplementär ist. Dies wird durch die Steuereinheit CONTROL der genannten Paralleltesteinrichtung PT sichergestellt, z.B. durch entsprechendes Dekodieren eines Teils der extern zu führbaren Adreßsignale ADR.

Die Gruppensteuerschaltung GPCTRL ist eingangsmäßig mit den M Gruppenadreßsignalen $GPAD_m$ des Gruppenadreßbusses GPAD und mit dem Testsignal Test verbunden. Sie weist Ausgänge auf für M Gruppenadreßausgangssignale $GPAD'_{1...M}$ (allgemein $GPAD'_m$), die den Gruppenadreßsignalen $GPAD_m$ zugeordnet sind.

Diese weisen in der Testbetriebsart alle gemeinsam einen logischen Pegel auf (z.B. alle "High" oder alle "Low"). Welcher Art dieser logische Pegel (High oder Low) ist, ist vom Prinzip her unwichtig, sie ist lediglich abhängig von der in der Gruppenleseeinheit GPRD und der Gruppenschreibeinheit GPWR verwendeten Logik (positive oder negative Logik). Vorliegend wird positive Logik verwendet, so daß dieser logische Pegel gleich "High" (= log. 1) sei.

In der Normalbetriebsart, d.h. das Testsignal Test ist deaktiviert, weist jedes der Gruppenadreßausgangssignale $GPAD'_{1...M}$ den logischen Zustand des jeweils zugeordneten Gruppenadreßsignals $GPAD_m$ auf. Dies ist in der nachstehenden Tabelle 1 (für M = 3) verdeutlicht, wobei "Test = 1" bedeutet, daß das Testsignal Test aktiviert sei und (bei angenommener positiver Logik) den Wert log. l aufweise. Entsprechend bedeutet "Test = 0", daß das Testsignal deaktiviert ist, entsprechend "log. 0". Weiterhin bedeutet "x": don't care.

| Test | $GPAD_1$ | $GPAD_2$ | $GPAD_3$ | $GPAD'_1$ | $GPAD'_2$ | $GPAD'_3$ |
|------|----------|----------|----------|-----------|-----------|-----------|
| 0 | 1 | 0 | 0 | 1 | 0 | 0 |
| 0 | 0 | 1 | 0 | 0 | 1 | 0 |
| 0 | 0 | 0 | 1 | 0 | 0 | 1 |
| 1 | x | x | x | 1 | 1 | 1 |

Tab. 1

Die Gruppenschreibeinheit GPWR weist Eingänge auf für die Gruppenadreßausgangssignale $GPAD'_m$ sowie zwei weitere Eingänge für die beiden Schreibdatenleitungen IODB-WR, $\overline{\text{IODB-WR}}$ des Ein-/Ausgabedatenbusses IODB. Sie weist M Paare von Ausgängen auf für die M Paare von Schreibdatenleitungen $GPDB\text{-}WR_m$, $\overline{GPDB\text{-}WR_m}$ des Gruppendatenbusses GPDB.

Entsprechend weist die Gruppenleseeinheit GPRD M Paare von Eingängen auf für die M Paare von Lesedatenleitungen $GPDB\text{-}RD_m$, $\overline{GPDB\text{-}RD_m}$ des Gruppendatenbusses GPDB sowie weitere Eingänge für die M Gruppenadreßausgangssignale $GPAD'_m$ der Gruppensteuerschaltung GPCTRL. Außerdem weist sie zwei Ausgänge GPout1, GPout2 auf, die mit zwei Eingängen GPin1, GPin2 der Gruppentesteinheit GPTest verbunden sind.

Die Gruppentesteinheit GPTest weist über die beiden Eingänge GPin1, GPin2 hinaus noch einen dritten Eingang auf für das Testsignal und einen vierten Eingang für ein Vergleichsdatum DCOMP. Das Vergleichsdatum DCOMP ist zuführbar entweder über einen außerhalb des Testbetriebs nicht benutzten Anschluß des Halbleiterspeichers ("NC-Pin") oder über einen im Testbetrieb zur Adressierung nicht notwendigen Pin einer Adreßleitung ADR. Sind im Testbetrieb alle mittels (u.a.) der Gruppenleseeinheit GPRD getesteten M Speicherzellen MC und die diesen nachgeordneten Komponenten (z.B. die entsprechenden Leseverstärker SA) in Ordnung, so stimmt der Wert ("log.0", "log.1") des Vergleichsdatums DCOMP überein mit den Daten, die alle Lesedatenleitungen $GPDB\text{-}RD_m$ der Paare von Lesedatenleitungen $GPDB\text{-}RD_m$, $\overline{GPDB\text{-}RD_m}$ des Grup-

pendatenbusses aufweisen, ansonsten nicht. Die Gruppentesteinheit GPTest weist weiterhin zwei Ausgänge auf für die beiden Lesedatenleitungen IODB-RD, $\overline{\text{IODB-RD}}$ des Ein-/Ausgabendatenbusses IODB. Diese Komponenten der Gruppenein-/ausgabeeinheit GPIO werden nachstehend anhand weiterer Figuren näher erläutert:

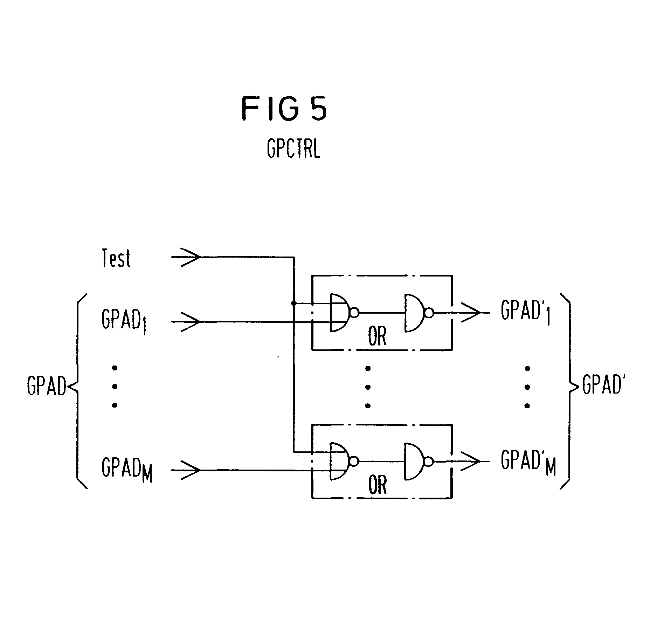

Figur 5 zeigt eine mögliche Ausführungsform für die Gruppensteuerschaltung GPCTRL. Sie enthält M voneinander unabhängige ODER-Schaltungen OR, die jeweils realisiert sind als ein NOR-Gatter mit zwei Eingängen und ein dem NOR-Gatter nachgeschalteter Inverter. Die ersten Eingänge der NOR-Gatter, die erste Eingänge der ODER-Schaltungen sind, bilden den einen Eingang der Gruppensteuerschaltung GPCTRL für das Testsignal Test. Jeder der zweiten Eingänge der NOR-Gatter, die zweite Eingänge der ODER-Schaltung OR sind, bildet jeweils einen Eingang der Gruppensteuerschaltung GPCTRL für eines der M Gruppenadreßsignale $GPAD_m$ des Gruppenadreßbusses GPAD. Die Ausgänge der ODER-Schaltung OR sind die Ausgänge der Gruppensteuerschaltung GPCTRL. An ihnen liegen demzufolge die bereits beschriebenen Gruppenadreßausgangssignale $GPAD'_m$ an.

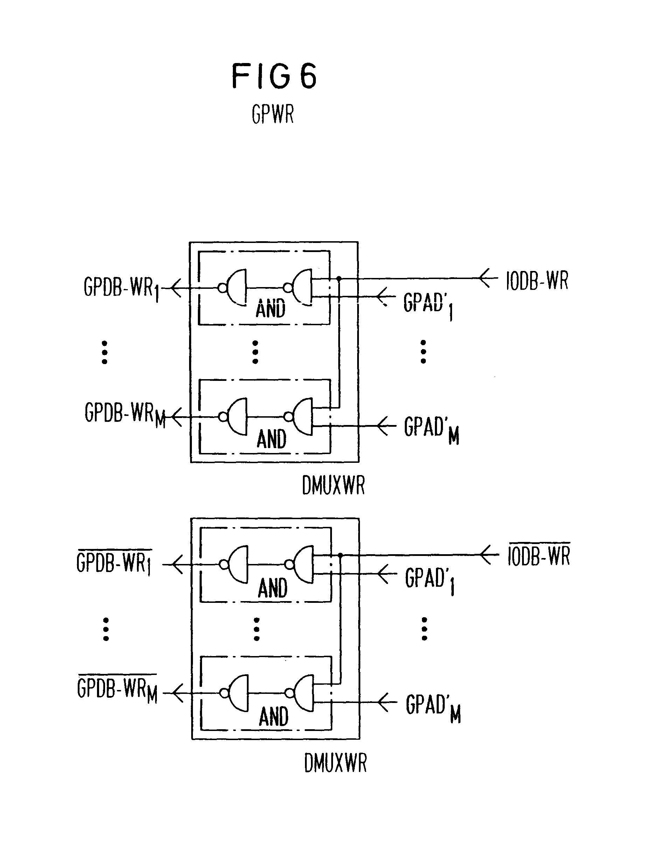

Figur 6 zeigt eine mögliche Ausführungsform für die Gruppenschreibeinheit GPWR. Sie enthält zwei Demultiplexer DMUXWR, von denen jeder M Eingänge aufweist für die M Gruppenadreßausgangssignale $GPAD'_m$ der Gruppensteuerschaltung GPCTRL. Jeder Demultiplexer DMUXWR enthält darüber hinaus einen weiteren Eingang für eine jeweilige Leitung des Paares von Schreibdatenleitungen IODB-WR, $\overline{\text{IODB-WR}}$ des Ein-/Ausgabedatenbusses IODB. Jeder Demultiplexer DMUXWR weist M Ausgänge auf für die Schreibdatenleitungen $GPDB\text{-}WR_m$, $\overline{GPDB\text{-}WR_m}$ des Gruppendatenbusses GPDB, wobei der eine Demultiplexer DMUXWR an seinen Ausgängen mit den jeweiligen einen Schreibdatenleitungen $GPDB\text{-}WR_m$ der Paare von Schreibdatenleitungen $GPDB\text{-}WR_m$, $\overline{GPDB\text{-}WR_m}$ verbunden ist und wobei der andere Demultiplexer DMUXWR an seinen Ausgängen mit den jeweiligen anderen Schreibdatenleitungen $\overline{GPDB\text{-}WR_m}$ der Paare von Schreibdatenleitungen $GPDB\text{-}WR_m$, $\overline{GPDB\text{-}WR_m}$ verbunden ist. Die Ausgänge der Demultiplexer DMUXWR sind die Ausgänge der Gruppenschreibeinheit GPWR. Jedem der Ausgänge eines Demultiplexers DMUXWR ist über den entsprechenden Eingang intern eines der Gruppenadreßausgangssignale $GPAD'_m$ der Gruppensteuerschaltung GPCTRL zugeordnet, was nachstehend noch näher erläutert wird.

In der Normalbetriebsart wird beim einen Demultiplexer DMUXWR ein an seinem weiteren Eingang, der mit der einen Schreibdatenleitung IODB-WR des Ein-/Ausgabedatenbusses IODB verbunden ist, anliegendes, in den Halbleiterspeicher einzuschreibendes Datum auf denjenigen Ausgang des Demultiplexers DMUXWR durchgeschaltet, dessen ihm zugeordnetes Gruppenadreßausgangssignal $GPAD'_m$ den ersten logischen Pegel des entsprechenden Gruppenadreßsignals $GPAD_m$ aufweist (gemäß Tab. 1 sind dies dasjenige Gruppenadreßausgangssignal $GPAD'_m$ und Gruppenadreßsignal $GPAD_m$, das den Wert "log. 1" aufweist). Entsprechend wird in der Normalbetriebsart beim anderen Demultiplexer DMUXWR ein an seinem weiteren Eingang, der mit der anderen Schreibdatenleitung $\overline{\text{IODB-WR}}$ des Ein-/Ausgabedatenbusses IODB verbunden ist, anliegendes Datum, das komplementär ist zu dem in den Halbleiterspeicher einzuschreibenden Datum, auf denjenigen Ausgang des Demultiplexers DMUXWR durchgeschaltet, dessen ihm zugeordnetes Gruppenadreßausgangssignal $GPAD'_m$ den ersten logischen Pegel des entsprechenden Gruppenadreßsignals $GPAD_m$ aufweist.

In der Testbetriebsart wird bei beiden Demultiplexern DMUXWR das am jeweiligen weiteren Eingang des jeweiligen Demultiplexers DMUXWR anliegende Datum auf alle Ausgänge des jeweiligen Demultiplexers DMUXWR durchgeschaltet, sodaß ein einzuschreibendes Datum gleichzeitig in M Speicherzellen MC eines Speicherblocks $BK_v$ eingeschrieben wird.

In einfacheren Worten ausgedrückt bedeutet dies: In der Normalbetriebsart wird bei jedem Demultiplexer DMUXWR das an seinem weiteren Eingang anliegende Datum auf denjenigen einen Ausgang durchgeschaltet, dessen ihm zugeordnetes Gruppenadreßausgangssignal $GPAD'_m$ aktiviert ist. In der Testbetriebsart wird bei jedem Demultiplexer DMUXWR das an seinem weiteren Eingang anliegende Datum auf sämtliche Ausgänge des Demultiplexers DMUXWR durchgeschaltet.

Jeder Demultiplexer DMUXWR in der Ausgestaltung nach Figur 6 enthält M voneinander unabhängige UND-Schaltungen AND mit jeweils zwei Eingängen, deren eine Eingänge gemeinsam mit der jeweiligen Schreibdatenleitung IODB-WR bzw. $\overline{\text{IODB-WR}}$ des Ein-/Ausgabedatenbusses IODB verbunden sind. Die anderen Eingänge der UND-Schaltungen AND sind bei jedem Demultiplexer DMUXWR mit einem jeweiligen der M Gruppenadreßausgangssignale $GPAD'_m$ der Gruppensteuerschaltung GPCTRL verbunden. Jede UND-Schaltung AND der Demultiplexer DMUXWR nach Figur 6 ist in Form eines NAND-Gatters und eines diesem nachgeschalteten Inverters realisiert. Das NAND-Gatter weist zwei Eingänge auf, die die Eingänge der UND-Schaltung AND sind.

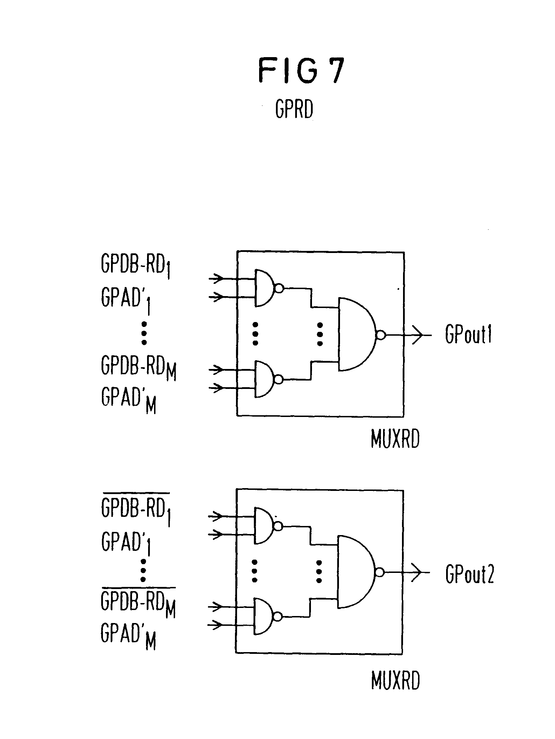

Figur 7 zeigt eine mögliche Ausführungsform der Gruppenleseeinheit GPRD einer Gruppenein-/Ausgabeeinheit GPIO. Die Funktion dieser dargestellten Ausführungsform verkörpert die erfindungsgemäße Lehre bezüglich einer Gruppenleseeinheit GPRD. Die in Figur 7 dargestellte Ausführungsform ist nur eine der Möglichkeiten, diese Lehre zu realisieren. Nach Figur 7 enthält die Gruppenleseeinheit GPRD zwei Multiplexer MUXRD. Jeder Multiplexer MUXRD weist M Eingänge auf für die einen ($\overline{\text{GPDB-RD}}_{1...M}$) bzw. für die anderen ($\overline{\text{GPDB-RD}}_{1...M}$) Datenleitungen der M Paare von Datenleitungen GPDB-RD$_m$, $\overline{\text{GPDB-RD}}_m$ des der jeweiligen Gruppenein-/Ausgabeeinheit GPIO zugeordneten Gruppendatenbusses GPDB. Darüber hinaus weist jeder Multiplexer weitere Eingänge auf, jeweils für die M Gruppenadreßausgangssignale GPAD'$_m$ des Gruppenadreßausgangsbusses GPAD' der Gruppensteuerschaltung GPCTRL. Diese Eingänge sind die Eingänge der Gruppenleseeinheit GPRD, wie bezüglich Figur 4 bereits beschrieben. Die Multiplexer MUXRD weisen weiterhin je einen Ausgang auf, die die in Figur 4 beschriebenen Ausgänge GPout1, GPout2 der Gruppenleseschaltung GPRD sind. Jedes der Gruppenadreßausgangssignale GPAD'$_m$ ist bei jedem Multiplexer MUXRD genau einer der Lesedatenleitungen GPDB-RD$_m$ bzw. $\overline{\text{GPDB-RD}}_m$ des Gruppendatenbusses GPDB zugeordnet.

In der Normalbetriebsart, in der ja genau eines der Gruppenadreßsignale GPAD$_m$ und damit eines der Gruppenadreßausgangssignale GPAD'$_m$ der Gruppensteuereinheit GPCTRL aktiviert ist, d.h. das den ersten logischen Pegel aufweist (in Tab. 1 wurde dafür der Wert "log. 1" angenommen), und in der die restlichen Gruppenadreßausgangssignale GPAD'$_m$ des Gruppenadreßausgangssignalbusses GPAD' deaktiviert sind (d.h. die den zweiten logischen Pegel aufweisen), ist durch die Multiplexer MUXRD genau dasjenige Paar von Lesedatenleitungen GPDB-RD$_m$, $\overline{\text{GPDB-RD}}_m$ des Gruppendatenbusses GPDB auf die Ausgänge GPout1, GPout2 der Gruppenleseschaltung GPRD durchgeschaltet, dem das eine aktivierte Gruppenadreßausgangssignal GPAD'$_m$ des Gruppenadreßausgangssignalbusses GPAD' zugeordnet ist.

In der Testbetriebsart ist in dem Fall, in dem alle an einem jeweiligen Multiplexer MUXRD anliegende Lesedatenleitungen GPDB-RD$_m$ bzw. $\overline{\text{GPDB-RD}}_m$ des Gruppendatenbusses GPDB dasselbe Datum aufweisen, dieses an den Ausgang des jeweiligen Multiplexers MUXRD, und damit an den jeweiligen Ausgang GPout1 bzw. GPout2 der Gruppenleseeinheit GPRD durchgeschaltet. Deshalb weisen diese Ausgänge GPout1, GPout2 in der Testbetriebsart in diesem Falle zueinander komplementäre logische Pegel auf (jedes Paar von Lesedatenleitungen des Gruppendatenbusses GPDB weist wegen der Funktion der Leseverstärker SA und der Blockdatenbusmultiplexer BKDBMX zueinander komplementäre logische Pegel = Daten auf).

Ansonsten weisen im Testbetrieb die Ausgänge GPout1, GPout2 der Gruppenleseeinheit GPRD einen einander gleichen logischen Pegel auf (in Figur 7: beide Ausgänge GPout1, GPout2 weisen log. 1 auf).

In der konkreten Ausführungsform nach Figur 7 enthält jeder Multiplexer MUXRD M NAND-Gatter mit jeweils zwei Eingängen sowie ein weiteres NAND-Gatter mit M Eingängen, die jeweils mit dem Ausgang eines der M NAND-Gatter verbunden sind. Der Ausgang des weiteren NAND-Gatters ist der Ausgang GPout1, GPout2 des jeweiligen Multiplexers MUXRD. Die jeweilige eine Leitung (GPDB-RD$_m$) eines jeden Paares von Lesedatenleitungen GPDB-RD$_m$, $\overline{\text{GPDB-RD}}_m$ des Gruppendatenbusses GPDB ist mit dem jeweiligen einen Eingang der M NAND-Gatter des einen Multiplexers MUXRD verbunden. Die jeweilige andere Leitung $\overline{\text{GPDB-RD}}_m$ eines jeden Paares von Lesedatenleitungen GPDB-RD$_m$, $\overline{\text{GPDB-RD}}_m$ des Gruppendatenbusses GPDB ist mit dem jeweiligen einen Eingang der M NAND-Gatter des anderen Multiplexers MUXRD verbunden. Weiterhin sind bei den Multiplexern MUXRD die anderen Eingänge der M NAND-Gatter mit dem der jeweiligen Lesedatenleitung GPDB-RD$_m$, $\overline{\text{GPDB-RD}}_m$ zugeordneten Gruppenadreßausgangssignal GPAD'$_m$ beaufschlagt.

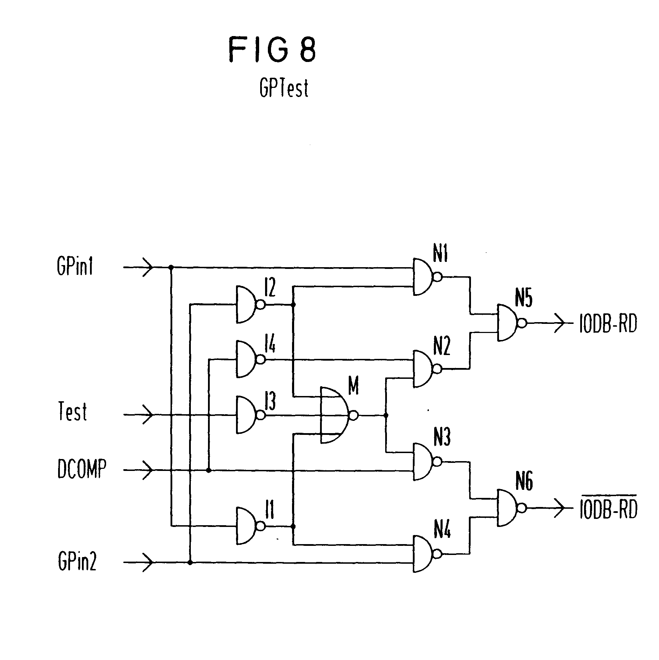

Figur 8 zeigt die Gruppentesteinheit GPTest. Sie weist einen ersten Eingang GPin1 und einen zweiten Eingang GPin2 auf, die mit dem jeweiligen Ausgang GPout1, GPout2 der Gruppenleseeinheit GPRD verbunden sind. Sie weist einen dritten Eingang für das Testsignal auf und einen vierten Eingang für das Vergleichsdatum DCOMP. Die Gruppentesteinheit weist zwei Ausgänge auf für die Lesedatenleitungen IODB-RD, $\overline{\text{IODB-RD}}$ des Ein-/Ausgabedatenbusses IODB.

Die Gruppentesteinheit GPTest hat folgende Funktion: In der normalen Betriebsart liegt an den Ausgängen dasjenige Signal an, das am jeweiligen Eingang GPin1 bzw. GPin2 der ersten beiden Eingänge GPin1, GPin2 anliegt. In der Testbetriebsart liegen in dem einen Fall, in dem die mit den ersten beiden Eingängen GPin1, GPin2 verbundenen Ausgänge GPout1, GPout2 der Gruppenleseeinheit GPRD die zueinander komplementären logischen Pegel aufweisen, diese komplementären Pegel an den Ausgängen der Gruppentesteinheit GPTest an. In dem anderen Fall, in dem die mit den ersten beiden Eingängen GPin1, GPin2 verbundenen Ausgänge GPout1, GPout2 der Gruppenleseeinheit GPRD beide den gleichen logischen Pegel aufweisen (vorliegend: log.1), weist der-eine der beiden Ausgänge der Gruppentesteinheit GPTest einen zum logischen Pegel des Vergleichsdatums DCOMP komplementären logischen Pegel auf, während der andere der beiden Ausgänge den logischen Pegel des Vergleichsdatums DCOMP aufweist.

In der in Figur 8 dargestellten Ausführungsform enthält die Gruppentesteinheit GPTest sechs NAND-Gatter N1...N6 mit jeweils zwei Eingängen und einem Ausgang sowie ein NOR-Gatter NOR mit drei Eingängen und einem Ausgang.

Der eine Eingang des ersten NAND-Gatters N1 ist der erste Eingang GPin1 der Gruppentesteinheit GPTest. Der eine Eingang des vierten NAND-Gatters N4 ist der zweite Eingang GPin2 der Gruppentesteinheit GPTest. Der erste Eingang GPin1 der Gruppentesteinheit GPTest ist über einen ersten Inverter I1 sowohl mit dem anderen Eingang des vierten NAND-Gatters N4 als auch mit dem ersten Eingang des NOR-Gatters NOR verbunden. Der zweite Eingang GPin2 der Gruppentesteinheit GPTest ist über einen zweiten Inverter I2 sowohl mit dem anderen Eingang des ersten NAND-Gatters N1 als auch mit dem zweiten Eingang des NOR-Gatters NOR verbunden.

Das Testsignal Test ist über einen dritten Inverter I3 dem dritten Eingang des NOR-Gatters NOR zuführbar. Das Vergleichsdatum DCOMP ist dem einen Eingang des dritten NAND-Gatters N3 und über einen vierten Inverter I4 dem einen Eingang des zweiten NAND-Gatters N2 zuführbar. Der Ausgang des NOR-Gatters NOR ist mit den anderen Eingängen des zweiten und dritten NAND-Gatters N2, N3 verbunden. Die Ausgänge des ersten und des zweiten NAND-Gatters N1, N2 sind mit den Eingängen des fünften NAND-Gatters N5 verbunden. Die Ausgänge des dritten und des vierten NAND-Gatters N3, N4 sind mit den Eingängen des sechsten NAND-Gatters N6 verbunden. Die Ausgänge des fünften und des sechsten NAND-Gatters N5, N6 sind die beiden Ausgange der Gruppentesteinheit GPTest.

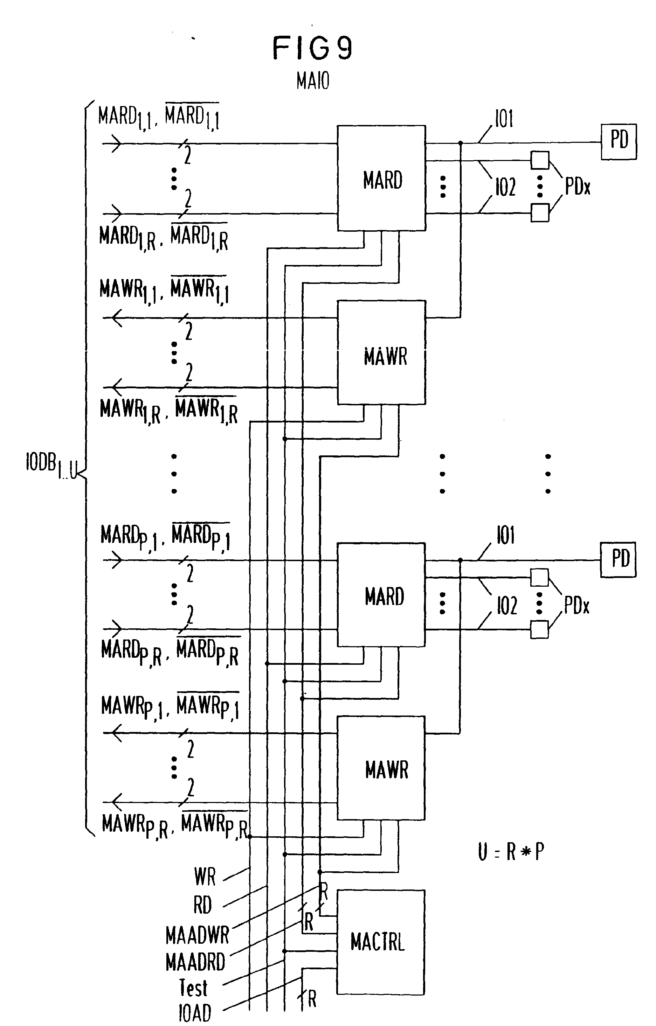

Figur 9 zeigt die Zellenfeldein-/ausgabeeinheit MAIO im Überblick. Sie enthält P Zellenfeldleseeinheiten MARD mit jeweils R Leseeinheiten (RDU1, RDU2), P Zellenfeldschreibeinheiten MAWR sowie eine Zellenfeldsteuerschaltung MACTRL.

Die Zellenfeldschreibeinheiten MAWR sind jeweils einer der Zellenfeldleseeinheiten MARD zugeordnet. Jede Zellenfeldleseeinheit MARD weist R Paare von Dateneingangsleitungen $MARD_{p,r}$, $\overline{MARD}_{p,r}$ auf. Jede Zellenfeldschreibeinheit MAWR weist R Paare von Datenausgangsleitungen $MAWR_{p,r}$, $\overline{MAWR}_{p,r}$ auf. Der Index p ist für jeweils R Paare konstant und weist insgesamt folgende Werte auf: p = 1...P. Der Index r weist folgende Werte auf: r = 1...R. Für die Zahlen P, R, U gilt folgende Zuordnung: P.R = U.

Die Dateneingangsleitungen $MARD_{p,r}$, $\overline{MARD}_{p,r}$ sind mit den Leseleitungen IODB-RD, $\overline{IODB-RD}$ der U Ein-/Ausgabedatenbusse IODB verbunden. Die Datenausgangsleitungen $MAWR_{p,r}$, $\overline{MAWR}_{p,r}$ sind mit den Schreibleitungen IODB-WR, $\overline{IODB-WR}$ der U Ein-/Ausgabedatenbusse IODB verbunden. Jede Zellenfeldleseeinheit MARD ist an einem Ausgang mit einer der I/O-Datenleitungen der ersten Art IO1 und mit einem Dateneingang der ihr zugeordneten Zellenfeldschreibeinheit MAWR verbunden. Jede Zellenfeldleseeinheit MARD hat weiterhin Ausgänge für (R-1) I/O-Datenleitungen der zweiten Art IO2. Alle Zellenfeldleseeinheiten MARD sind gemeinsam mit dem Lesesteuersignal RD beaufschlagt. Alle Zellenfeldschreibeinheiten MAWR sind gemeinsam mit dem Schreibsteuersignal WR beaufschlagt. Alle Zellenfeldleseeinheiten MARD, alle Zellenfeldschreibeinheiten MAWR und die Zellenfeldsteuerschaltung MACTRL sind gemeinsam mit dem Testsignal Test beaufschlagt. Alle Zellenfeldleseeinheiten MARD sind gemeinsam mit einem Zellenfeldleseadreßbus MAADRD verbunden. Alle Zellenfeldschreibeinheiten MAWR sind gemeinsam mit einem Zellenfeldschreibadreßbus MAADWR verbunden.

Die Zellenfeldsteuerschaltung MACTRL ist eine Schaltung zum Generieren des Zellenfeldleseadreßbusses MAADRD und des Zellenfeldschreibadreßbusses MAADWR aus dem I/O-Adreßbus IOAD unter Steuerung durch das Testsignal Test, wobei der Zellenfeldleseadreßbus MAADRD und der Zellenfeldschreibadreßbus MAADWR jeweils R Adreßleitungen $MAADRD_{1...R}$ bzw. $MAADRD_{1...R}$ umfassen.

Ähnlich wie bei den zuvor bereits beschriebenen Datenbussen (BKDB, GPDB, IODB), können auch hier jeweils ein Paar von Dateneingangsleitungen $MARD_{p,r}$, $\overline{MARD}_{p,r}$ und ein Paar von Datenausgangsleitungen $MAWR_{p,r}$, $\overline{MAWR}_{p,r}$ als ein einziges Datenleitungspaar realisiert sein, das bidirektional betreibbar ist.

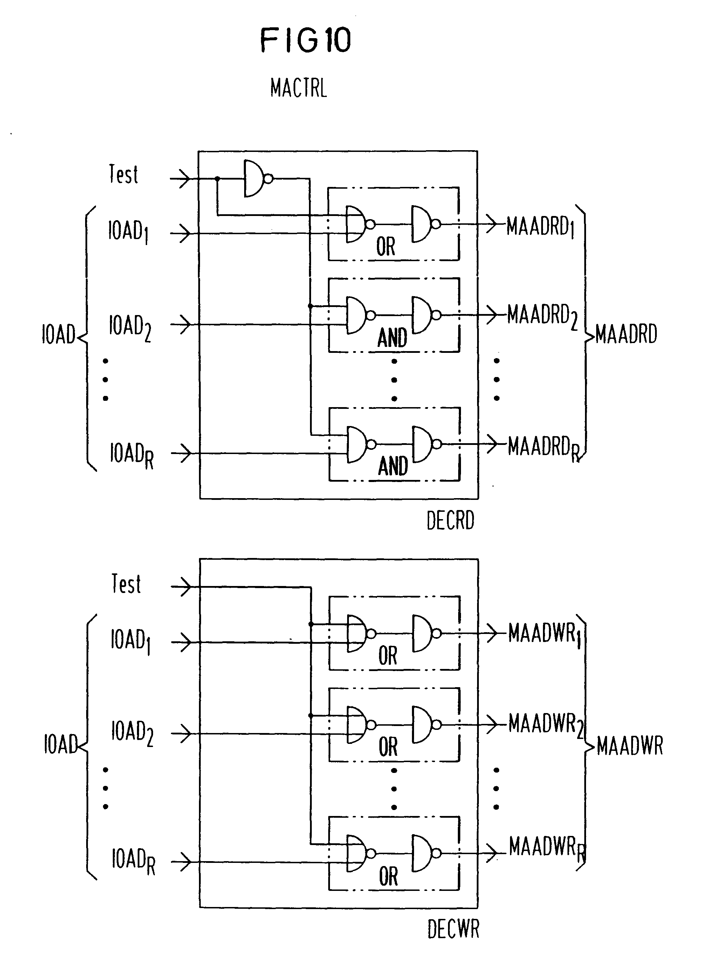

Figur 10 zeigt die Zellenfeldsteuerschaltung MACTRL. Sie enthält einen Lesedekoder DECRD und einen Schreibdekoder DECWR. Diese schalten beide in der Normalbetriebsart den I/O-Adreßbus IOAD auf den Zellenfeldleseadreßbus MAADRD und auf den Zellenfeldschreibadreßbus MAADWR durch. In der Testbetriebsart weist eine erste Leitung des Zellenfeldleseadreßbusses MAADRD vermittels des Lesedekoders DECRD und des Testsignals Test einen konstanten logischen Pegel auf (dieser kann log. 0 oder log. 1 sein, je nach verwendeter Logik, vorliegend wird log. 1 angenommen). Die restlichen Leitungen des Zellenfeldleseadreßbusses MAADRD weisen einen zum logischen Pegel der ersten Leitung komplementären logischen Pegel auf, der ebenfalls konstant ist. Weiterhin weisen in der Testbetriebsart alle Leitungen des Zellenfeldschreibadreßbusses MAADWR vermittels des Schreibdekoders DECWR und des Testsignals Test einen konstanten logischen Pegel auf. Dieser ist wertemäßig gleich dem logischen Pegel der ersten Leitung des Zellenfeldleseadreßbusses MAADRD.

In der konkreten Ausführungsform nach Figur 10 enthält der Lesedekoder DECRD eine ODER-Schaltung OR mit zwei Eingängen und einem Ausgang. Der eine Eingang ist mit dem Testsignal Test beaufschlagt. Der andere Eingang ist mit einer ersten Leitung $IOAD_1$ des I/O-Adreßbusses IOAD verbunden. Der Ausgang ist mit der ersten Leitung des Zellenfeldleseadreßbusses MAADRD verbunden. Der Lesedekoder DECRD weist weiterhin (R-1) UND-Schaltungen AND auf mit jeweils zwei Eingängen und einem Ausgang. Jeweils der eine Eingang ist mit einem zum Testsignal Test komplementären Signal beaufschlagt. Jeder der anderen Eingänge ist mit einer der restlichen Leitungen des I/O-Adreßbusses IOAD verbunden. Jeder der Ausgänge ist mit einer der

EP 0 527 866 B1

restlichen Leitungen des Zellenfeldleseßdreßbusses MAADRD verbunden.

Der Schreibdekoder DECWR enthält R ODER-Schaltungen OR mit jeweils zwei Eingängen und einem Ausgang. Die einen Eingänge sind gemeinsam mit dem Testsignal Test beaufschlagt. Die anderen Eingänge sind mit dem I/O-Adreßbus IOAD verbunden. Die Ausgänge sind mit dem Zellenfeldschreibadreßbus MAADWR verbunden.

Nach Figur 10 enthalten die ODER-Schaltung OR des Lesedekoders DECRD und die ODER-Schaltungen OR des Schreibdekoders DECWR jeweils ein NOR-Gatter und einen diesem nachgeschalteten Inverter. Ebenso enthalten die UND-Schaltungen AND des Lesedekoders DECRD ein NAND-Gatter und einen diesem nachgeschalteten Inverter.

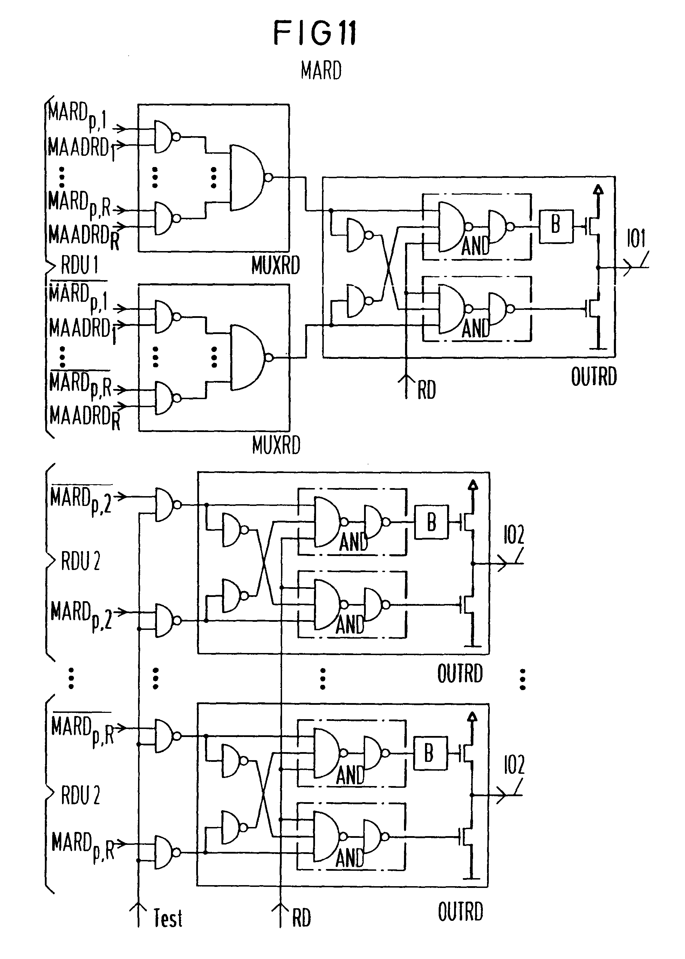

Figur 11 zeigt eine Zellenfeldleseeinheit MARD. Sie enthält eine erste Leseeinheit RDU1 und (R-1) restliche Leseeinheiten RDU2. Die erste Leseeinheit RDU1 enthält zwei Multiplexer MUXRD und eine Ausgangsstufe OUTRD. Jeder Multiplexer MUXRD weist R erste Eingänge auf für jeweils eine Dateneingangsleistung $MARD_{p,r}$ bzw. $\overline{MARD}_{p,r}$ der R Paare von Dateneingangsleitungen $MARD_{p,r}$, $\overline{MARD}_{p,r}$. Weiterhin weist jeder Multiplexer MUXRD R zweite Eingänge für den Zellenfeldleseadreßbus MAADRD auf, dessen Leitungen den Dateneingangsleitungen $MARD_{p,r}$ bzw. $\overline{MARD}_{p,r}$ zugeordnet sind, sowie einen Ausgang.

Bei beiden Multiplexern MUXRD ist in der Normalbetriebsart diejenige der Dateneingangsleitungen $MARD_{p,r}$ bzw. $\overline{MARD}_{p,r}$ auf den jeweiligen Ausgang durchgeschaltet, deren zugeordnete Leitung des Zellenfeldleseadreßbusses MAADRD den aktivierten Zustand aufweist.

Bei beiden Mutliplexern MUXRD ist in der Testbetriebsart diejenige der Dateneingangsleitungen $MARD_{p,r}$ bzw. $\overline{MARD}_{p,r}$ auf den Ausgang durchgeschaltet, der die erste Leitung $MAADRD_1$ des Zellenfeldleseadreßbusses MAADRD mit ihrem konstanten logischen Pegel zugeordnet ist.

Die Ausgangsstufe OUTRD ist eine Treiberschaltung. Deren Ausgang ist der mit einer der I/O-Datenleitungen der ersten Art IO1 verbundene Ausgang der gesamten Zellenfeldleseeinheit MARD. Er weist, unabhängig von der Betriebsart, das am Ausgang des einen Multiplexers MUXRD anliegende Signal in verstärkter Form auf.

In der Ausführungsform nach Figur 11 weist jeder Multiplexer MUXRD der ersten Leseeinheit RDU1 R NAND-Gatter mit jeweils zwei Eingängen auf. Deren einer Eingang ist jeweils einer der R ersten Eingänge des Multiplexers MUXRD. Deren anderer Eingang ist jeweils einer der R zweiten Eingänge des Multiplexers MUXRD. Jeder Multiplexer MUXRD der ersten Leseeinheit RDU1 weist ein zusätzliches NAND-Gatter mit R Eingängen auf. Diese sind jeweils mit einem Ausgang der R NAND-Gatter verbunden. Der Ausgang des zusätzlichen NAND-Gatters ist der Ausgang des jeweiligen Multiplexers MUXRD der ersten Leseeinheit RDU1.

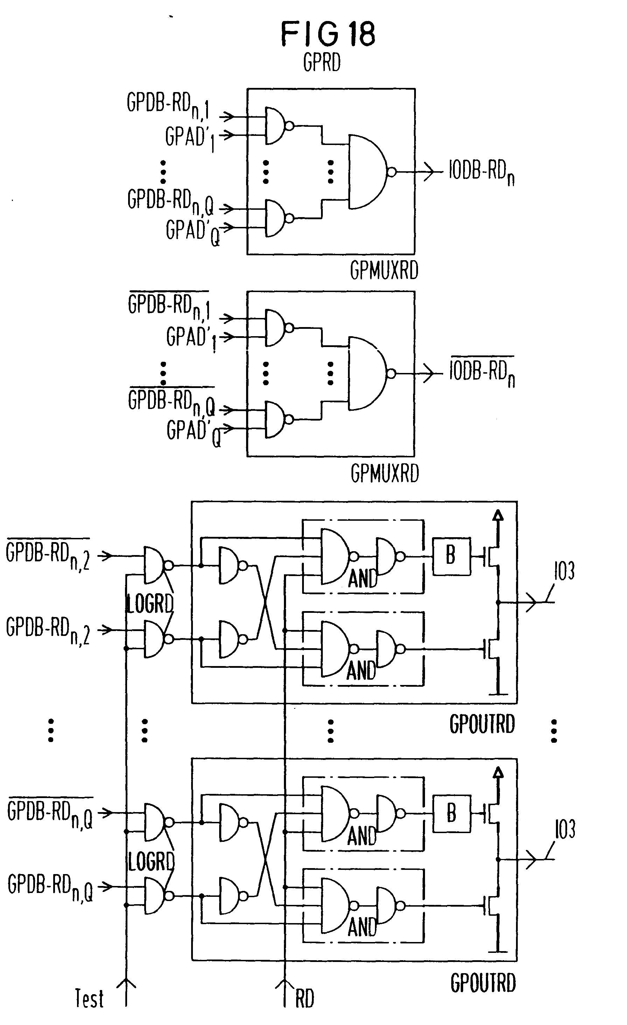

Die Ausgangsstufe OUTRD weist zwei UND-Schaltungen AND auf mit jeweils drei Eingängen und einem Ausgang. Der jeweilige erste Eingang jeder UND-Schaltung AND ist mit dem Ausgang des jeweils einen Multiplexers MUXRD verbunden. Der zweite Eingang jeder UND-Schaltung AND ist mit dem Ausgang des jeweils anderen Multiplexers MUXRD über einen Inverter verbunden. Die dritten Eingänge der UND-Schaltungen AND sind mit dem Lesesteuersignal RD beaufschlagt. Die Ausgangsstufe OUTRD weist eine Endstufe auf, die eingangsmäßig mit den Ausgängen der UND-Schaltungen AND verbunden ist und deren Ausgang der Ausgang der Ausgangsstufe OUTRD und der ersten Leseeinheit RDU1 ist. Jede der UND-Schaltungen AND enthält ein NAND-Gatter mit einem nachgeschalteten Inverter. Die Ausgangsstufe OUTRD kann auch, wie dargestellt, eine Boostanordnung B enthalten, wie bezüglich Figur 18 beschrieben.

Die restlichen (R-1) Leseeinheiten RDU2 enthalten jeweils eine Ausgangsstufe OUTRD mit zwei Eingängen und einem Ausgang. Der Ausgang ist einer der Ausgänge für die (R-1) I/O-Datenleitungen der zweiten Art IO2. Jedem Eingang einer Ausgangsstufe OUTRD ist eine NAND-Schaltung mit zwei Eingängen vorgeschaltet. Deren erster Eingang ist mit jeweils einer der beiden Dateneingangsleitungen $\overline{MARD}_{p,2...R}$ bzw. $MARD_{p,2...R}$ der R Paare von Dateneingangsleitungen $MARD_{p,r}$, $\overline{MARD}_{p,r}$ mit Ausnahme des ersten Paares $MARD_{p,1}$, $\overline{MARD}_{p,1}$ dieser R Paare verbunden. Der zweite Eingang der NAND-Schaltung ist mit dem Testsignal Test beaufschlagt.

In der Normalbetriebsart sind die Ausgänge der restlichen (R-1) Leseeinheiten RDU2 hochohmig geschaltet.

In der Testbetriebsart liegt am Ausgang jeder der restlichen (R-1) Leseeinheiten RDU2 das an der einen Dateneingangsleitung $MARD_{p,2...R}$ des jeweiligen Paares von Dateneingangsleitungen $MARD_{p,2...R}$, $\overline{MARD}_{p,2...R}$ anliegende Signal in verstärkter Form an.

Die Ausgangsstufen OUTRD der restlichen (R-1) Leseeinheiten RDU2 sind gleich der Ausgangsstufe OUTRD der ersten Leseeinheit RDU1 der jeweiligen Zellenfeldleseeinheit MARD. Unter Beibehaltung der Gesamtlogik einer Zellenfeldleseeinheit MARD und/oder der einzelnen Leseeinheiten RDU1, RDU2 sind auch andere Gatter- und Signalkombinationen verwendbar.

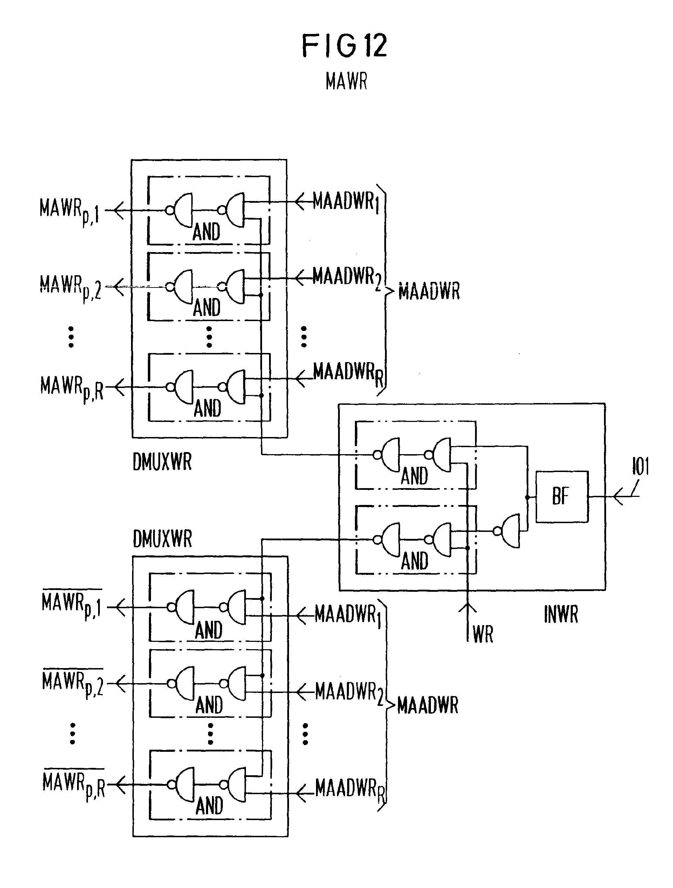

Figur 12 zeigt eine der P Zellenfeldschreibeinheiten MAWR. Sie ist an einem ersten Eingang mit einer der P I/O-Datenleitungen der ersten Art IO1 verbunden und an einem zweiten Eingang mit dem Schreibsteuersignal WR beaufschlagt. Sie enthält weiterhin Eingänge für den Zellenfeld-Schreibadreßbus MAADWR und Ausgän-

11

ge für die R Paare von Datenausgangsleitungen $MAWR_{p,r}$, $\overline{MAWR}_{p,r}$.

In der Normalbetriebsart gibt sie ein in den Speicher einzuschreibendes, auf der jeweiligen I/O-Datenleitung der ersten Art IO1 anliegendes Datum und ein dazu komplementäres Datum in Abhängigkeit vom Schreibsteuersignal WR und vom ZellenfeldSchreibadreßbus MAADWR auf dasjenige Paar von Datenausgangsleitungen $MAWR_{p,r}$, $\overline{MAWR}_{p,r}$ weiter, bezüglich dessen eine Leitung des I/O-Adreßbusses IOAD, und somit eine Leitung des Zellenfeld-Schreibadreßbusses MAADWR aktiviert ist.

In der Testbetriebsart gibt sie das an der I/O-Datenleitung der ersten Art IO1 anliegende Datum und das dazu komplementäre Datum auf alle R Paare der Datenausgangsleitungen $MAWR_{p,r}$, $\overline{MAWR}_{p,r}$ weiter.

In der Ausführungsform nach Figur 12 enthält eine Zellenfeldschreibeinheit MAWR zwei Demultiplexer DMUXWR und eine Eingangsstufe INWR. Die Eingangsstufe INWR ist an einem ersten Eingang mit der jeweiligen I/O-Datenleitung der ersten Art IO1 verbunden und an einem zweiten Eingang mit dem Schreibsteuersignal WR beaufschlagt. Die Eingangsstufe INWR leitet beim Einschreiben aus dem an der I/O-Datenleitung der ersten Art IO1 anliegenden, einzuschreibenden Datum dasselbe Datum und das dazu komplementäre Datum ab und legt diese abgeleiteten Daten an zwei Ausgänge an. Jeder Demultiplexer DMUXWR enthält R UND-Schaltungen AND mit jeweils zwei Eingängen und einem Ausgang. Alle ersten Eingänge der UND-Schaltungen AND des einen Demultiplexers DMUXWR sind mit dem einen Ausgang der Eingangsstufe INWR verbunden und alle ersten Eingänge der UND-Schaltungen AND des anderen Demultiplexers DMUXWR sind mit dem anderen Ausgang der Eingangsstufe INWR verbunden. Die zweiten Eingänge der UND-Schaltungen AND beider Demultiplexer DMUXWR sind mit dem Zellenfeldschreibadreßbus MAADWR verbunden. Die Ausgänge der Demultiplexer DMUXWR sind mit den R Paaren von Datenausgangsleitungen $MAWR_{p,r}$, $\overline{MAWR}_{p,r}$ verbunden.

Eine Eingangsstufe INWR enthält ein Buffer BF für das an der I/O-Datenleitung der ersten Art IO1 anliegende Datum. Sie enthält zwei UND-Schaltungen AND mit jeweils zwei Eingängen und einem Ausgang, die dem Buffer BF nachgeschaltet sind. Dabei sind der erste Eingang der einen UND-Schaltung AND mit einem Ausgang des Buffers BF verbunden und der erste Eingang der anderen UND-Schaltung AND über einen Inverter mit dem Ausgang des Buffers BF. Die zweiten Eingänge der UND-Schaltungen AND sind mit dem Schreibsteuersignal WR beaufschlagt. Die UND-Schaltungen AND sind jeweils als NAND-Gatter mit zwei Eingängen und einem nachgeschalteten Inverter ausgebildet.

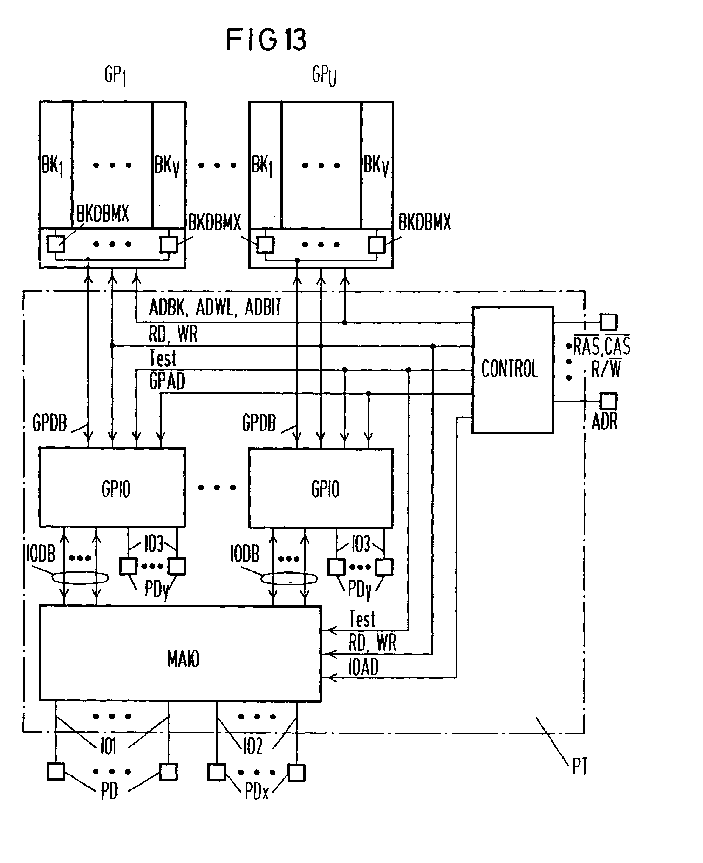

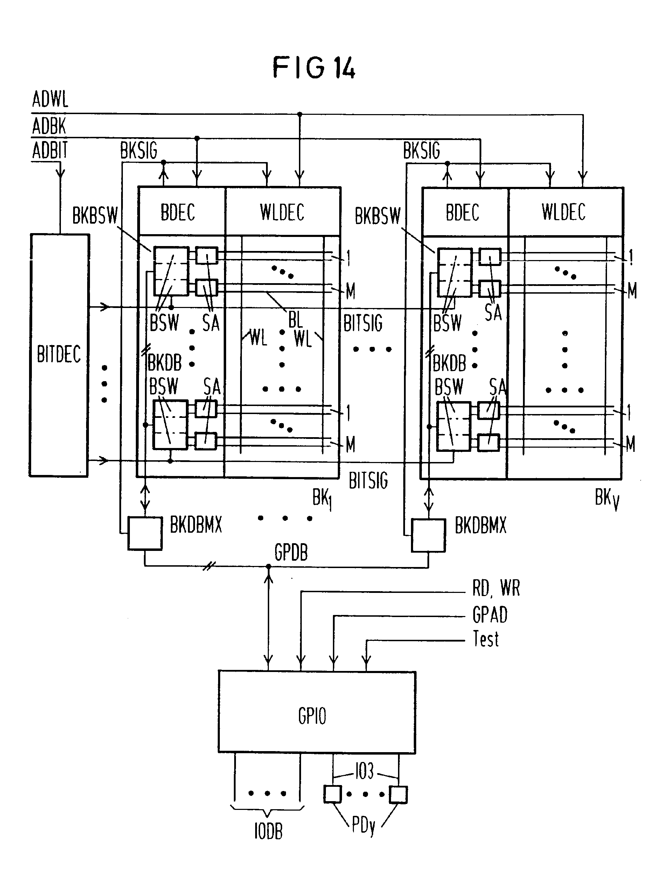

Figur 13 zeigt eine zweite Ausführungsform des erfindungsgemäßen Halbleiterspeichers in einer globalen Übersicht. Mögliche erfindungsgemäße Aus- und Weiterbildungen dazu zeigen die Figuren 14 bis 23. Figur 13 unterscheidet sich von Figur 2 lediglich in folgenden Punkten:

Die Gruppenein-/ausgabeeinheiten GPIO weisen zusätzlich zum Ein-/Ausgabedatenbus IODB noch weitere I/O-Datenleitungen, nämlich die der bereits genannten dritten Art IO3 auf, die mit den gegebenenfalls vorhandenen weiteren Hilfsanschlußflächen PDy verbindbar sind. Außerdem enthalten die Ein-/Ausgabedatenbusse IODB, im Gegensatz zur eingangs beschriebenen ersten Ausführungsform des erfindungs gemäßen Halbleiterspeichers, N Datenleitungspaare zum Lesen $IODB\text{-}RD_{1...N}$, $\overline{IODB\text{-}RD}_{1...N}$ und N Datenleitungspaare zum Schreiben $IODB\text{-}WR_{1...N}$, $\overline{IODB\text{-}WR}_{1...N}$, die jeweils unidirektional betreibbar sind. N ist ein ganzzahliger Bruchteil von M. Stattdessen können aber auch, wie z.B. bei den Gruppendatenbussen GPDB, lediglich N Datenleitungspaare zum Schreiben und Lesen vorgesehen sein, die dann bidirektional betreibbar sind. Auch die Gruppenein-/ausgabeeinheiten GPIO sind bei dieser Ausführungsform anders ausgeführt als bei der ersten Ausführungsform.

Bei jeder Gruppenein-/ausgabeeinheit GPIO werden bezüglich des Gruppendatenbusses GPDB die (2.M) Paare (im Falle von unidirektional betreibbaren Datenleitungen) bzw. M Paare (im Falle von bidirektional betreibbaren Datenleitungen) von Datenleitungen zum Schreiben und zum Lesen rein organisatorisch durch die Gruppenein-/ausgabeeinheit GPIO so betrachtet und behandelt, als ob (2.N.Q) Paare (unidirektional) bzw. (N.Q) Paare (bidirektional) von Datenleitungen des Gruppendatenbusses GPDB zum Schreiben und zum Lesen vorlägen. Es gilt also M = N.Q. Dargestellt wird im folgenden jeweils der Fall, daß unidirektional betreibbare Datenleitungen vorliegen. Demzufolge wird für die Datenleitungen nachfolgend nicht der bislang verwendete Index m = 1...M verwendet, sondern es wird doppelt indiziert mit n = 1...N und q = 1...Q, wobei angenommen wird, daß q der schneller laufende Index ist und n der langsamer laufende Index.

Entsprechend enthält auch der Gruppenadreßbus GPAD Q Gruppenadreßsignale $GPAD_{1...Q}$, von denen jeweils eines einen ersten logischen Zustand aufweist und die restlichen einen zweiten logischen Zustand, wobei wiederum M = N.Q gilt.

Figur 14 zeigt, ähnlich wie Figur 3 bezüglich der ersten Ausführungsform der Erfindung, eine Blockgruppe $GP_u$ des Halbleiterspeichers samt zugehöriger Gruppenein-/ausgabeeinheit GPIO. Anhand der vorherigen Ausführungen und der Ähnlichkeiten zu Figur 3 erübrigen sich weitere diesbezügliche Erläuterungen.

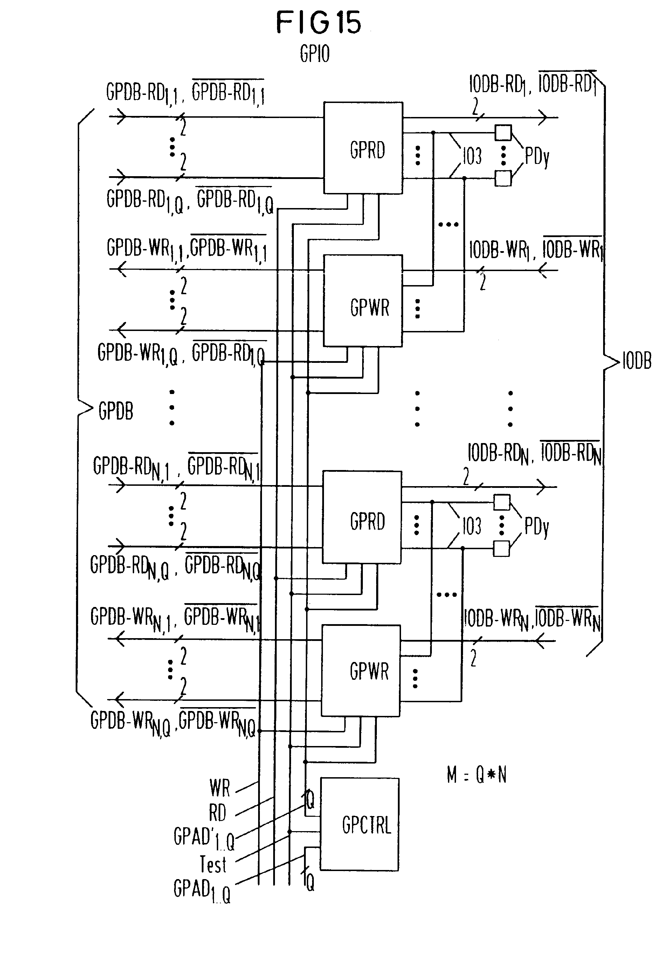

Figur 15 zeigt eine Gruppenein-/ausgabeeinheit GPIO als Blockschaltbild. Sie enthält eine Gruppensteuerschaltung GPCTRL, N Gruppenschreibeinheiten GPWR und N Gruppenleseeinheiten GPRD. Die Gruppensteuerschaltung GPCTRL ist eingangsmäßig mit den Q Gruppenadressignalen $GPAD_{1...Q}$ und dem Testsignal Test verbunden. Sie weist Ausgänge auf für Q Gruppenadreßausgangssignale GPAD'$_{1...Q}$.

In der Testbetriebsart weist das erste Gruppenadreßausgangssignal GPAD'$_1$ einen ersten logischen Pegel auf. Die restlichen Gruppenadreßsignale GPAD'$_{2...Q}$weisen einen zweiten logischen Pegel auf, der zum ersten logischen Pegel komplementär ist.

In der Normalbetriebsart weisen die Gruppenadreßausgangssignale GPAD'$_{1...Q}$ die logischen Zustände der jeweiligen Gruppenadreßsignale GPAD$_{1...Q}$ auf.

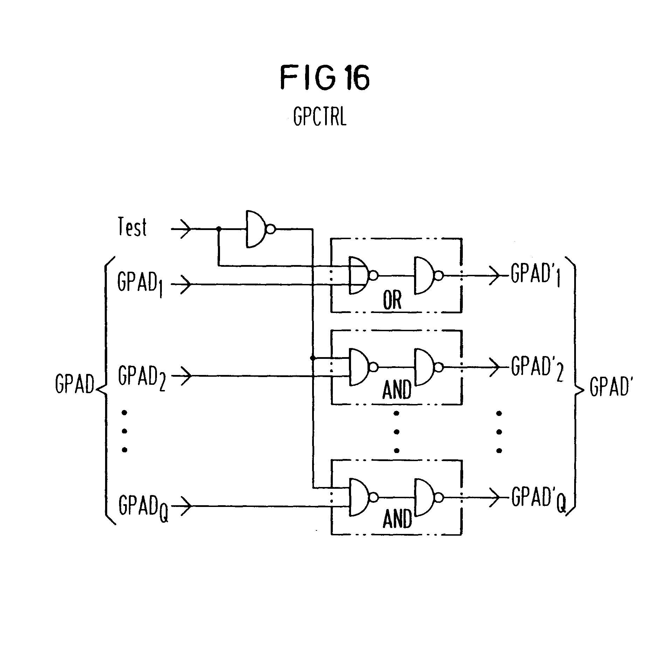

Figur 16 zeigt die Gruppensteuerschaltung GPCTRL. Sie enthält eine ODER-Schaltung OR und (Q-1) UND-Schaltungen AND mit jeweils zwei Eingängen. Am einen Eingang der ODER-Schaltung OR liegt das erste (GPAD$_1$) der Gruppenadressignale GPAD$_{1...Q}$ an. An den einen Eingängen der UND-Schaltungen AND liegt jeweils eines der restlichen (GPAD$_{2...Q}$) der Gruppenadressignale GPAD$_{1...Q}$ an. Am anderen Eingang der ODER-Schaltung OR liegt das Testsignal Test an. An den anderen Eingängen der UND-Schaltungen AND liegt ein zum Testsignal Test komplementäres Signal an. Die Ausgänge der ODER-Schaltung OR und der UND-Schaltungen AND sind die Ausgänge der Gruppensteuerschaltung GPCTRL. Die ODER-Schaltung OR enthält ein NOR-Gatter mit zwei Eingängen und einen diesem nachgeschalteten Inverter. Die UND-Schaltungen AND enthalten jeweils ein NAND-Gatter mit zwei Eingängen und einen diesem nachgeschalteten Inverter.

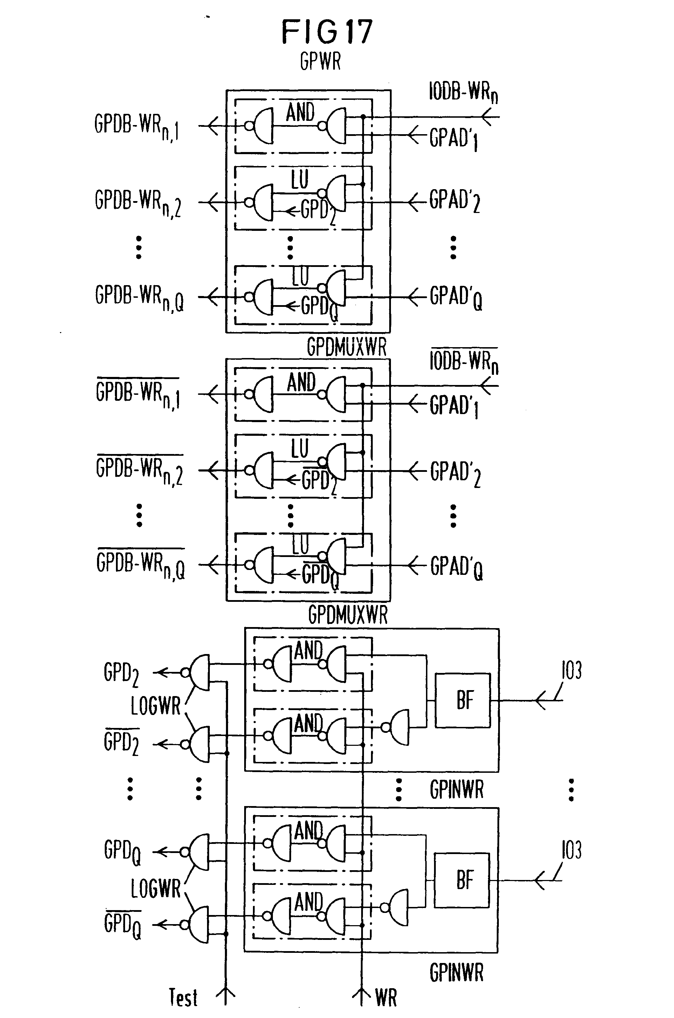

Figur 17 zeigt eine der Gruppenschreibeinheiten GPWR. Bezüglich des Index n (1...N) wird angenommen, daß es die n-te Gruppenschreibeinheit GPWR sei. Sie weist ein Paar von Eingängen auf für ein Datenleitungspaar IODB-WR$_n$, $\overline{\text{IODB-WR}_n}$ des Ein-/Ausgabedatenbusses IODB, welches zum Schreiben dient. Sie ist außerdem eingangsmäßig mit den Gruppenadreßausgangssignalen GPAD$_q'$ der Gruppensteuerschaltung GPCTRL verbunden. Sie weist (Q-1) Gruppeneingangsstufen GPINWR auf mit je einem Eingang, der mit jeweils einer von (Q-1) I/O-Leitungen der dritten Art IO3 verbunden ist. Sie weist einen weiteren Eingang für das Schreibsteuersignal WR auf.

Jede Gruppeneingangsstufe GPINWR leitet aus einem in den Speicher einzuschreibenden Datum, das über die jeweilige I/O-Datenleitung der dritten Art IO3 an ihr anliegt, beim Einschreiben dasselbe Datum und ein dazu komplementäres Datum ab und legt diese abgeleiteten Daten an zwei Ausgänge. Jedem Ausgang einer Gruppeneingangsstufe GPINWR ist eine logische Schaltung LOGWR mit zwei Eingängen nachgeschaltet. Deren einer Eingang ist mit dem jeweiligen Ausgang der Gruppeneingangsstufe GPINWR verbunden und deren anderer Eingang ist mit dem Testsignal Test beaufschlagt.

In der Normalbetriebsart liegt an den Ausgängen GPD$_2$, $\overline{\text{GPD}_2}$ bis GPD$_Q$, $\overline{\text{GPD}_Q}$ beider logischer Schaltungen LOGWR einer Gruppeneingangsstufe GPINWR ein Signal mit demselben logischen Pegel an, während in der Testbetriebsart am Ausgang GPD$_{2,...,Q}$ der einen logischen Schaltung LOGWR das abgeleitete, komplementäre Datum anliegt und am Ausgang $\overline{\text{GPD}_{2,...,Q}}$ der anderen logischen Schaltung LOGWR das abgeleitete Datum anliegt.

Jede Gruppenschreibeinheit GPWR enthält weiterhin zwei Demultiplexer GPDMUXWR, von denen jeder Q Eingänge für die Gruppenadreßausgangssignale GPAD$_q'$ aufweist sowie einen weiteren Eingang, der einer der beiden Eingänge des Paares von Eingängen für das jeweilige, zum Schreiben vorgesehene Datenleitungspaar IODB-WR$_n$, $\overline{\text{IODB-WR}_n}$ des Ein-/Ausgabedatenbusses IODB ist. Darüber hinaus enthält jeder Demultiplexer GPDMUXWR (Q-1) zusätzliche Eingänge, von denen beim einen Demultiplexer GPDMUXWR jeder mit dem Ausgang GPD$_{2,...,Q}$ der jeweiligen einen logischen Schaltung LOGWR verbunden ist und von denen beim anderen Demultiplexer GPDMUXWR jeder mit dem Ausgang $\overline{\text{GPD}_{2,...,Q}}$ der jeweiligen anderen logischen Schaltung LOGWR verbunden ist. Jeder Demultiplexer GPDMUXWR weist Q Ausgänge auf. Die Ausgänge der Demultiplexer GPDMUXWR sind mit Q Paaren von Datenleitungen der M Paare von für Schreiben vorgesehenen Datenleitungen des der jeweiligen Gruppenein-/ausgabeeinheit GPIO zugeordneten Gruppendatenbusses GPDB verbunden.

In der Normalbetriebsart leitet beim Schreiben jede Gruppenschreibeinheit GPWR die an dem mit ihr eingangsmäßig verbundenen Datenleitungspaar IODB-WR$_n$, $\overline{\text{IODB-WR}_n}$ des Ein-/Ausgabedatenbusses IODB anliegenden Daten an diejenigen beiden Ausgänge durch, bezüglich derer eines der Gruppenadreßsignale GPAD$_q$, und somit das diesem zugeordnete Gruppenadreßausgangssignal GPAD$_q'$ der Gruppensteuerschaltung GPCTRL aktiviert ist. In der Testbetriebsart leitet beim Schreiben jede Gruppen schreibeinheit GPWR sowohl die an dem mit ihr eingangsmäßig verbundenen Datenleitunspaar IODB-WR$_n$, $\overline{\text{IODB-WR}_n}$ des Ein-/Ausgabedatenbusses IODB anliegenden Daten als auch die aus den an ihren Gruppeneingangsstufen GPINWR anliegenden Daten der I/O-Leitungen der dritten Art IO3 abgeleiteten Daten an einen jeweiligen Ausgang, und somit insgesamt auf einen Teil N des Gruppendatenbusses GPDB.

In der konkreten Ausführungsform nach Figur 17 enthält jeder Demultiplexer GPDMUXWR eine UND-Schaltung AND und (Q-1) logische Einheiten LU. Diese weisen jeweils einen Ausgang auf, der einer der Q Ausgänge des jeweiligen Demultiplexers GPDMUXWR ist. Jede UND-Schaltung AND weist zwei Eingänge auf und jede logische Einheit LU weist drei Eingänge auf. Die ersten Eingänge der UND-Schaltung AND und der logischen Einheiten LU jedes Demultiplexers GPDMUXWR sind mit dem einen weiteren Eingang des jeweiligen Demultiplexers GPDMUXWR verbunden. Die zweiten Eingänge der UND-Schaltung AND und der logischen Einheiten LU der Demultiplexer GPDMUXWR sind mit jeweils einem der Q Eingänge des jeweiligen Demultiplexers GPDMUXWR verbunden. Die dritten Eingänge der logischen Einheiten LU der Demultiplexer GPDMUXWR sind die zusätzlichen (Q-1) Eingänge des jeweiligen Demultiplexers GPDMUXWR.

Die UND-Schaltungen AND enthalten jeweils ein NAND-Gatter mit den beiden Eingängen der UND-Schaltung AND sowie einen diesem nachgeschalteten Inverter. Die logischen Einheiten LU enthalten jeweils ein erstes NAND-Gatter mit zwei Eingängen, die die ersten beiden Eingänge der logischen Einheit LU sind. Jedem ersten NAND-Gatter ist ein zweites NAND-Gatter mit ebenfalls zwei Eingängen zugeordnet, wobei der eine Eingang mit dem Ausgang des ersten NAND-Gatters verbunden ist und wobei der andere Eingang der dritte Eingang der logischen Einheit LU ist.

Die Gruppeneingangsstufe GPINWR enthält ein Buffer BF zur Zwischenspeicherung des über die jeweilige Datenleitung der dritten Art IO3 anliegenden Datums. Die Gruppeneingangsstufe GPINWR enthält zwei UND-Schaltungen AND mit jeweils zwei Eingängen, wobei dem einen Eingang der einen UND-Schaltung AND das an der jeweiligen Datenleitung der dritten Art IO3 anliegende Datum zugeführt ist. Dem einen Eingang der anderen UND-Schaltung AND ist das an der jeweiligen Datenleitung der dritten Art IO3 anliegende Datum in invertierter Form zugeführt. Die anderen Eingänge der UND-Schaltungen AND sind mit dem Schreibsteuersignal beaufschlagt.

Figur 18 zeigt eine der Gruppenleseeinheiten GPRD. Bezüglich des Index n = (1...N) wird wiederum angenommen, daß es die n-te Gruppenleseeinheit GPRD sei. Sie weist Q Paare von Dateneingängen auf, die mit einer entsprechenden Anzahl von Datenleitungspaaren $GPDB\text{-}RD_{n,q}$, $\overline{GPDB\text{-}RD}_{n,q}$ des jeweiligen Gruppendatenbusses GPDB verbunden sind, die für Lesen vorgesehen sind. Sie weist außerdem Adreßeingänge auf für die Gruppenadreßausgangssignale $GPAD'_q$ der Gruppensteuerschaltung GPCTRL. Dabei ist jedes der Gruppenadreßausgangssignale $GPAD'_q$ einem der Q Paare von Dateneingängen zugeordnet. Sie weist auch Eingänge für das Lesesteuersignal RD und für das Testsignal Test auf. Eine Gruppenleseeinheit GPRD weist weiterhin ein Paar von Ausgängen auf für ein Datenleitungspaar $IODB\text{-}RD_n$, $\overline{IODB\text{-}RD}_n$ des Ein-/Ausgabedatenbusses IODB, welches dem Lesen dient. Außerdem weist sie (Q-1) Ausgänge auf, die mit den I/O-Leitungen der dritten Art IO3 verbunden sind.

In der Normalbetriebsart werden Daten desjenigen Paares der Q Paare von Dateneingängen, dessen ihm zugeordneter Adreßeingang den ersten logischen Pegel aufweist, den eines der Q Gruppenadressignale $GPAD_q$, und den somit auch eines der Q Gruppenadreßausgangssignale $GPAD'_q$ der Gruppensteuerschaltung GPCTRL aufweist, auf das mit dem einen Datenleitungspaar $IODB\text{-}RD_n$, $\overline{IODB\text{-}RD}_n$ des Ein-/Ausgabedatenbusses IODB verbundene Paar von Ausgängen durchgeschaltet.

In der Testbetriebsart werden am ersten Paar der Dateneingänge anliegende Daten auf das mit dem einen Datenleitungspaar $IODB\text{-}RD_n$, $\overline{IODB\text{-}RD}_n$ des Ein-/Ausgabedatenbusses IODB verbundene Paar von Ausgängen durchgeschaltet. Außerdem werden in der Testbetriebsart die an den restlichen (Q-1) Dateneingängen anliegende Daten auf die mit den I/O-Datenleitungen der dritten Art IO3 verbundenen (Q-1) Ausgänge durchgeschaltet.

Nach Figur 18 enthält eine Gruppenleseeinheit GPRD zwei Multiplexer GPMUXRD, 2(Q-1) logische Einheiten LOGRD und (Q-1) Gruppenausgangsstufen GPOUTRD. Jeder Multiplexer GPMUXRD ist mit Q jeweiligen Datenleitungen $GPDB\text{-}RD_{n,q}$ bzw. $\overline{GPDB\text{-}RD}_{n,q}$ aller Q für Lesen vorgesehenen Datenleitungspaare $GPDB\text{-}RD_{n,1...Q}$, $\overline{GPDB\text{-}RD}_{n,1...Q}$ eines Teils N des Gruppendatenbusses GPDB eingangsmäßig verbunden. Er ist mit den Adreßeingängen der Gruppenleseeinheit GPRD für die Gruppenadreßausgangssignale $GPAD'_q$ der Gruppensteuerschaltung GPCTRL eingangsmäßig verbunden. Jeder Multiplexer weist einen Ausgang auf, der als Ausgang der Gruppenleseeinheit GPRD mit einer Leitung $IODB\text{-}RD_n$ bzw. $\overline{IODB\text{-}RD}_n$ der Leitungen des Datenleitungspaares $IODB\text{-}RD_n$, $\overline{IODB\text{-}RD}_n$ des Ein-/Ausgabedatenbusses IODB verbunden ist.

In der Normalbetriebsart wird dasjenige Datum auf den mit dem Ein-/Ausgabedatenbus IODB verbundenen Ausgang durchgeschaltet, das an der jeweiligen Datenleitung eines solchen Paares der Q Datenleitungspaare anliegt, dessen ihm zugeordnetes Gruppenadreßausgangssignal $GPAD'_q$ den ersten logischen Pegel aufweist.

In der Testbetriebsart wird das an der jeweiligen Datenleitung $GPDB\text{-}RD_{n,1}$ bzw. $\overline{GPDB\text{-}RD}_{n,1}$ des ersten Paares $GPDB\text{-}RD_{n,1}$, $\overline{GPDB\text{-}RD}_{n,1}$ von Datenleitungen des Teils N des Gruppendatenbusses GPDB anliegende Datum auf den jeweiligen Ausgang durchgeschaltet.

In Figur 18 ist jede logische Einheit LOGRD ein NAND-Gatter mit zwei Eingängen. Jeweils zwei logische Einheiten LOGRD sind funktionell so zusammengefaßt, daß ihre ersten Eingänge mit einer jeweiligen Datenleitung $GPDB\text{-}RD_{n,2,...,Q}$ bzw. $\overline{GPDB\text{-}RD}_{n,2,...,Q}$ eines der (Q-1) für Lesen vorgesehenen Datenleitungspaare $GPDB\text{-}RD_{n,2...Q}$, $\overline{GPDB\text{-}RD}_{n,2...Q}$ des Teils N des Gruppendatenbusses GPDB verbunden sind. Die zweiten Eingänge jeder logischen Einheit LOGRD sind mit dem Testsignal Test verbunden. Die Ausgänge von jeweils 2 logischen Einheiten LOGRD sind gleichzeitig Eingänge der ihr nachgeschalteten Gruppenausgangsstufe GPOUTRD.

Eine Gruppenausgangsstufe GPOUTRD enthält zwei UND-Schaltungen AND mit je drei Eingängen und eine beiden UND-Schaltungen AND nachgeschaltete Endstufe. Die ersten Eingänge der UND-Schaltungen AND sind über einen Inverter mit dem Ausgang einer jeweiligen logischen Einheit LOGRD verbunden. Die zweiten Eingänge der UND-Schaltungen AND sind mit dem Ausgang der jeweils anderen logischen Einheit LOGRD verbunden. Die dritten Eingänge sind mit dem Lesesteuersignal RD beaufschlagt. Der Ausgang der Endstufe ist der Ausgang der Gruppenausgangsstufe GPOUTRD, welcher gleichzeitig einer der (Q-1) Ausgänge der Gruppenleseeinheit GPRD ist.

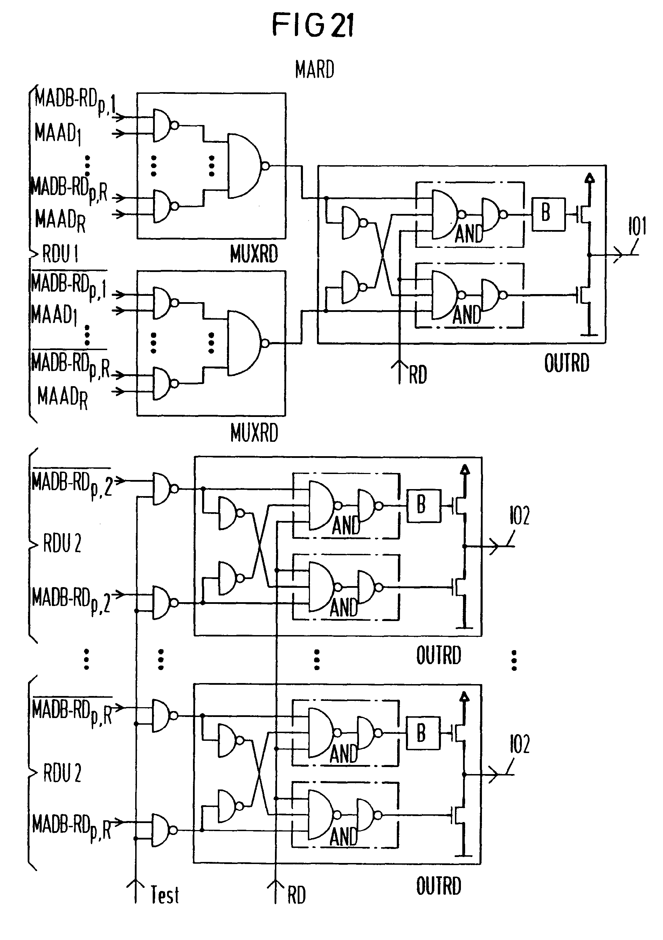

Die Endstufe kann auch, wie in Figur 18 schematisch dargestellt, eine Boostanordnung B enthalten zur Überhöhung des High-Pegels des anliegenden Signals, um Spannungsverluste am Ausgang der Gruppenausgangsstufe GPOUTRD zu vermeiden. Diese Maßnahme als solche ist bekannt (z.B. als "Wortleitungsüberhöhungsschaltung"). Entsprechendes gilt auch bezüglich den in Figuren 11 und 21 gezeigten Endstufen der Ausgangsstufen OUTRD.

Anhand des bislang Beschriebenen ergibt sich an den Busausgängen aller Gruppenein-/ausgabeeinheiten GPIO folgendes Bild (vgl. dazu auch Figur 13):

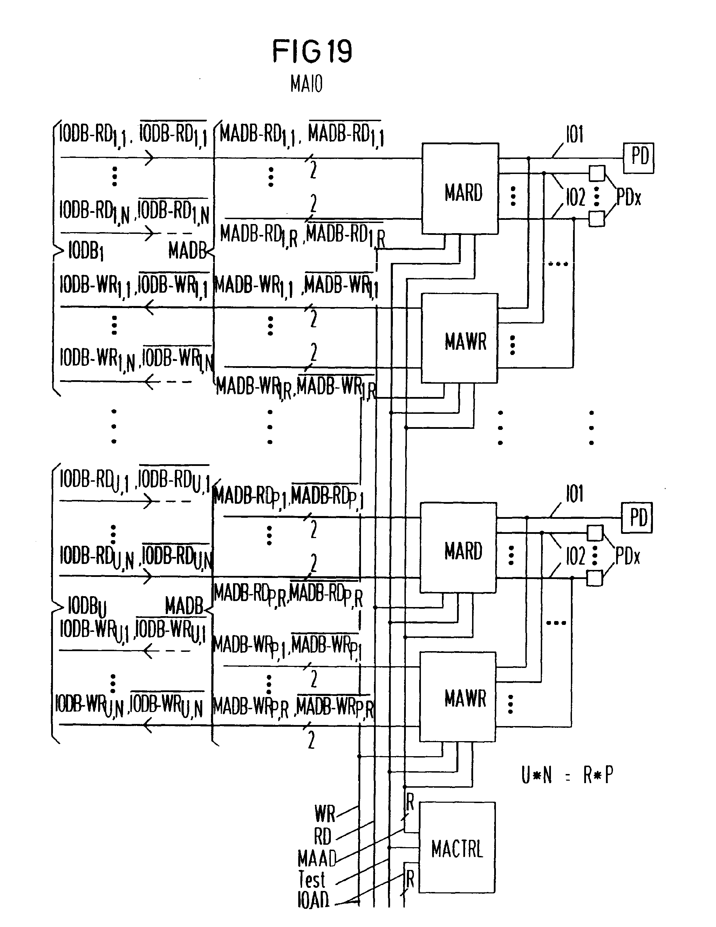

Jeder Blockgruppe $GP_u$ ist ein Ein-/Ausgabedatenbus IODB mit jeweils N Paaren von Datenleitungen zum Lesen und/oder Schreiben zugeordnet: IODB-$RD_{1...N}$, $\overline{\text{IODB-RD}}_{1...N}$ und IODB-$WR_{1...N}$, $\overline{\text{IODB-WR}}_{1...N}$ (unidirektionaler Betrieb) bzw. $IODB_{1...N}$, $\overline{IODB}_{1...N}$ (bidirektionaler Betrieb). Nach Figur 13 ist die Zellenfeldeinheit MAIO mit U solchen Bussen eingangsmäßig verbunden, so daß man die Gesamtzahl der Datenleitungen dieser Busse in dem Fall, in dem man diese als einen einzigen Bus betrachtet, insgesamt folgendermaßen indizieren müßte: $IODB_{1...U,1...N}$, $\overline{IODB}_{1...U,1...N}$ (für bidirektionalen Betrieb) bzw. IODB-$RD_{1...U,1...N}$, $\overline{\text{IODB}}_{1...U,1...N}$, IODB-$WR_{1...U,1...N}$, $\overline{\text{IODB-WR}}_{1...U,1...N}$ (für unidirektionalen Betrieb) mit u = 1...U als dem langsamer als n = 1...N lau fenden Index. Wie man daraus ersieht, stehen also U.N Schreibdatenleitungen und U.N Lesedatenleitungen zur weiteren Verarbeitung zur Verfügung (unidirektionaler Betrieb betrachtet; für bidirektionalen Betrieb gilt entsprechendes). Diese kann man nun gedanklich insgesamt mit anderen Indizes versehen und die so entstehenden neuen Zuordnungen insgesamt als Zellenfelddatenbus MADB bezeichnen, dessen Paare von Schreibdatenleitungen die Indizierung MADB-$WR_{1...P,1...R}$ und $\overline{\text{MADB-WR}}_{1...P,1...R}$ aufweisen und dessen Paare von Lesedatenleitungen die Indizierung MADB-$RD_{1...P,1...R}$ und $\overline{\text{MADB-RD}}_{1...P,1...R}$ aufweisen, wobei folgende Annahmen gelten: p = 1...P, r = 1...R; der Index p läuft langsamer als der Index r. Außerdem gilt: U.N = P.R. Vorstehende Ausführungen treffen für unidirektionalen Betrieb zu (der in den Figuren 19 und folgenden gezeigt ist). Sie sind jedoch für den Fachmann leicht abänderbar für bidirektionalen Betrieb.

Figur 19 zeigt die Zellenfeldein-/ausgabeeinheit MAIO. Diese ist, wie Figur 13 zeigt, mit den U Ein-/Ausgabedatenbussen IODB mit den obengenannten Datenleitungen verbunden, in Figur 19 (s. ganz links) dargestellt als $IODB_{1...U}$. Für die weitere Erläuterung sei jedoch die vorstehend beschriebene "Umorganisation" dieser U Busse in P Zellenfelddatenbusse MADB vorgenommen mit folgender Indizierung der zugehörigen Paare von Schreib- und Lesedatenleitungen: MADB-$WR_{p,r}$, $\overline{\text{MADB-WR}}_{p,r}$; MADB-$RD_{p,r}$, $\overline{\text{MADB-RD}}_{p,r}$. Auch dieses ist in Figur 19 angedeutet.

Nachstehend wird nun Figur 19 näher erläutert: Ganz links außen ist die Organisationsstruktur gemäß der Einteilung in U Ein-/Ausgabedatenbusse $IODB_u$ gezeigt. Rechts daneben ist die Organisationsstruktur gemäß der Einteilung in P Zellenfelddatenbusse MADB gezeigt.

Die Zellenfeldein-/Ausgabeeinheit MAIO enthält P Zellenfeldleseeinheiten MARD mit jeweils R Leseeinheiten (RDU1; RDU2), P Zellenfeldschreibeinheiten MAWR, die jeweils einer der P Zellenfeldleseeinheiten MARD zugeordnet sind und die jeweils R Schreibeinheiten (WRU1; WRU2) enthalten, sowie eine Zellenfeldsteuerschaltung MACTRL.

Jede Zellenfeldleseeinheit MARD weist die R Paare von Dateneingangsleitungen MADB-$RD_{p,r}$, $\overline{\text{MADB-RD}}_{p,r}$ eines der P Zellenfelddatenbusse MADB auf. Jede Zellenfeldschreibeinheit MAWR weist die R Paare von Datenausgangsleitungen MADB-$WR_{p,r}$, $\overline{\text{MADB-WR}}_{p,r}$ des Zellenfelddatenbusses MADB auf. Jede Zellenfeldleseeinheit MARD ist an einem Ausgang mit einer der I/O-Datenleitungen der ersten Art IO1 und mit einem Dateneingang der ihr zugeordneten Zellenfeldschreibeinheit MAWR verbunden. Jede Zellenfeldleseeinheit MARD hat weiterhin Ausgänge für (R-1) I/O-Datenleitungen der zweiten Art IO2. Alle Zellenfeldleseeinheiten MARD sind gemeinsam mit dem Lesesteuersignal RD beaufschlagt. Alle Zellenfeldschreibeinheiten MAWR sind gemeinsam mit dem Schreibsteuersignal WR beaufschlagt. Alle Zellenfeldleseeinheiten MARD, alle Zellenfeldschreibeinheiten MAWR und die Zellenfeldsteuerschaltung MACTRL sind gemeinsam mit dem Testsignal Test beaufschlagt. Alle Zellenfeldleseeinheiten MARD und alle Zellenfeldschreibeinheiten MAWR sind gemeinsam mit einem Zellenfeldadreßbus MAAD verbunden. Somit sind alle Zellenfeldleseeinheiten MARD und alle Zellenfeldschreibeinheiten MAWR jeweils gemeinsam betreibbar.

Die Zellenfeldsteuerschaltung MACTRL ist eine Schaltung zum Generieren des Zellenfeldadreßbusses

EP 0 527 866 B1

MAAD aus dem I/O-Adreßbus IOAD unter Steuerung durch das Testsignal Test, wobei der Zellenfeldadreßbus MAAD R Adreßleitungen $MAAD_{1...R}$ umfaßt.

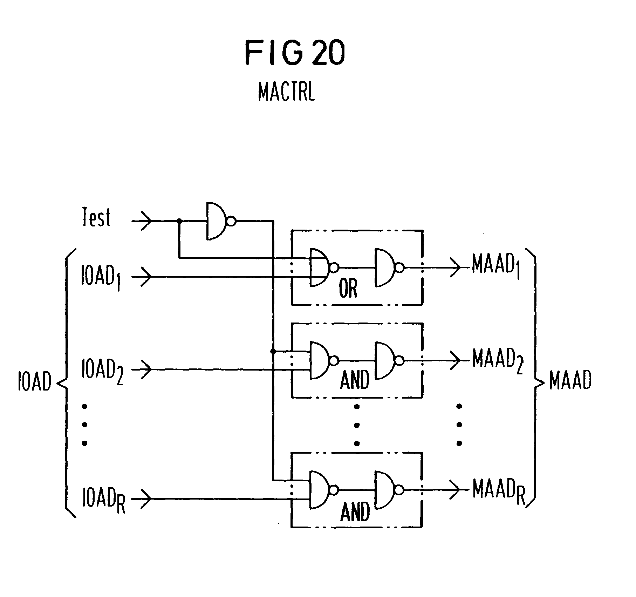

Figur 20 zeigt die Zellenfeldsteuerschaltung MACTRL. Sie ist ein Dekoder, der in der Normalbetriebsart den I/O-Adreßbus IOAD auf den Zellenfeldadreßbus MAAD durchschaltet. In der Testbetriebsart weist eine erste Leitung $MAAD_1$ des Zellenfeldadreßbusses MAAD vermittels des Testsignals Test einen konstanten logischen Pegel auf. Die restlichen (R-1) Leitungen des Zellenfeldadreßbusses MAAD hingegen weisen einen zum logischen Pegel der ersten Leitung $MAAD_1$ komplementären logischen Pegel auf, der ebenfalls konstant ist.

Die Zellenfeldsteuerschaltung MACTRL weist eine ODER-Schaltung OR mit zwei Eingängen und einem Ausgang auf, wobei der eine Eingang mit dem Testsignal Test beaufschlagt ist, wobei der andere Eingang mit einer ersten Leitung $IOAD_1$ des I/O-Adreßbusses IOAD verbunden ist und wobei der Ausgang mit der ersten Leitung $MAAD_1$ des Zellenfeldadreßbusses MAAD verbunden ist. Sie weist weiterhin (R-1) UND-Schaltungen AND auf mit jeweils zwei Eingängen und einem Ausgang. Jeweils der eine Eingang ist mit einem zum Testsignal Test komplementären Signal beaufschlagt. Jeder der anderen Eingänge ist mit einer der restlichen (R-1) Leitungen des I/O-Adreßbusses IOAD verbunden. Jeder der Ausgänge ist mit einer der restlichen (R-1) Leitungen $MAAD_{2...R}$ des Zellenfeldadreßbusses MAAD verbunden.

In der Ausführungsform nach Figur 20 enthält die ODER-Schaltung OR eine NOR-Schaltung und einen diesem nachgeschalteten Inverter. Die UND-Schaltungen AND enthalten jeweils ein NAND-Gatter und einen diesem nachgeschalteten Inverter.

Figur 21 zeigt eine Zellenfeldleseeinheit MARD mit einer ersten Leseeinheit RDU1 und (R-1) zweiten Leseeinheiten RDU2, von denen zwei dargestellt sind, während die restlichen (R-3) Leseeinheiten RDU2 durch Pünktchen angedeutet sind. Die erste Leseeinheit RDU1 enthält zwei Multiplexer MUXRD und eine Ausgangsstufe OUTRD. Jeder Multiplexer MUXRD weist R erste Eingänge auf für jeweils eine Dateneingangsleitung $MADB\text{-}RD_{p,r}$ bzw. $\overline{MADB\text{-}RD}_{p,r}$ der R Paare von Dateneingangsleitungen $MADB\text{-}RD_{p,r}$, $\overline{MADB\text{-}RD}_{p,r}$ sowie R zweite Eingänge für den Zellenfeldadreßbus MAAD. Dessen Leitungen sind den Dateneingangsleitungen $MADB\text{-}RD_{p,r}$ und $\overline{MADB\text{-}RD}_{p,r}$ zugeordnet. Außerdem weist er einen Ausgang auf.

Bei beiden Multiplexern MUXRD ist in der Normalbetriebsart diejenige der Dateneingangsleitungen $MADB\text{-}RD_{p,r}$ bzw. $\overline{MADB\text{-}RD}_{p,r}$ auf den jeweiligen Ausgang durchgeschaltet, deren zugeordnete Leitung des Zellenfeldadreßbusses MAAD einen aktivierten elektrischen Zustand aufweist.

Bei beiden Multiplexern MUXRD ist in der Testbetriebsart diejenige der Dateneingangsleitungen $MADB\text{-}RD_{p,r}$ bzw. $\overline{MADB\text{-}RD}_{p,r}$ auf den Ausgang durchgeschaltet, der die erste Leitung $MAAD_1$ des Zellenfeidadreßbuses MAAD mit ihrem konstanten logischen Pegel zugeordnet ist.

Die Ausgangsstufe OUTRD ist eine Treiberschaltung, deren Ausgang der mit einer der I/O-Datenleitungen der ersten Art IO1 verbundene Ausgang der gesamten Zellenfeldleseeinheit MARD ist und der das am Ausgang des einen Multiplexers MUXRD anliegende Signal in verstärkter Form aufweist.

In Figur 21 weist jeder Multiplexer MUXRD der ersten Leseeinheit RDU1 R NAND-Gatter mit jeweils zwei Eingängen auf, deren einer Eingang jeweils einer der R ersten Eingänge des Multiplexers MUXRD ist und deren anderer Eingang jeweils einer der R zweiten Eingänge des Multiplexers MUXRD ist. Jeder Multiplexer MUXRD der ersten Leseeinheit RDU1 weist ein zusätzliches NAND-Gatter mit R Eingängen auf, die jeweils mit einem Ausgang der R NAND-Gatter verbunden sind. Der Ausgang des zusätzlichen NAND-Gatters ist der Ausgang des jeweiligen Multiplexers MUXRD der ersten Leseeinheit RDU1.

Die Ausgangsstufe OUTRD weist zwei UND-Schaltungen AND auf mit jeweils drei Eingängen und einem Ausgang. Der jeweilige erste Eingang jeder UND-Schaltung AND ist mit dem Ausgang des jeweils einen Multiplexers MUXRD verbunden. Der jeweilige zweite Eingang jeder UND-Schaltung AND ist mit dem Ausgang des jeweils anderen Multiplexers MUXRD über einen Inverter verbunden. Die dritten Eingänge der UND-Schaltungen AND sind mit dem Lesesteuersignal RD beaufschlagt. Die Ausgangsstufe OUTRD weist eine Endstufe auf, die eingangsmäßig mit den Ausgängen der UND-Schaltungen AND verbunden ist und deren Ausgang der Ausgang der Ausgangsstufe OUTRD und der ersten Leseeinheit RDU1 ist. Die UND-Schaltungen AND sind als NAND-Gatter mit nachgeschaltetem Inverter realisiert. Die Endstufe kann auch eine Boostanordnung B enthalten, wie bezüglich Figur 18 bereits beschrieben.

Jede der restlichen (R-1) Leseeinheiten RDU2 enthält eine Ausgangsstufe OUTRD mit zwei Eingängen und einem Ausgang. Der Ausgang ist einer der Ausgänge für die (R-1) I/O-Datenleitungen der zweiten Art IO2. Jedem Eingang einer Ausgangsstufe OUTRD ist eine NAND-Schaltung mit zwei Eingängen vorgeschaltet, deren erster Eingang verbunden ist mit jeweils einer der beiden Dateneingangsleitungen $\overline{MADB\text{-}RD}_{p,2...R}$ bzw. $MADB\text{-}RD_{p,2...R}$ eines der R Paare von Dateneingangsleitungen $MADB\text{-}RD_{p,r}$, $\overline{MADB\text{-}RD}_{p,r}$ mit Ausnahme des ersten Paares $MADB\text{-}RD_{p,1}$, $\overline{MADB\text{-}RD}_{p,1}$ dieser R Paare. Deren zweiter Eingang ist mit dem Testsignal Test beaufschlagt.

In der Normalbetriebsart sind die Ausgänge der restlichen (R-1) Leseeinheiten (RDU2) hochohmig ge-

16

schaltet.

In der Testbetriebsart liegt am Ausgang jeder der restlichen (R-1) Leseeinheiten (RDU2) das an der einen Dateneingangsleitung $\overline{\text{MADB-RD}}_{p,2...R}$ des jeweiligen Paares von Dateneingangsleitungen MADB-RD$_{p,2...R}$, $\overline{\text{MADB-RD}}_{p,2...R}$ anliegende Signal in verstärkter Form an.

Die Ausgangsstufen OUTRD der restlichen (R-1) Leseeinheiten RDU2 sind gleich der Ausgangsstufe OUTRD der ersten Leseeinheit RDU1 der jeweiligen Zellenfeldleseeinheit MARD.

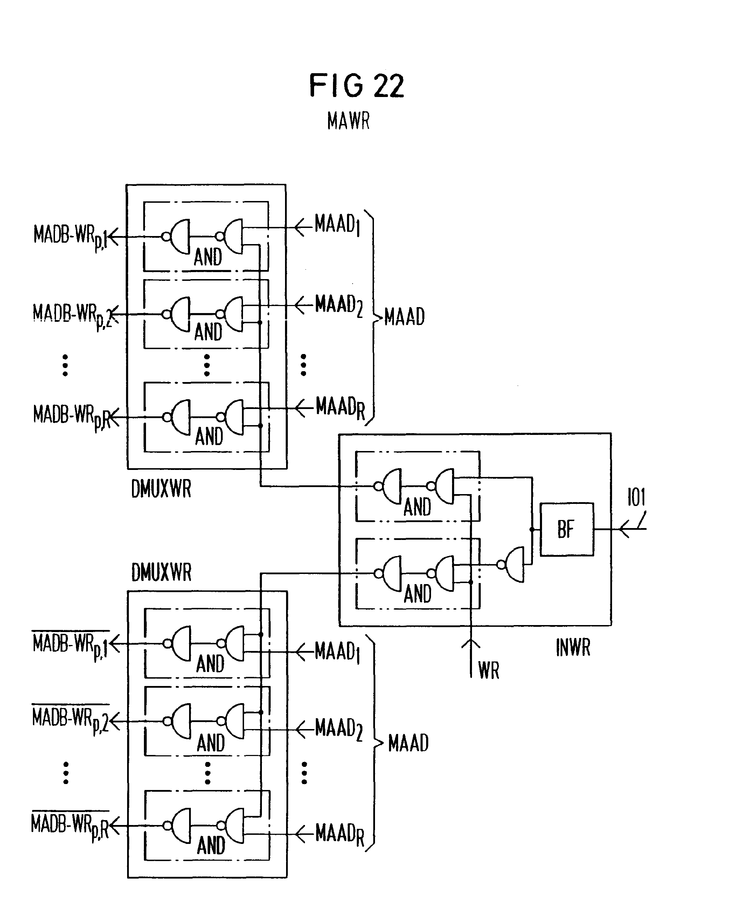

Figur 22 zeigt eine erste Ausführungsform einer Zellenfeldschreibeinheit MAWR für die zweite Ausführungsform des erfindungsgemäßen Halbleiterspeichers. Sie ist identisch mit der in Figur 12 bezüglich der ersten Ausführungsform des erfindungsgemäßen Halbleiterspeichers gezeigten Zellenfeldschreibeinheit MAWR. Von einer näheren Beschreibung von Figur 22 wird deshalb abgesehen und auf Figur 12 verwiesen. Es wird lediglich noch auf folgendes hingewiesen: Da bei der zweiten Ausführungsform des erfindungsgemäßen Halbleiterspeichers ein einziger Zellenfeldadreßbus MAAD zum Schreiben und zum Lesen dient (im Gegensatz zur ersten Ausführungsform des erfindungsgemäßen Halbleiterspeichers), wurde dies in Figur 22 beim Bezugszeichen MAAD entsprechend berücksichtigt. Ebenso wurde bei den Datenausgangsleitungen MADB-WR$_{p,r}$, $\overline{\text{MADB-WR}}_{p,r}$ der Zellenfelddatenbusse MADB die Nomenklatur an die bei der zweiten Ausführungsform des erfindungsgemäßen Halbleiterspeichers verwendete Nomenklatur angepaßt.

Bei dieser Ausführungsform einer Zellenfeldschreibeinheit MAWR liegt beim Schreiben in der Testbetriebsart ein an der I/O-Datenleitung der ersten Art IO1 anliegendes Datum an allen jeweiligen einen R Datenausgangsleitungen MADB-WR$_{p,1...R}$ an und in invertierter Form an allen jeweiligen anderen R Datenausgangsleitungen $\overline{\text{MADB-WR}}_{p,1...R}$, so daß dieses Datum in R der insgesamt U.N. Speicherzellen MC gleichzeitig eingeschrieben wird.

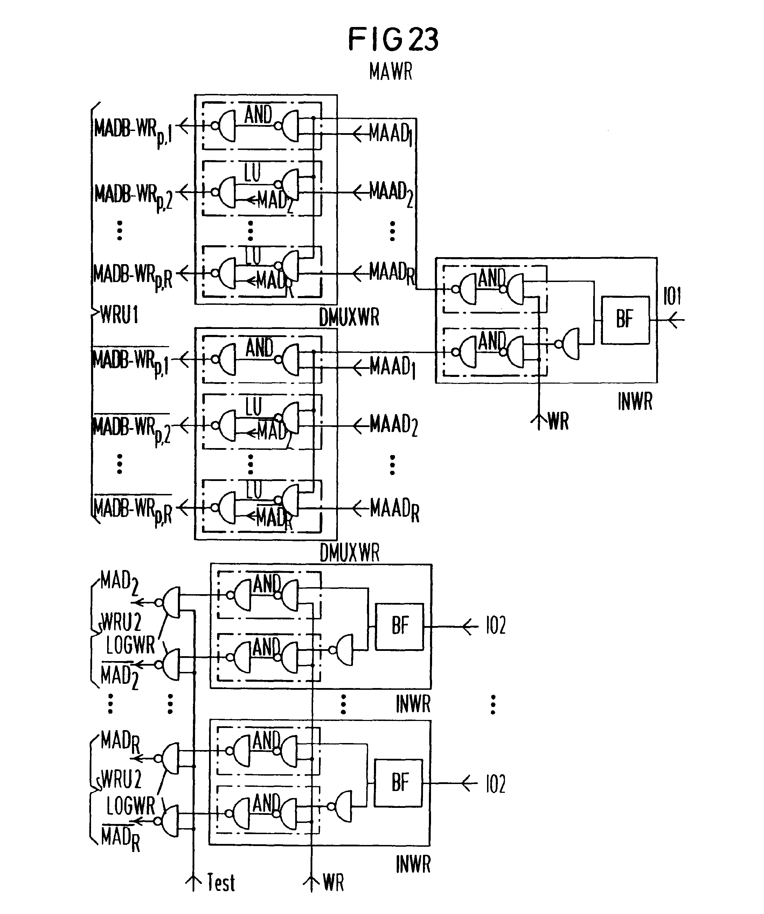

Figur 23 zeigt eine zweite Ausführungsform einer Zellenfeldschreibeinheit MAWR. Sie ist schaltungstechnisch weitgehend aufgebaut wie die bereits beschriebene Gruppenschreibeinheit GPWR (siehe Figur 17). Wegen der unterschiedlichen Nomenklatur bei den Datenleitungen und wegen des Vorhandenseins einer gegenüber der Gruppenschreibeinheit GPWR zusätzlichen Eingangsstufe INWR wird Figur 23 nachstehend trotzdem ausführlich beschrieben:

Jede der P Zellenschreibeinheiten MAWR ist an einem ersten Eingang mit einer der P I/O-Datenleitungen der ersten Art IO1 verbunden. Sie ist an weiteren (R-1) ersten Eingängen mit jeweils einer der I/O-Datenleitungen der zweiten Art IO2 verbunden. Ein zweiter Eingang ist mit dem Schreibsteuersignal WR beaufschlagt. Jede Zellenfeldschreibeinheit MAWR enthält weiterhin dritte Eingänge für den Zellenfeldadreßbus MAAD und Ausgänge für die R Paare von Datenausgangsleitungen MADB-WR$_{p,r}$, $\overline{\text{MADB-WR}}_{p,r}$ eines der Zellenfelddatenbusse MADB.

In der Normalbetriebsart gibt jede Zellenfeldschreibeinheit MAWR ein in den Speicher einzuschreibendes, auf der jeweiligen I/O-Datenleitung der ersten Art IO1 anliegendes Datum und ein dazu komplementäres Datum in Abhängigkeit vom Schreibsteuersignal WR und vom Zellenfeldadreßbus MAAD auf dasjenige Paar von Datenausgangsleitungen MADB-WR$_{p,r}$, $\overline{\text{MADB-WR}}_{p,r}$ weiter, bezüglich dessen eine Leitung des I/O-Adreßbusses IOAD, und somit eine Leitung des Zellenfeldadreßbusses MAAD und aktiviert ist.

In der Testbetriebsart gibt sie zum einen das an der I/O-Datenleitung der ersten Art IO1 und das dazu komplementäre Datum auf das erste Paar MADB-WR$_{p,1}$, $\overline{\text{MADB-WR}}_{p,1}$ der R Paare von Datenausgangsleitungen MADB-WR$_{p,r}$, $\overline{\text{MADB-WR}}_{p,r}$ weiter. Zum anderen gibt sie in der Testbetriebsart an den weiteren (R-1) ersten Eingängen anliegenden Daten und ein jeweils dazu komplementäres Datum auf ein jeweiliges Paar $\overline{\text{MADB-}}$ WR$_{p,2,...,R}$, $\overline{\text{MADB-WR}}_{p,2...R}$ der restlichen (R-1) Paare von Datenausgangsleitungen MADB-WR$_{p,2...R}$, $\overline{\text{MADB-}}$ WR$_{p,2...R}$ der R Paare von Datenausgangsleitungen MADB-WR$_{p,r}$, $\overline{\text{MADB-WR}}_{p,r}$ weiter.

Zur Realisierung dieser Funktion enthält die Zellenfeldschreibeinheit MAWR nach Figur 23 zwei Demultiplexer DMUXWR und R Eingangsstufen INWR. Die erste der Eingangsstufen (INWR) ist an einem ersten Eingang mit der I/O-Datenleitungen der ersten Art IO1 verbunden, welche beim Einschreiben mit einem einzuschreibenden Datum beaufschlagt ist. Die restlichen (R-1) Eingangsstufen INWR sind an einem jeweiligen ersten Eingang mit eienr jeweiligen I/O-Datenleitung der zweiten Art IO2 verbunden, welche beim Einschreiben mit einem jeweiligen einzuschreibenden Datum beaufschlagt ist. Jede Eingangsstufe INWR ist an einem zweiten Eingang mit dem Schreibsteuersignal WR beaufschlagt. Jede Eingangsstufe INWR weist zwei Ausgänge auf. Am einen Ausgang liegt bei aktiviertem Schreibsteuersignal WR das an ihrem ersten Eingang anliegende Datum an. Am anderen Ausgang liegt bei aktiviertem Schreibsteuersignal WR das zu diesem Datum komplementäre Datum an. Bei der jeder (R-1) restlichen Eingangsstufen INWR ist ihren beiden Ausgängen jeweils eine logische Schaltung LOGWR nachgeschaltet mit zwei Eingängen und einem Ausgang MAD$_{2,...,R}$ bzw. $\overline{\text{MAD}}_{2,...,R}$, deren einer Eingang mit dem jeweiligen der beiden Ausgänge der Eingangsstufe INWR verbunden ist und deren anderer Eingang mit dem Testsignal Test beaufschlagt ist.

In der Normalbetriebsart liegen an den Ausgängen MAD$_{2;...;R}$ bzw. $\overline{\text{MAD}}_{2;...;R}$ aller den (R-1) restlichen Eingangsstufen INWR nachgeschalteten logischen Schaltungen LOGWR ein Signal mit einem einander gleichen logischen Pegel an, während in der Testbetriebsart bezüglich jeder der (R-1) restlichen Eingangsstufen INWR am Ausgang $MAD_{2,...,R}$ der einen logischen Schaltung LOGWR das jeweilige komplementäre Datum und am Ausgang $\overline{MAD}_{2,...,R}$ der anderen logischen Schaltung LOGWR das jeweilige einzuschreibende Datum anliegt.

Jeder Demultiplexer DMUXWR enthält eine UND-Schaltung AND mit zwei Eingängen und (R-1) logische Einheiten LU mit drei Eingängen sowie R Ausgänge. Beim einen Demultiplexer DMUXWR sind der erste Eingang der UND-Schaltung AND und die ersten Eingänge der logischen Einheiten LU mit dem einen Ausgang der ersten Eingangsstufe INWR verbunden. Beim anderen Demultiplexer DMUXWR sind der erste Eingang der UND-Schaltung AND und die ersten Eingänge der logischen Einheiten LU mit dem anderen Ausgang der ersten Eingangsstufe INWR verbunden. Bei beiden Demultiplexern DMUXWR sind die zweiten Eingänge der UND-Schaltungen AND und die zweiten Eingänge der logischen Einheiten LU mit einer jeweiligen Leitung $MAAD_r$ des Zellenfeldadreßbusses MAAD verbunden. Beim einen Demultiplexer DMUXWR sind die dritten Eingänge der LU mit dem Ausgang $MAD_{2,...,R}$ der einen einer jeweiligen der restlichen (R-1) Eingangsstufen INWR nachgeschalteten logischen Schaltungen LOGWR verbunden. Beim anderen Demultiplexer DMUXWR sind die dritten Eingänge der logischen Einheiten LU mit dem Ausgang $\overline{MAD}_{2,...,R}$ der anderen einer jeweiligen der restlichen (R-1) Eingangsstufen INWR nachgeschalteten logischen Schaltung LOGWR verbunden. Jeder Demultiplexer DMUXWR weist R Ausgänge auf, die insgesamt die Ausgänge der Zellenfeldschreibeinheit MAWR sind.

In Figur 23 enthält jede Eingangsstufe INWR einen Buffer BF für das an einer I/O-Datenleitung der jeweiligen Art IO1 bzw. IO2 anliegende Datum. Sie enthält zwei UND-Schaltungen AND mit jeweils zwei Eingängen und einem Ausgang, die dem Buffer BF nachgeschaltet sind, wobei der erste Eingang der einen UND-Schaltung mit einem Ausgang des Buffers BF verbunden ist und wobei der erste Eingang der anderen UND-Schaltung AND über einen Inverter mit dem Ausgang des Buffers BF verbunden ist. Die zweiten Eingänge der UND-Schaltungen AND sind mit dem Schreibsteuersignal WR beaufschlagt.

Die UND-Schaltungen AND enthalten jeweils ein NAND-Gatter mit zwei Eingängen und einen diesem nachgeschalteten Inverter.

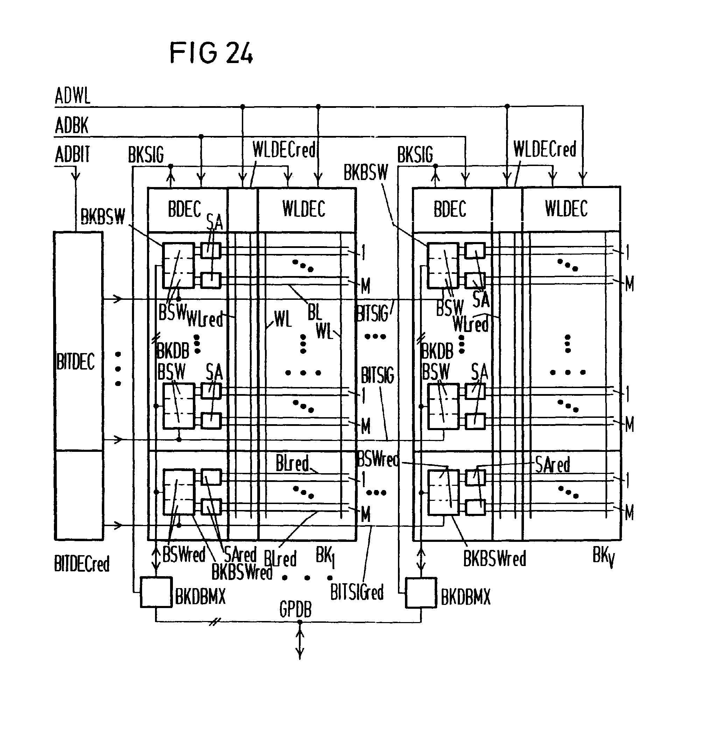

Figur 24 zeigt die Kombination von zwei weiteren Ausführungsformen des Halbleiterspeichers mit Paralleltesteinrichtung, allerdings nur ausschnittsweise, soweit für die Darstellung der Ausführungsformen notwendig.

In der einen weiteren Ausführungsform enthält jeder der Speicherblöcke $BK_{1...V}$ einer Blockgruppe $GP_u$ von üblichen Halbleiterspeichern bereits bekannte weitere Wortleitungen mit Speicherzellen, nämlich sogenannte redundante Wortleitungen WLred mit redundanten Speicherzellen MCred. Den redundanten Wortleitungen WLred sind redundante Wortleitungsdekoder WLDECred zugeordnet, denen die Wortleitungsadressen ADWL ebenfalls zugeführt sind. Sie dienen einem an sich bekannten Ersetzen defekter (und sämtlicher noch intakter) Speicherzellen MC entlang einer normalen Wortleitung WL durch die redundanten Speicherzellen MCred entlang einer der redundanten Wortleitungen WLred (Redundanzfall), so daß im Redundanzfall statt einer Anwahl einer Wortleitung WL mit den defekten Speicherzellen MC eine Anwahl einer entsprechenden redundanten Wortleitung WLred samt den zugehörigen redundanten Speicherzellen MCred erfolgt. Dabei sind die redundanten Speicherzellen MCred über die den ersetzten Speicherzellen MC zugeordneten Paare von Bitleitungen BL, die Leseverstärker SA und die Bitschalterblöcke BKBSW mit den entsprechenden Leitungen des jeweiligen Blockdatenbusse BKDB verbindbar.

Die andere weitere Ausführungsform, ebenfalls in Figur 24 gezeigt, enthält je Speicherblock $BK_v$ (wenigstens) eine Gruppe von M Paaren redundanter Bitleitungen BLred mit redundanten Speicherzellen MCred, M redundante Leseverstärker SAred und einen redundanten Bitschalterblock BKBSWred sowie einen Redundanz-Bitgruppendekoder BITDECred. Im Redundanzfall sind damit defekte Speicherzellen MC entlang einer Gruppe von M Paaren von Bitleitungen BL (samt den intakten Speicherzellen MC entlang derselben Paare von Bitleitungen BL) ersetzbar durch die Speicherzellen MCred entlang der Gruppe von M Paaren von redundanten Bitleitungen BLred. Die Anwahl der Gruppe von M Paaren der redundanten Bitleitungen BLred erfolgt dabei über die Redundanz-Leseverstärker SAred, den redundanten Bitschalterblock BKBSWred, über das Blockauswahlsignal BKSIG des Blockdekoders BDEC des auszuwählenden Speicherblockes $BK_v$ sowie über ein dem redundanten Bitschalterblock BKBSWred zugeordnetes redundantes Bitgruppen-Auswahlsignal BITSIGred des Redundanz-Bitgruppen-Dekoders BITDECred. Die M Paare von redundanten Bitleitungen BLred sind dabei über die Redundanz-Leseverstärker SAred und den Redundanz-Bitschalterblock BKBSWred mit den Leitungen des Gruppendatenbusses GPDB verbindbar.

Wie bereits eingangs erläutert, kann bislang ein Hersteller bekannter Halbleiterspeicher bekannte Paralleltestverfahren nicht dazu benutzen, defekte Speicherzellen MC dauerhaft durch redundante Speicherzellen MCred zu ersetzen, da ihm die bekannten Paralleltestverfahren keine Informationen über die Position der defekten Speicherzellen oder wenigstens einer Gruppe defekter Speicherzellen vermitteln können. Er muß also stets normale Einzeltests durchführen, dabei die Positionen aller defekten Speicherzellen ermitteln (über deren Adressen) und diese Informationen einem Reparaturautomaten zuführen, der dann über weitere Mittel und bekannte Algorithmen den Redundanzvorgang durchführt, d.h. als defekt erkannte Speicherzellen MC durch redundante Speicherzellen MCred ersetzt.

Die vorliegende Erfindung ermöglicht es jedoch in ihrer ersten Ausführungsform, die Position einer kompletten Gruppe von M Speicherzellen MC festzustellen, von denen mindestens eine Speicherzelle MC defekt ist. Dies geschieht über die Datenwerte der von extern angelegten Adressen ADR, die Identifikation (über einen Testautomaten) derjenigen I/O-Datenein-/ausgangsleitungen IO1, IO2, an der der Fehler festgestellt wird, und über einen dem Speicherhersteller bekannten Zuordnungsplan zwischen den extern anlegbaren Adressen ADR, den I/O-Datenein-/ausgangsleitungen IO1, IO2 und den einzelnen Gruppen von Speicherzellen MC. In der zweiten Ausführungsform ist darüber hinaus durch die zusätzliche Verwendung der I/O-Datenein-/ausgangsleitungen der dritten Art IO3 auch die Identifikation jeder einzelnen defekten Speicherzelle MC möglich, da noch mehr I/O-Datenein-/ausgangsleitungen zur Fehlererkennung zur Verfügung stehen (die Gesamtzahl der I/O-Datenein-/ausgangsleitungen IO1, IO2, IO3 = M.U).

Wenn nun die in Figur 24 gezeigten weiteren Ausführungsformen Paralleltesteinrichtungen PT gemäß einer der ersten beiden Ausführungsformen des Halbleiterspeichers aufweisen, so ist es damit erstmals möglich, mittels eines computergesteuerten Test- und Reparaturautomaten automatisch einen Halbleiterspeicher im Paralleltestverfahren (unter entsprechend großer Zeiterparnis) zu testen und anschließend daran die defekten Speicherzellen MC oder die Speicherzellengruppen, die wenigstens eine defekte Speicherzelle MC enthalten, durch redundante Speicherzellen MCred oder Speicherzellengruppen entlang redundanter Wortleitungen WLred oder Bitleitungen BLred zu ersetzen.

Dieses erfindungsgemäße Verfahren wird dann folgendermaßen durchgeführt: Zuerst werden alle Speicherzellen MC des in Chipform vorliegenden Halbleiterspeichers (meist noch auf dem Wafer) in der (vorstehend beschriebenen) Testbetriebsart getestet, d.h. jeweils mehrere Gruppen M Speicherzellen MC werden parallel zueinander getestet. in jedem Speicherzyklus, in dem an irgendeiner der I/O-Datenein-/ausgangsleitungen IO1, IO2, gegebenenfalls IO3 bzw. an den daran angeschlossenen (Hilfs-)Anschlußflächen PD, PDx, gegebenenfalls PDy durch den Testautomaten wenigstens ein Fehler erkannt wird, "notiert" dieser die gerade angelegten Adreßsignale ADR und diejenige(n) I/O-Datenein-/ausgangsleitung(en), an der der Fehler auftrat bzw. an denen die Fehler auftraten und identifiziert mit diesen Informationen über den obengenannten, beispielsweise im Testautomaten abgespeicherten Zuordnungsplan die defekte Speicherzellengruppe(n) bzw. Speicherzelle(n). Die so gewonnenen Daten werden im Testautomaten und/oder dem zugehörigen Computer abgespeichert.

Wenn dann der gesamte Halbleiterspeicher getestet ist, werden die Identifikationsdaten und der Zuordnungsplan dem Reparaturautomaten zugeführt, der unter Verwendung der Identifikationsdaten des Zuordnungsplanes, bekannter Algorithmen und weiterer an sich bekannter Mittel die Wortleitungen WL und/oder Gruppen von Paaren von Bitleitungen BL, entlang denen defekte Speicherzellengruppen (oder Speicherzellen) erkannt worden waren, durch redundante Wortleitungen WLred und/oder Gruppen von Paaren redundanter Bitleitungen BLred samt deren redundanten Speicherzellen MCred ersetzt. Das Ersetzen selbst ist beispielsweise unter dem Begriff "Laser fusing" bekannt.

## Patentansprüche

1. Integrierter Halbleiterspeicher mit einer Paralleltesteinrichtung (PT) und U Blockgruppen ($GP_{u=1...U}$), bei dem in einer Testbetriebsart mehrere Gruppen von M Speicherzellen (MC) gleichzeitig auf Funktion testbar sind, wobei jede Gruppe entlang einer jeweiligen Wortleitung (WL) innerhalb einer jeweiligen der U Blockgruppen ($GP_u$) angeordnet ist, und
   bei dem die dabei ausgelesenen Daten durch die Paralleltesteinrichtung (PT) auswertbar sind,
   **gekennzeichnet durch**
   folgende Merkmale:
   - die Paralleltesteinrichtung (PT) dient einem Einschreiben und einem Auswerten von in den Halbleiterspeicher einzuschreibenden und aus diesem auszulesenden Daten,
   - das Ergebnis der Auswertung liegt, für jede Gruppe von M Speicherzellen (MC) getrennt, an I/O-Datenleitungen (IO1, IO2, IO3) des Halbleiterspeichers an.

2. Integrierter Halbleiterspeicher nach Anspruch 1 mit folgenden Merkmalen:
   - jede Blockgruppe ($GP_u$) enthält V Speicherblöcke ($BK_{v=1...V}$) mit matrixförmig entlang von Wortleitungen (WL) und Bitleitungen (BL) angeordneten Speicherzellen (MC),
   - im Betrieb ist maximal ein Speicherblock ($BK_v$) je Blockgruppe ($GP_u$) auswählbar,
   - jeder Speicherblock ($BK_v$) enthält folgende Elemente:

- einen Blockdekoder (BDEC) zur Auswahl des jeweiligen Speicherblocks aus der Menge der Speicherblöcke (BK$_{1...V}$) seiner Blockgruppe (GP$_u$) in Abhängigkeit von ihm zugeführten Blockadressen (ADBK), wobei die Auswahl mittels eines Blockauswahlsignales (BKSIG) erfolgt,
- Wortleitungsdekoder (WLDEC) zur Auswahl der Wortleitungen (WL) in Abhängigkeit von Wortleitungsadressen (ADWL) und vom Blockauswahlsignal (BKSIG),
- Leseverstärker (SA), an die jeweils einerseits ein Paar der Bitleitungen (BL) und andererseits ein Paar von Verbindungsleitungen angeschlossen ist,
- Bitschalter (BSW) zu einer wahlweisen Verbindung des Paares von Verbindungsleitungen mit einem von M Paaren von Datenleitungen zum Lesen (BKDB-RD) und zum Schreiben (BKDB-WR) eines Blockdatenbusses (BKDB), wobei jeweils M Bitschalter (BSW) als Bitschalterblock (BKBSW) gemeinsam durch ein Bitgruppen-Auswahlsignal (BITSIG) ansteuerbar sind,
- die Bitgruppen-Auswahlsignale (BITSIG) sind Ausgangssignale eines Bitgruppendekoders (BITDEC), der von Bitgruppenadressen (ADBIT) angesteuert ist, wobei wenigstens ein Bitgruppendekoder (BITDEC) für alle Speicherblöcke (BK$_{1...V}$) vorgesehen ist,
- jedem Speicherblock (BK$_v$) einer Blockgruppe (GP$_u$) ist ein Blockdatenbus-Multiplexer (BKDBMX) zugeordnet, dem einerseits die Schreibdatenleitungen (BKDB-WR) und Lesedatenleitungen (BKDB-RD) des jeweiligen Blockdatenbusses (BKDB) zugeführt sind und der andererseits mit M Paaren von Datenleitungen zum Schreiben (GPDB-WR) und zum Lesen (GPDB-RD) eines Gruppendatenbusses (GPDB) verbunden ist, der alle Blockdatenbus-Multiplexer (BKDBMX) einer Blockgruppe (GP$_u$) miteinander verbindet,
- jeder Blockdatenbus-Multiplexer (BKDBMX) ist durch das Blockauswahlsignal (BKSIG) desjenigen Speicherblocks (BK$_v$) gesteuert, dem der Blockdatenbus-Multiplexer (BKDBMX) zugeordnet ist,
- die Paralleltesteinrichtung (PT) enthält folgende Komponenten:
  - je Blockgruppe (GP$_u$) ist eine Gruppenein-/ausgabeeinheit (GPIO) vorgesehen, die einerseits mit dem jeweiligen Gruppendatenbus (GPDB) verbunden ist und die andererseits mit einem Ein-/Ausgabedatenbus (IODB) verbunden ist,
  - alle Gruppenein-/ausgabeeinheiten (GPIO) der U Blockgruppen (GP$_{1...U}$) sind gemeinsam angesteuert durch wenigstens ein Testsignal (Test), durch wenigstens ein Steuersignal (WR, RD) für Schreiben und Lesen und durch einen Gruppenadreßbus (GPAD),
  - eine allen Blockgruppen (GP$_{1...U}$) zugeordnete Zellenfeldein-/ausgabeeinheit (MAIO), die eingangsmäßig mit den Ein-/Ausgabedatenbussen (IODB) aller Gruppendatenein-/ Ausgabeeinheiten (GPIO) verbunden ist und die ausgangsmäßig P I/O-Datenleitungen einer ersten Art (IO1) und (K-P) I/O-Datenleitungen einer zweiten Art (IO2) aufweist und die angesteuert ist durch das wenigstens eine Steuersignal (RD, WR) für Lesen und Schreiben, durch das Testsignal (Test) und durch einen I/O-Adreßbus (IOAD),
  - die I/O-Datenleitungen der ersten Art (IO1) sind wenigstens mittelbar mit solchen Anschlußflächen (PD) des Halbleiterspeichers verbunden, die über Anschlußvorrichtungen des in ein Gehäuse eingekapselten Halbleiterspeichers einem Anwender des Halbleiterspeichers elektrisch zugänglich sind,
  - die I/O-Datenleitungen der zweiten Art (IO2) sind lediglich auf dem Halbleiterchip selbst zugänglich, so daß sie dem Anwender des in das Gehäuse eingekapselten Halbleiterspeichers elektrisch unzugänglich sind,
- die Paralleltesteinrichtung (PT) enthält weiterhin wenigstens eine Steuereinheit (CONTROL) mit Eingängen für dem Halbleiterspeicher von extern zuführbare Adreßsignale (ADR) und Steuersignale ($\overline{RAS}$, $\overline{CAS}$, R/$\overline{W}$) und mit Ausgängen für die Blockadressen (ADBK), die Wortleitungsadressen (ADWL), die Bitgruppenadressen (ADBIT), das wenigstens eine Steuersignal zum Schreiben und Lesen (WR, RD), für das Testsignal (Test), den Gruppenadreßbus (GPAD) und für den I/O-Adreßbus (IOAD),
  - die Steuereinheit (CONTROL) generiert aus den extern zuführbaren Adreßsignalen (ADR) die Blockadressen (ADBK), die Wortleitungsadressen (ADWL), die Bitgruppenadressen (ADBIT), den Gruppenadreßbus (GPAD) und den I/O-Adreßbus (IOAD),
  - sie generiert aus den extern zuführbaren Steuersignalen ($\overline{RAS}$, $\overline{CAS}$, R/$\overline{W}$) das wenigstens eine Steuersignal zum Lesen und Schreiben (RD, WR),
  - sie generiert, insbesondere entsprechend der Norm "JEDEC Standard 21-B" des JEDEC-Committees aus den extern zuführbaren Adreßsignalen (ADR) und den Steuersignalen ($\overline{RAS}$, $\overline{CAS}$, R/$\overline{W}$) das Testsignal (Test), wobei der Halbleiterspeicher in der Testbetriebsart betreibbar ist, wenn das Testsignal (Test) aktiviert ist und ansonsten in einer Normalbetriebsart.

3. Integrierter Halbleiterspeicher nach Anspruch 2, **dadurch gekennzeichnet,** daß bei den Blockdatenbussen (BKDB) jeweils ein Paar von Datenleitungen zum Lesen (BKDB-RD) als separates Paar von Lesedatenleitungen ausgeführt ist und daß jeweils ein Paar von Datenleitungen zum Schreiben (BKDB-WR) als separates Paar von Schreibdatenleitungen ausgeführt ist.

4. Integrierter Halbleiterspeicher nach Anspruch 2, **dadurch gekennzeichnet,** daß bei den Blockdatenbussen (BKDB) jeweils ein Paar von Datenleitungen zum Schreiben (BKDB-WR) und ein Paar von Datenleitungen zum Lesen (BKDB-RD) als einziges, bidirektional betreibbares Paar von Datenleitungen ausgeführt ist.

5. Integrierter Halbleiterspeicher nach einem der Ansprüche 2 bis 4, **dadurch gekennzeichnet,** daß bei den Gruppendatenbussen (GPDB) jeweils ein Paar von Datenleitungen zum Schreiben (GPDB-WR) und ein Paar von Datenleitungen zum Lesen (GPDB-RD) als einziges, bidirektional betreibbares Paar von Datenleitungen ausgeführt ist.

6. Integrierter Halbleiterspeicher nach einem der Ansprüche 2 bis 4, **dadurch gekennzeichnet,** daß bei den Gruppendatenbussen (GPDB) jeweils ein Paar von Datenleitungen zum Schreiben (GPDB-WR) als separates Paar von Schreibdatenleitungen ausgeführt ist und daß jeweils ein Paar von Datenleitungen zum Lesen (GPDB-RD) als separates Paar von Lesedatenleitungen ausgeführt ist.

7. Integrierter Halbleiterspeicher nach einem der Ansprüche 2 bis 6, **dadurch gekennzeichnet,** daß die Blockadressen (ADBK) aus den extern zuführbaren Adreßsignalen (ADR) in einer Anzahl abgeleitet sind, daß mit ihnen die V Blockdekoder (BDEC) einer Blockgruppe ($GP_u$) adressierbar sind.

8. Integrierter Halbleiterspeicher nach einem der Ansprüche 2 bis 7, **dadurch gekennzeichnet,** daß die Wortleitungsadressen (ADWL) aus den extern zuführbaren Adreßsignalen (ADR) in einer Anzahl abgeleitet sind, daß mit ihnen alle Wortleitungen (WL) eines Speicherblocks ($BK_v$) adressierbar sind.

9. Integrierter Halbleiterspeicher nach einem der Ansprüche 2 bis 8, **dadurch gekennzeichnet,** daß die Bitgruppenadressen (ADBIT) aus den extern zuführbaren Adreßsignalen (ADR) in einer Anzahl abgeleitet sind, daß aus ihnen (A:M) Bitgruppen-Auswahlsignale (BITSIG) dekodierbar sind, wobei A gleich der Gesamtzahl der Paare von Bitleitungen (BL) eines Speicherblocks ($BK_v$) ist.

10. Integrierter Halbleiterspeicher nach einem der Ansprüche 2 bis 9, **dadurch gekennzeichnet,** daß ein Ein-/Ausgabedatenbus (IODB) genau ein Datenleitungspaar zum Schreiben und Lesen aufweist.

11. Integrierter Halbleiterspeicher nach einem der Ansprüche 2 bis 9, **dadurch gekennzeichnet,** daß ein Ein-/Ausgabedatenbus (IODB) ein Datenleitungspaar zum Schreiben (IODB-WR, $\overline{\text{IODB-WR}}$) und ein Datenleitungspaar zum Lesen (IODB-RD, $\overline{\text{IODB-RD}}$) aufweist.

12. Integrierter Halbleiterspeicher nach Anspruch 10 oder 11, **dadurch gekennzeichnet,** daß der Gruppenadreßbus (GPAD) M Gruppenadressignale ($GPAD_{m=1...M}$) enthält, von denen jeweils eines einen ersten logischen Zustand aufweist und die restlichen einen zweiten, dazu komplementären logischen Zustand aufweisen.

13. Integrierter Halbleiterspeicher nach Anspruch 12, **dadurch gekennzeichnet,** daß eine Gruppenein-/ausgabeeinheit (GPIO) eine Gruppensteuerschaltung (GPCTRL), eine Gruppenschreibeinheit (GPWR), eine Gruppenleseeinheit (GPRD) und eine Gruppentesteinheit (GPTest) enthält, daß die Gruppensteuerschaltung (GPCTRL) mit den M Gruppenadreßsignalen ($GPAD_m$) und dem Testsignal (Test) eingangsmäßig verbunden ist,
daß sie Ausgänge aufweist für M Gruppenadreßausgangssignale ($GPAD'_{m=1...M}$), die in der Testbetriebsart alle gemeinsam einen logischen Pegel aufweisen und die in der Normalbetriebsart die logischen Zustände der jeweiligen Gruppenadressignale ($GPAD_m$) aufweisen.

14. Integrierter Halbleiterspeicher nach Anspruch 13, **dadurch gekennzeichnet,** daß die Gruppensteuerschaltung (GPCTRL) M voneinander unabhängige ODER-Schaltungen (OR) enthält mit jeweils zwei Eingängen, an deren einen Eingängen gemeinsam das Testsignal (Test) anliegt, an deren anderen Eingängen das jeweilige Gruppenadreßsignal ($GPAD_m$) anliegt und deren Ausgänge die Ausgänge der Gruppensteuerschaltung (GPCTRL) sind.

15. Integrierter Halbleiterspeicher nach Anspruch 14, **dadurch gekennzeichnet,** daß eine ODER-Schaltung (OR) ein NOR-Gatter mit zwei Eingängen enthält und einen diesem nachgeschalteten Inverter.

16. Integrierter Halbleiterspeicher nach Anspruch 14 oder 15, **dadurch gekennzeichnet,** daß die Gruppenschreibeinheit (GPWR) zwei Demultiplexer (DMUXWR) enthält, die jeweils Eingänge für die Gruppenadreßausgangssignale (GPAD$_m$) der Gruppensteuerschaltung (GPCTRL) aufweisen sowie jeweils einen weiteren Eingang für eine der beiden Leitungen (IODB-WR, $\overline{\text{IODB-WR}}$) des Datenleitungspaares des Ein-/Ausgabedatenbusses (IODB), die dem Schreiben dienen, und die jeweils M Ausgänge aufweisen für Leitungen derjenigen M Paare von Leitungen des der Gruppenein-/ausgabeeinheit (GPIO) zugeordneten Gruppendatenbusses (GPDB), die zum Schreiben dienen (GPDB-WR$_{1...M}$; $\overline{\text{GPDB-WR}}_{1...M}$), wobei bei jedem Demultiplexer (DMUXWR) jeder der M Ausgänge genau einer der Eingänge für die Gruppenadreßausgangssignale (GPAD$'_{1...M}$) der Gruppensteuerschaltung (GPCTRL) zugeordnet ist, wobei bei jedem Demultiplexer (DMUXWR) in der Normalbetriebsart ein am weiteren Eingang anliegendes Datum auf denjenigen Ausgang durchgeschaltet ist, dessen ihm zugeordnetes Gruppenadreßausgangssignal (GPAD$'_m$) den ersten logischen Pegel des entsprechenden Gruppenadreßsignals (GPAD$_m$) aufweist und wobei bei jedem Demultiplexer (DMUXWR) in der Testbetriebsart das am jeweiligen weiteren Eingang anliegende Datum auf alle M Ausgänge durchgeschaltet ist.

17. Integrierter Halbleiterspeicher nach Anspruch 16, **dadurch gekennzeichnet,** daß jeder Demultiplexer (DMUXWR) M voneinander unabhängige UND-Schaltungen (AND) enthält mit jeweils zwei Eingängen, deren eine Eingänge gemeinsam mit der jeweiligen einen Leitung des Ein-/Ausgabedatenbusses (IODB) verbunden sind, die dem Schreiben dient, und deren andere Eingänge bei jedem Demultiplexer (DMUXWR) jeweils mit einem der Gruppenadreßausgangssignale (GPAD$'_{1...M}$) der Gruppensteuerschaltung (GPCTRL) verbunden sind.

18. Integrierter Halbleiterspeichder nach Anspruch 17, **dadurch gekennzeichnet,** daß wenigstens eine UND-Schaltung (AND) ein NAND-Gatter mit zwei Eingängen, die die Eingänge der UND-Schaltung (AND) sind, enthält und einen dem NAND-Gatter nachgeschalteten Inverter.

19. Integrierter Halbleiterspeicher nach einem der Ansprüche 13 bis 18, **dadurch gekennzeichnet,** daß die Gruppenleseeinheit (GPRD) zwei Multiplexer (MUXRD) enthält mit jeweils M Eingängen für Leitungen derjenigen M Paare von Leitungen des der Gruppenein-/Ausgabeeinheit (GPIO) zugeordneten Gruppendatenbusses (GPDB), die zum Lesen dienen (GPDB-RD$_{1...M}$; $\overline{\text{GPDB-RD}}_{1...M}$) sowie jeweils weitere Eingänge für die M Gruppenadreßausgangssignale (GPAD$'_{1...M}$) der Gruppensteuerschaltung (GPCTRL),
daß jeder Multiplexer (MUXRD) einen Ausgang (GPout1, GPout2) enthält,
daß jedes der Gruppenadreßausgangssignale (GPAD$'_{1...M}$) bei jedem Multiplexer (MUXRD) genau einem Paar der Leitungen (GPDB-RD$_{1...M}$, $\overline{\text{GPDB-RD}}_{1...M}$) des Gruppendatenbusses (GPDB) zugeordnet ist,
daß in der Normalbetriebsart durch die beiden Multiplexer (MUXRD) dasjenige Paar Datenleitungen (GPDB-RD$_1$, $\overline{\text{GPDB-RD}}_1$;...; GPDB-RD$_M$, $\overline{\text{GPBD-RD}}_M$) zum Lesen des Gruppendatenbusses (GPDB) auf die Ausgänge (GPout1, GPout2) durchgeschaltet ist, dessen ihm zugeordnetes Gruppenadreßausgangssignal (GPAD$'_m$) den ersten logischen Pegel des entsprechenden Gruppenadressignals (GPAD$_m$) aufweist, und
daß im Testbetrieb in dem Fall, in dem alle an einem jeweiligen Multiplexer (MUXRD) anliegenden Leitungen (GPDB-RD$_{1...M}$; $\overline{\text{GPDB-RD}}_{1...M}$) zum Lesen dasselbe Datum aufweisen, dieses an den Ausgang (GPout1; GPout2) des jeweiligen Multiplexers (MUXRD) geschaltet ist, so daß die Ausgänge (GPout1, GPout2) der beiden Multiplexer (MUXRD) zueinander komplementäre logische Pegel aufweisen, und daß ansonsten die Ausgänge (GPout1, GPout2) der Multiplexer (MUXRD) einen einander gleichen logischen Pegel aufweisen.

20. Integrierter Halbleiterspeicher nach Anspruch 19, **dadurch gekennzeichnet,** daß jeder Multiplexer (MUXRD) M NAND-Gatter mit jeweils zwei Eingängen enthält sowie ein weiteres NAND-Gatter mit M Eingängen, die jeweils mit dem Ausgang eines der M NAND-Gatter verbunden sind, daß der Ausgang des weiteren NAND-Gatters der Ausgang (GPout1; GPout2) des jeweiligen Multiplexers (MUXRD) ist, daß der eine Eingang jedes der M NAND-Gatter mit einer der Lesedatenleitungen (GPDB-RD$_{1...M}$; $\overline{\text{GPB-RD}}_{1...M}$) des Gruppendatenbusses (GPDB) verbunden ist und daß der andere Eingang jedes der M NAND-Gatter mit dem der jeweiligen Lesedatenleitung (GPDB-RD$_{1...M}$; $\overline{\text{GPDB-RD}}_{1...M}$) zugeordneten Gruppenadreßausgangssignal (GPAD$'_m$) beaufschlagt ist.

21. Integrierter Halbleiterspeicher nach Anspruch 19 oder 20, **dadurch gekennzeichnet,**
- daß die Gruppentesteinheit (GPTest) einen ersten (GPin1) und einen zweiten Eingang (GPin2) aufweist, der jeweils mit einem der beiden Ausgänge (GPout1; GPout2) der Gruppenleseeinheit (GPRD) verbunden ist,
- daß die Gruppentesteinheit (GPTest) einen dritten Eingang für das Testsignal (Test) aufweist und einen vierten Eingang für ein Vergleichsdatum (DCOMP) mit einem logischen Pegel,
- daß die Gruppentesteinheit (GPTest) zwei Ausgänge aufweist, die mit den Leseleitungen (IODB-RD, $\overline{\text{IODB-RD}}$) des Ein-/Ausgabedatenbusses (IODB) verbunden sind, und
- daß die Gruppentesteinheit (GPTest) folgende Funktion aufweist:
  - in der normalen Betriebsart liegt an den Ausgängen das jenige Signal an, das am jeweiligen Eingang (GPin1; GPin2) der ersten beiden Eingänge (GPin1, GPin2) anliegt,
  - in der Testbetriebsart liegen in dem einen Fall, in dem die mit den ersten beiden Eingängen (GPin1, GPin2) verbundenen Ausgänge (GPout1, GPout2) der Gruppenleseeinheit (GPRD) die zueinander komplementären logischen Pegel aufweisen, diese komplementären Pegel an den Ausgängen der Gruppentesteinheit (GPTest) an und in dem anderen Fall, in dem die mit den ersten beiden Eingängen (GPin1, GPin2) verbundenen Ausgänge (GPout1, GPout2) der Gruppenleseeinheit (GPRD) beide den einander gleichen logischen Pegel aufweisen, weist der eine der beiden Ausgänge der Gruppentesteinheit (GPTest) einen zum logischen Pegel des Vergleichsdatums (DCOMP) komplementären logischen Pegel auf, während der andere der beiden Ausgänge den logischen Pegel des Vergleichsdatums (DCOMP) aufweist.

22. Integrierter Halbleiterspeicher nach Anspruch 21, **dadurch gekennzeichnet,** daß die Gruppentesteinheit (GPTest) sechs NAND-Gatter (N1...N6) mit jeweils zwei Eingängen und einem Ausgang enthält sowie ein NOR-Gatter (NOR) mit drei Eingängen und einem Ausgang,
daß der eine Eingang des ersten NAND-Gatters (N1) der erste Eingang (GPin1) der Gruppentesteinheit (GPTest) ist,
daß der eine Eingang des vierten NAND-Gatters (N4) der zweite Eingang (GPin2) der Gruppentesteinheit (GPTest) ist,
daß der erste Eingang (GPin1) der Gruppentesteinheit (GPTest) über einen ersten Inverter (I1) sowohl mit dem anderen Eingang des vierten NAND-Gatters (N4) als auch mit dem ersten Eingang des NOR-Gatters (NOR) verbunden ist,
daß der zweite Eingang (GPin2) der Gruppentesteinheit (GPTest) über einen zweiten Inverter (I2) sowohl mit dem anderen Eingang des ersten NAND-Gatters (N1) als auch mit dem zweiten Eingang des NOR-Gatters (NOR) verbunden ist,
daß das Testsignal (Test) über einen dritten Inverter (I3) dem dritten Eingang des NOR-Gatters (NOR) zuführbar ist,
daß das Vergleichsdatum (DCOMP) dem einen Eingang des dritten NAND-Gatters (N3) und über einen vierten Inverter (I4) dem einen Eingang des zweiten NAND-Gatters (N2) zuführbar ist,
daß der Ausgang des NOR-Gatters (NOR) mit den anderen Eingängen des zweiten und dritten NAND-Gatters (N2, N3) verbunden ist,
daß die Ausgänge des ersten und des zweiten NAND-Gatters (N1, N2) mit den Eingängen des fünften NAND-Gatters (N5) verbunden sind,
daß die Ausgänge des dritten und des vierten NAND-Gatters (N3, N4) mit den Eingängen des sechsten NAND-Gatters (N6) verbunden sind und
daß die Ausgänge des fünften und des sechsten NAND-Gatters (N5, N6) die beiden Ausgänge der Gruppentesteinheit (GPTest) sind.

23. Integrierter Halbleiterspeicher nach Anspruch 21 oder 22, **gekennzeichnet** durch folgende Merkmale:
- die Zellenfeldein-/ausgabeeinheit (MAIO) enthält P Zellenfeldleseeinheiten (MARD) mit jeweils R Leseeinheiten (RDU1; RDU2), P Zellenfeldschreibeinheiten (MAWR), die jeweils einer der Zellenfeldleseeinheiten (MARD) zugeordnet sind und die jeweils R Schreibeinheiten (WRU1; WRU2) enthalten, sowie eine Zellenfeldsteuerschaltung (MACTRL),
- jede Zellenfeldleseeinheit (MARD) weist R Paare von Dateneingangsleitungen ($MARD_{p,r}$, $\overline{MARD}_{p,r}$) auf,
- jede Zellenfeldschreibeinheit (MAWR) weist R Paare von Datenausgangsleitungen ($MAWR_{p,r}$, $\overline{MAWR}_{p,r}$) auf, wobei p für jeweils R Paare konstant ist und p = 1...P, r = 1...R ist,
- für die Zahlen P, R, U gilt folgende Zuordnung: P.R = U,
- die Dateneingangsleitungen ($MARD_{p,r}$, $\overline{MARD}_{p,r}$) sind mit den Leseleitungen (IODB-RD, $\overline{\text{IODB-RD}}$)

der U Ein-/Ausgabedatenbusse (IODB) verbunden,
- die Datenausgangsleitungen (MAWR$_{p,r}$, $\overline{\text{MAWR}}_{p,r}$) sind mit den Schreibleitungen (IODB-WR, $\overline{\text{IODB-WR}}$) der U Ein-/Ausgabedatenbusse (IODB) verbunden,
- jede Zellenfeldleseeinheit (MARD) ist an einem Ausgang mit einer der I/O-Datenleitungen der ersten Art (IO1) und mit einem Dateneingang der ihr zugeordneten Zellenfeldschreibeinheit (MAWR) verbunden,
- jede Zellenfeldleseeinheit (MARD) hat weiterhin Ausgänge für (R-1) I/O-Datenleitungen der zweiten Art (IO2),
- alle Zellenfeldleseeinheiten (MARD) sind gemeinsam mit dem Lesesteuersignal (RD) beaufschlagt,
- alle Zellenfeldschreibeinheiten (MAWR) sind gemeinsam mit dem Schreibsteuersignal (WR) beaufschlagt,
- alle Zellenfeldleseeinheiten (MARD), alle Zellenfeldschreibeinheiten (MAWR) und die Zellenfeldsteuerschaltung (MACTRL) sind gemeinsam mit dem Testsignal (Test) beaufschlagt,
- alle Zellenfeldleseeinheiten (MARD) sind gemeinsam mit einem Zellenfeldleseadreßbus (MAADRD) verbunden,
- alle Zellenfeldschreibeinheiten (MAWR) sind gemeinsam mit einem Zellenfeldschreibadreßbus (MAADWR) verbunden,
- die Zellenfeldsteuerschaltung (MACTRL) ist eine Schaltung zum Generieren des Zellenfeldleseadreßbusses (MAADRD) und des Zellenfeldschreibadreßbusses (MAADWR) aus dem I/O-Adreßbus (IOAD) unter Steuerung durch das Testsignal (Test), wobei der Zellenfeldleseadreßbus (MAADRD) und der Zellenfeldschreibadreßbus (MAADWR) jeweils R Adreßleitungen (MAADRD$_{1...R}$; MAADWR$_{1...R}$) umfassen.

24. Integrierter Halbleiterspeicher nach Anspruch 23, **dadurch gekennzeichnet,** daß jeweils ein Paar von Dateneingangsleitungen (MARD$_{p,r}$, $\overline{\text{MARD}}_{p,r}$) und ein Paar von Datenausgangsleitungen (MAWR$_{p,r}$, $\overline{\text{MAWR}}_{p,r}$) als ein einziges Datenleitungspaar realisiert ist, das bidirektional betreibbar ist.

25. Integrierter Halbleiterspeicher nach Anspruch 23 oder 24, **dadurch gekennzeichnet,** daß die Zellenfeldsteuerschaltung (MACTRL) einen Lesedekoder (DECRD) und einen Schreibdekoder (DECWR) enthält, die beide in der Normalbetriebsart den I/O-Adreßbus (IOAD) auf den Zellenfeldleseadreßbus (MAADRD) und auf den Zellenfeldschreibadreßbus (MAADWR) durchschalten, daß in der Testbetriebsart vermittels des Lesedekoders (DECRD) und des Testsignals (Test) eine erste Leitung des Zellenfeldleseadreßbusses (MAADRD) einen konstanten logischen Pegel aufweist, während die restlichen Leitungen des Zellenfeldleseadreßbusses (MAADRD) einen zum logischen Pegel der ersten Leitung komplementären logischen Pegel aufweisen, der ebenfalls konstant ist und daß in der Testbetriebsart vermittels des Schreibdekoders (DECWR) und des Testsignals (Test) alle Leitungen des Zellenfeldschreibadreßbusses (MAADWR) einen konstanten logischen Pegel aufweisen.

26. Integrierter Halbleiterspeicher nach Anspruch 25, **dadurch gekennzeichnet,** daß der Lesedekoder (DECRD) eine ODER-Schaltung (OR) aufweist mit zwei Eingängen und einem Ausgang, wobei der eine Eingang mit dem Testsignal (Test) beaufschlagt ist, wobei der andere Eingang mit einer ersten Leitung des I/O-Adreßbusses (IOAD) verbunden ist und wobei der Ausgang mit der ersten Leitung des Zellenfeldleseadreßbusses (MAADRD) verbunden ist und daß der Lesedekoder (DECRD) (R-1) UND-Schaltungen (AND) aufweist mit jeweils zwei Eingängen und einem Ausgang, wobei jeweils der eine Eingang mit einem zum Testsignal (Test) komplementären Signal beaufschlagt ist, wobei jeder der anderen Eingänge mit einer der restlichen Leitungen des I/O-Adreßbusses (IOAD) verbunden ist und wobei jeder der Ausgänge mit einer der restlichen Leitungen des Zellenfeldleseadreßbusses (MAADRD) verbunden ist.

27. Integrierter Halbleiterspeicher nach Anspruch 25 oder 26, **dadurch gekennzeichnet,** daß der Schreibdekoder (DECWR) R ODER-Schaltungen (OR) enthält mit jeweils zwei Eingängen und einem Ausgang, wobei die einen Eingänge gemeinsam mit dem Testsignal (Test) beaufschlagt sind, wobei die anderen Eingänge mit dem I/O-Adreßbus (IOAD) verbunden sind und wobei die Ausgänge mit dem Zellenfeldschreibadreßbus (MAADWR) verbunden sind.

28. Integrierter Halbleiterspeicher nach Anspruch 26 oder 27, **dadurch gekennzeichnet,** daß eine ODER-Schaltung (OR) ein NOR-Gatter und einen diesem nachgeschalteten Inverter enthält.

29. Integrierter Halbleiterspeicher nach Anspruch 26, **dadurch gekennzeichnet,** daß eine UND-Schaltung (AND) ein NAND-Gatter und einen diesem nachgeschalteten Inverter enthält.

30. Integrierter Halbleiterspeicher nach einem der Ansprüche 23 bis 29, **dadurch gekennzeichnet,**
daß eine erste Leseeinheit (RDU1) jeder Zellenfeldleseeinheit (MARD) zwei Multiplexer (MUXRD) und eine Ausgangsstufe (OUTRD) enthält,
daß jeder Multiplexer (MUXRD) R erste Eingänge aufweist für jeweils eine Dateneingangsleitung ($MARD_{p,r}$; $\overline{MARD}_{p,r}$) der R Paare von Dateneingangsleitungen ($MARD_{p,r}$, $\overline{MARD}_{p,r}$) sowie R zweite Eingänge für den Zellenfeldleseadreßbus (MAADRD), dessen Leitungen den Dateneingangsleitungen ($MARD_{p,r}$; $\overline{MARD}_{p,r}$) zugeordnet sind, und einen Ausgang,
daß bei beiden Multiplexern (MUXRD) in der Normalbetriebsart diejenige der Dateneingangsleitungen ($MARD_{p,r}$; $\overline{MARD}_{p,r}$) auf den jeweiligen Ausgang durchgeschaltet ist, deren zugeordnete Leitung des Zellenfeldleseadreßbusses (MAADRD) den aktivierten Zustand aufweist,
daß bei beiden Multiplexern (MUXRD) in der Testbetriebsart diejenige der Dateneingangsleitungen ($MARD_{p,r}$, $\overline{MARD}_{p,r}$) auf den Ausgang durchgeschaltet ist, der die erste Leitung ($MAADRD_1$) des Zellenfeldleseadreßbusses (MAADRD) mit ihrem konstanten logischen Pegel zugeordnet ist und
daß die Ausgangsstufe (OUTRD) eine Treiberschaltung ist, deren Ausgang der mit einer der I/O-Datenleitungen der ersten Art (IO1) verbundene Ausgang der gesamten Zellenfeldleseeinheit (MARD) ist, der das am Ausgang des einen Multiplexers (MUXRD) anliegende Signal in verstärkter Form aufweist.

31. Integrierter Halbleiterspeicher nach Pnspruch 30, **dadurch gekennzeichnet,** daß jeder Multiplexer (MUXRD) der ersten Leseeinheit (RDU1) R NAND-Gatter mit jeweils zwei Eingängen aufweist, deren einer Eingang jeweils einer der R ersten Eingänge des Multiplexers (MUXRD) ist und deren anderer Eingang jeweils einer der R zweiten Eingänge des Multiplexers (MUXRD) ist,
daß jeder Multiplexer (MUXRD) der ersten Leseeinheit (RDU1) ein zusätzliches NAND-Gatter mit R Eingängen aufweist, die jeweils mit einem Ausgang der R NAND-Gatter verbunden sind und daß der Ausgang des zusätzlichen NAND-Gatters der Ausgang des jeweiligen Multiplexers (MUXRD) der ersten Leseeinheit (RDU1) ist.

32. Integrierter Halbleiterspeicher nach Anspruch 30 oder 31, **dadurch gekennzeichnet,** daß die Ausgangsstufe (OUTRD) zwei UND-Schaltungen (AND) aufweist mit jeweils drei Eingängen und einem Ausgang,
daß der jeweilige erste Eingang jeder UND-Schaltung (AND) mit dem Ausgang des jeweils einen Multiplexers (MUXRD) verbunden ist,
daß der zweite Eingang jeder UND-Schaltung (AND) mit dem Ausgang des jeweils anderen Multiplexers (MUXRD) über einen Inverter verbunden ist,
daß die dritten Eingänge der UND-Schaltungen (AND) mit dem Lesesteuersignal (RD) beaufschlagt sind und
daß die Ausgangsstufe (OUTRD) eine Endstufe aufweist, die eingangsmäßig mit den Ausgängen der UND-Schaltungen (AND) verbunden ist und deren Ausgang der Ausgang der Ausgangsstufe (OUTRD) und der ersten Leseeinheit (RDU1) ist.

33. Integrierter Halbleiterspeicher nach Anspruch 32, **dadurch gekennzeichnet,** daß wenigstens eine der UND-Schaltungen (AND) ein NAND-Gatter mit einem nachgeschalteten Inverter ist.

34. Integrierter Halbleiterspeicher nach einem der Ansprüche 30 bis 33, **dadurch gekennzeichnet,**
daß die restlichen (R-1) Leseeinheiten (RDU2) jeweils eine Ausgangsstufe (OUTRD) enthalten mit zwei Eingängen und einem Ausgang, der jeweils einer der Ausgänge für die (R-1) I/O-Datenleitungen der zweiten Art (IO2) ist,
daß jedem Eingang einer Ausgangsstufe (OUTRD) eine NAND-Schaltung mit zwei Eingängen vorgeschaltet ist, deren erster Eingang verbunden ist mit jeweils einer der beiden Dateneingangsleitungen ($\overline{MARD}_{p,2...R}$; $MARD_{p,2...R}$) der R Paare von Dateneingangsleitungen ($MARD_{p,r}$, $\overline{MARD}_{p,r}$) mit Ausnahme des ersten Paares ($\overline{MARD}_{p,1}$, $MARD_{p,1}$) dieser R Paare und deren zweiter Eingang mit dem Testsignal (Test) beaufschlagt ist,
daß in der Normalbetriebsart die Ausgänge der restlichen (R-1) Leseeinheiten (RDU2) hochohmig geschaltet sind, und
daß in der Testbetriebsart am Ausgang jeder der restlichen (R-1) Leseeinheiten (RDU2) das an der einen Dateneingangsleitung ($MARD_{p,2...R}$) des jeweiligen Paares von Dateneingangsleitungen ($MARD_{p,2...R}$, $\overline{MARD}_{p,2...R}$) anliegende Signal in verstärkter Form anliegt.

35. Integrierter Halbleiterspeicher nach Anspruch 34, **dadurch gekennzeichnet,** daß die Ausgangsstufen (OUTRD) der restlichen (R-1) Leseeinheiten (RDU2) gleich sind der Ausgangsstufe (OUTRD) der ersten Leseeinheit (RDU1) der jeweiligen Zellenfeldleseeinheit (MARD).

36. Integrierter Halbleiterspeicher nach einem der Ansprüche 23 bis 35,
    **gekennzeichnet durch** folgende Merkmale:
    - jede der P Zellenfeldschreibeinheiten (MAWR) ist an einem ersten Eingang mit einer der P I/O-Datenleitungen der ersten Art (IO1) verbunden und an einem zweiten Eingang mit dem Schreibsteuersignal (WR) beaufschlagt,
    - sie enthält weiterhin Eingänge für den Zellenfeld-Schreibadreßbus (MAADWR) und Ausgänge für die R Paare von Datenausgangsleitungen (MAWR$_{p,r}$, $\overline{MAWR}_{p,r}$),
    - in der Normalbetriebsart gibt sie ein in den Speicher einzuschreibendes, auf der jeweiligen I/O-Datenleitung der ersten Art (IO1) anliegendes Datum und ein dazu komplementäres Datum in Abhängigkeit vom Schreibsteuersignal (WR) und vom Zellenfeld-Schreibadreßbus (MAADWR) auf dasjenige Paar von Datenausgangsleitungen (MAWR$_{p,r}$, $\overline{MAWR}_{p,r}$) weiter, bezüglich dessen eine Leitung des Zellenfeld-Schreibadreßbusses (MAADWR) aktiviert ist,
    - in der Testbetriebsart gibt sie das an der I/O-Datenleitung der ersten Art (IO1) anliegende Datum und das dazu komplementäre Datum auf alle R Paare der Datenausgangsleitungen (MAWR$_{p,r}$, $\overline{MAWR}_{p,r}$) weiter.

37. Integrierter Halbleiterspeicher nach Anspruch 36, **gekennzeichnet durch** folgende Merkmale:
    - eine Zellenfeldschreibeinheit (MAWR) enthält zwei Demultiplexer (DMUXWR) und eine Eingangsstufe (INWR),
    - die Eingangsstufe (INWR) ist an einem ersten Eingang mit der jeweiligen I/O-Datenleitung der ersten Art (IO1) verbunden und an einem zweiten Eingang mit dem Schreibsteuersignal (WR) beaufschlagt,
    - die Eingangsstufe (INWR) leitet beim Einschreiben aus dem an der I/O-Datenleitung der ersten Art (IO1) anliegenden, einzuschreibenden Datum dasselbe Datum und das dazu komplementäre Datum ab und legt diese abgeleiteten Daten an zwei Ausgänge an,
    - jeder Demultiplexer (DMUXWR) enthält R UND-Schaltungen (AND) mit jeweils zwei Eingängen und einem Ausgang,
    - alle ersten Eingänge der UND-Schaltungen (AND) des einen Demultiplexers (DMUXWR) sind mit dem einen Ausgang der Eingangsstufe (INWR) verbunden und alle ersten Eingänge der UND-Schaltungen (AND) des anderen Demultiplexers (DMUXWR) sind mit dem anderen Ausgang der Eingangsstufe (INWR) verbunden,
    - die zweiten Eingänge der UND-Schaltungen (AND) beider Demultiplexer (DMUXWR) sind mit dem Zellenfeldschreibadreßbus (MAADWR) verbunden,
    - die Ausgänge der Demultiplexer (DMUXWR) sind mit den R Paaren von Datenausgangsleitungen (MAWR$_{p,r}$, $\overline{MAWR}_{p,r}$) verbunden.

38. Integrierter Halbleiterspeicher nach Anspruch 37, **dadurch gekennzeichnet,** daß eine Eingangsstufe (INWR) ein Buffer (BF) für das an der I/O-Datenleitung der ersten Art (IO1) anliegende Datum enthält und daß sie zwei UND-Schaltungen (AND) mit jeweils zwei Eingängen und einem Ausgang enthält, die dem Buffer (BF) nachgeschaltet sind, wobei der erste Eingang der einen UND-Schaltung (AND) mit einem Ausgang des Buffers (BF) verbunden ist, wobei der erste Eingang der anderen UND-Schaltung (AND) über einen Inverter mit dem Ausgang des Buffers (BF) verbunden ist und wobei die zweiten Eingänge der UND-Schaltungen (AND) mit dem Schreibsteuersignal (WR) beaufschlagt sind.

39. Integrierter Halbleiterspeicher nach Anspruch 37 oder 38, **dadurch gekennzeichnet,** daß wenigstens eine der UND-Schaltungen (AND) ein NAND-Gatter mit zwei Eingängen und einen dem NAND-Gatter nachgeschalteten Inverter enthält.

40. Integrierter Halbleiterspiecher nach einem der Ansprüche 2 bis 9,
    **dadurch gekennzeichnet,** daß ein Ein-/Ausgabedatenbus (IODB) N bidirektional betreibbare Datenleitungspaare zum Schreiben und Lesen aufweist, wobei N ein ganzzahliger Bruchteil von M ist.

41. Integrierter Halbleiterspeicher nach einem der Ansprüche 2 bis 9,
    **dadurch gekennzeichnet,** daß ein Ein-/Ausgabedatenbus (IODB) N Datenleitungspaare zum Lesen (IODB-RD$_{1...N}$, $\overline{IODB}_{1...N}$) und N Datenleitungspaare zum Schreiben (IODB-WR$_{1...N}$, $\overline{IODB-WR}_{1...N}$) aufweist, wobei N ein ganzzahliger Bruchteil von M ist.

**42.** Integrierter Halbleiterspeicher nach Anspruch 40 oder 41, **dadurch gekennzeichnet,** daß der Gruppenadreßbus (GPAD) Q Gruppenadreßsignale $(GPAD_{q=1...Q})$ enthält, von denen jeweils eines einen ersten logischen Zustand aufweist und die restlichen einen zweiten, dazu komplementären logischen Zustand, wobei Q.N = M gilt.

**43.** Integrierter Halbleiterspeicher nach einem der Ansprüche 40 bis 42, **dadurch gekennzeichnet,**
daß eine Gruppenein-/ausgabeeinheit (GPIO) eine Gruppensteuerschaltung (GPCTRL), N Gruppenschreibeinheiten (GPWR) und N Gruppenleseeinheiten (GPRD) enthält,
daß die Gruppensteuerschaltung (GPCTRL) mit den Q Gruppenadreßsignalen $(GPAD_{1...Q})$ und dem Testsignal (Test) eingangsmäßig verbunden ist,
daß sie Ausgänge aufweist für Q Gruppenadreßausgangssignale $(GPAD'_{q=1...Q})$, wobei in der Testbetriebsart das erste Gruppenadreßausgangssignal $(GPAD'_1)$ einen ersten logischen Pegel aufweist und die restlichen Gruppenadreßsignale $(GPAD'_{2...Q})$ einen zweiten logischen Pegel, der zum ersten logischen Pegel komplementär ist, und wobei in der Normalbetriebsart die Gruppenadreßausgangssignale $(GPAD'_{1...Q})$ die logischen Zustände der jeweiligen Gruppenadreßsignale $(GPAD_{1...Q})$ aufweisen.

**44.** Integrierter Halbleiterspeichernach Anspruch 43,
**dadurch gekennzeichnet,** daß die Gruppensteuerschaltung (GPCTRL) eine ODER-Schaltung (OR) und (Q-1) UND-Schaltungen (AND) enthält mit jeweils zwei Eingängen, daß am einen Eingang der ODER-Schaltung (OR) das erste $(GPAD_1)$ der Gruppenadreßsignale $(GPAD_{1...Q})$ anliegt,
daß an den einen Eingängen der UND-Schaltungen (AND) jeweils eines der restlichen $(GPAD_{2...Q})$ der Gruppenadreßsignale $(GPAD_{1...Q})$ anliegt,
daß am anderen Eingang der ODER-Schaltung (OR) das Testsignal (Test) anliegt,
daß an den anderen Eingängen der UND-Schaltungen (AND) ein zum Testsignal (Test) komplementäres Signal anliegt und daß die Ausgänge der ODER-Schaltung (OR) und der UND-Schaltungen (AND) die Ausgänge der Gruppensteuerschaltung (GPCTRL) sind.

**45.** Integrierter Halbleiterspeicher nach Anspruch 44, **dadurch gekennzeichnet,** daß die ODER-Schaltung (OR) ein NOR-Gatter enthält mit zwei Eingängen und einen diesem nachgeschalteten Inverter.

**46.** Integrierter Halbleiterspeicher nach Anspruch 44 oder 45, **dadurch gekennzeichnet,** daß wenigstens eine UND-Schaltung (AND) ein NAND-Gatter enthält mit zwei Eingängen und einen diesem nachgeschalteten Inverter.

**47.** Integrierter Halbleiterspeicher nach einem der Ansprüche 43 bis 46,
**gekennzeichnet** durch folgende Merkmale:
- eine Gruppenschreibeinheit (GPWR) weist ein Paar von Eingängen auf für ein Datenleitungspaar $(IODB\text{-}WR_n, \overline{IODB\text{-}WR_n})$ des Ein-/Ausgabedatenbusses (IODB), welches zum Schreiben dient,
- sie ist außerdem eingangsmäßig mit den Gruppenadreßausgangssignalen $(GPAD'_{1...Q})$ der Gruppensteuerschaltung (GPCTRL) verbunden,
- sie weist (Q-1) Gruppeneingangsstufen (GPINWR) auf mit je einem Eingang, der mit einer von (Q-1) I/O-Datenleitungen einer dritten Art (IO3) verbunden ist,
- sie weist einen weiteren Eingang für das Schreibsteuersignal (WR) auf,
- jede Gruppeneingangsstufe (GPINWR) leitet aus einem in den Speicher einzuschreibenden Datum, das über die jeweilige I/O-Datenleitung der dritten Art (IO3) an ihr anliegt, beim Einschreiben dasselbe Datum und ein dazu komplementäres Datum ab und legt diese abgeleiteten Daten an zwei Ausgänge,
- jedem Ausgang einer Gruppeneingangsstufe (GPINWR) ist eine logische Schaltung (LOGWR) mit zwei Eingängen nachgeschaltet, deren einer Eingang mit dem jeweiligen Ausgang der Gruppeneingangsstufe (GPINWR) verbunden ist und deren anderer Eingang mit dem Testsignal (Test) beaufschlagt ist,
- in der Normalbetriebsart liegt an den Ausgängen $(GPD_2, \overline{GPD_2}; ...; GPD_Q, \overline{GPD_Q})$ beider logischer Schaltungen (LOGWR) einer Gruppeneingangsstufe (GPINWR) ein Signal mit demselben logischen Pegel an, während in der Testbetriebsart am Ausgang $(GPD_{2...Q})$ der einen logischen Schaltung (LOGWR) das abgeleitete, komplementäre Datum und am Ausgang $(\overline{GPD_{2...Q}})$ der anderen logischen Schaltung (LOGWR) das abgeleitete Datum anliegt,
- jede Gruppenschreibeinheit (GPWR) enthält weiterhin zwei Demultiplexer (GPDMUXWR), von denen jeder Q Eingänge für die Gruppenadreßausgangssignale $(GPAD'_{1...Q})$ aufweist sowie einen weiteren Eingang, der einer der beiden Eingänge des Paares von Eingängen für das jeweilige, zum Schreiben vorgesehene Datenleitungspaar (IODB-WR$_n$, $\overline{\text{IODB-WR}_n}$) des Ein-/Ausgabedatenbusses (IODB) ist,

- darüber hinaus enthält jeder Demultiplexer (GPDMUXWR) (Q-1) zusätzliche Eingänge, von denen beim einen Demultiplexer (GPDMUXWR) jeder mit dem Ausgang (GPD$_{2,\dots,Q}$) der jeweiligen einen logischen Schaltung (LOGWR) verbunden ist und von denen beim anderen Demultiplexer (GPDMUXWR) jeder mit dem Ausgang ($\overline{\text{GPD}_{2,\dots,Q}}$) der jeweiligen anderen logischen Schaltung (LOGWR) verbunden ist,
- jeder Demultiplexer (GPDMUXWR) weist Q Ausgänge auf,
- die Ausgänge der Demultiplexer (GPDMUXWR) sind mit Q Paaren von Datenleitungen der M Paare von für Schreiben vorgesehenen Datenleitungen des Gruppendatenbusses (GPDB) verbunden,
- in der Normalbetriebsart leitet beim Schreiben jede Gruppenschreibeinheit (GPWR) die an dem mit ihr eingangsmäßig verbundenen Datenleitungspaar (IODB-WR$_n$, $\overline{\text{IODB-WR}_n}$) des Ein-/Ausgabedatenbusses (IODB) anliegenden Daten an diejenigen beiden Ausgänge durch, bezüglich derer eines der Gruppenadreßsignale (GPAD$_q$) und somit das diesem zugeordnete Gruppenadreßausgangssignal (GPAD'$_q$) der Gruppensteuerschaltung (CPCTRL) aktiviert ist,
- in der Testbetriebsart leitet beim Schreiben jede Gruppenschreibeinheit (GPWR) sowohl die an dem mit ihr eingangsmäßig verbundenen Datenleitungspaar (IODB-WR$_n$, $\overline{\text{IODB-WR}_n}$) des Ein-/Ausgabedatenbusses (IODB) anliegenden Daten als auch die aus den an ihren Gruppeneingangsstufen (GPINWR) anliegenden Daten der I/O-Datenleitungen der dritten Art (IO3) abgeleiteten Daten an einen jeweiligen Ausgang, und somit insgesamt auf einen Teil (N) des Gruppendatenbusses (GPDB).

48. Integrierter Halbleiterspeicher nach Anspruch 47, **gekennzeichnet** durch folgende Merkmale:
- jeder Demultiplexer (GPDMUXWR) enthält eine UND-Schaltung (AND) und (Q-1) logische Einheiten (LU), welche jeweils einen Ausgang aufweisen, der einer der Q Ausgänge des jeweiligen Demultiplexers (GPDMUXWR) ist,
- jede UND-Schaltung (AND) weist zwei Eingänge auf und jede logische Einheit (LU) weist drei Eingänge auf,
- die ersten Eingänge der UND-Schaltung (AND) und der logischen Einheiten (LU) jedes Demultiplexers (GPDMUXWR) sind mit dem einen weiteren Eingang des jeweiligen Demultiplexers (GPDMUXWR) verbunden,
- die zweiten Eingänge der UND-Schaltung (AND) und der logischen Einheiten (LU) der Demultiplexer (GPDMUXWR) sind mit jeweils einem der Q Eingänge des jeweiligen Demultiplexers (GPDMUXWR) verbunden,
- die dritten Eingänge der logischen Einheiten (LU) der Demultiplexer (GPDMUXWR) sind die zusätzlichen (Q-1) Eingänge des jeweiligen Demultiplexers (GPDMUXWR).

49. Integrierter Halbleiterspeicher nach Anspruch 48, **dadurch gekennzeichnet,** daß eine UND-Schaltung (AND) ein NAND-Gatter mit den beiden Eingängen der UND-Schaltung (AND) sowie einen diesem nachgeordneten Inverter enthält.

50. Integrierter Halbleiterspeicher nach Anspruch 48 oder 49, **dadurch gekennzeichnet,** daß eine logische Einheit (LU) ein erstes NAND-Gatter enthält mit zwei Eingängen, die die ersten beiden Eingänge der logischen Einheit (LU) sind,
daß dem ersten NAND-Gatter ein zweites NAND-Gatter mit ebenfalls zwei Eingängen zugeordnet ist, wobei der eine Eingang mit dem Ausgang des ersten NAND-Gatters verbunden ist und wobei der andere Eingang der dritte Eingang der logischen Einheit (LU) ist.

51. Integrierter Halbleiterspeicher nach einem der Ansprüche 47 bis 50, **dadurch gekennzeichnet,** daß eine Gruppeneingangsstufe (GPINWR) ein Buffer (BF) enthält zur Zwischenspeicherung des über die jeweilige I/O-Datenleitung der dritten Art (IO3) anliegenden Datums.

52. Integrierter Halbleiterspeicher nach einem der Ansprüche 47 bis 51, **dadurch gekennzeichnet,** daß eine Gruppeneingangsstufe (GPINWR) zwei UND-Schaltungen (AND) mit jeweils zwei Eingängen enthält, wobei dem einen Eingang der einen UND-Schaltung (AND) das an der jeweiligen I/O-Datenleitung der dritten Art (IO3) anliegende Datum zugeführt ist, wobei dem einen Eingang der anderen UND-Schaltung (AND) das an der jeweiligen I/O-Datenleitung der dritten Art (IO3) anliegende Datum in invertierter Form zugeführt ist, und wobei die anderen Eingänge der UND-Schaltungen (AND) mit dem Schreibsteuersignal (WR) beaufschlagt sind.

**53.** Integrierter Halbleiterspeicher nach einem der Ansprüche 43 bis 52,
**gekennzeichnet** durch folgende Merkmale:
- eine Gruppenleseeinheit (GPRD) weist Q Paare von Dateneingängen auf, die mit einer entsprechenden Anzahl von für Lesen vorgesehenen Datenleitungspaaren (GPDB-RD$_{n,1...Q}$, $\overline{\text{GPDB-RD}}_{n,1...Q}$) des jeweiligen Gruppendatenbusses (GPDB) verbunden sind,
- sie weist Adreßeingänge auf für die Gruppenadreßausgangssignale (GPAD'$_{1...Q}$) der Gruppensteuerschaltung (GPCTRL), wobei jedes Gruppenadreßausgangssignal (GPAD'$_{1,...,Q}$) einem der Q Paare von Dateneingängen zugordnet ist, sowie
- Eingänge für das Lesesteuersignal (RD) und für das Testsignal (Test),
- eine Gruppenleseeinheit (GPRD) weist weiterhin ein Paar von Ausgängen auf für ein Datenleitungspaar (IODB-RD$_n$, $\overline{\text{IODB-RD}}_n$) des Ein-/Ausgabedatenbusses (IODB), welches dem Lesen dient,
- außerdem weist sie (Q-1) Ausgänge auf, die mit den I/O-Datenleitungen der dritten Art (IO3) verbunden sind,
- in der Normalbetriebsart werden Daten desjenigen Paares der Q Paare von Dateneingängen, dessen ihm zugeordneter Adreßeingang den ersten logischen Pegel aufweist, den eines der Q Gruppenadreßsignale (GPAD$_{1...Q}$), und den somit auch eines der Q Gruppenadreßausgangssignale (GPAD'$_{1...Q}$) der Gruppensteuerschaltung (GPCTRL) aufweist, auf das mit dem einen Datenleitungspaar (IODB-RD$_n$, $\overline{\text{IODB-RD}}_n$) des Ein-/Ausgabedatenbusses (IODB) verbundene Paar von Ausgängen durchgeschaltet,
- in der Testbetriebsart werden am ersten Paar der Dateneingänge anliegende Daten auf das mit dem einen Datenleitungspaar (IODB-RD$_n$, IODB-RD$_n$) des Ein-/Ausgabedatenbusses (IODB) verbundene Paar von Ausgängen durchgeschaltet,
- außerdem werden in der Testbetriebsart die an den restlichen (Q-1) Dateneingängen anliegende Daten auf die mit den I/O-Datenleitungen der dritten Art (IO3) verbundenen (Q-1) Ausgänge durchgeschaltet.

**54.** Integrierter Halbleiterspeicher nach Anspruch 53, **gekennzeichnet** durch folgende Merkmale:
- eine Gruppenleseeinheit (GPRD) enthält zwei Multiplexer (GPMUXRD), 2.(Q-1) logische Einheiten (LOGRD) und (Q-1) Gruppenausgangsstufen (GPOUTRD),
- jeder Multiplexer (GPMUXRD) ist mit Q jeweiligen Datenleitungen (GPDB-RD$_{n,1...Q}$; $\overline{\text{GPDB-RD}}_{n,1...Q}$) aller Q für Lesen vorgesehen Datenleitungspaare (GPDB-RD$_{n,1...Q}$, $\overline{\text{GPDB-RD}}_{n,1...Q}$) eines Teils (N) des Gruppendatenbusses (GPDB) eingangsmäßig verbunden,
- er ist mit den Adreßeingängen der Gruppenleseeinheit (GPRD) für die Gruppenadreßausgangssignale (GPAD'$_{1...Q}$) der Gruppensteuerschaltung (GPCTRL) eingangsmäßig verbunden,
- er weist einen Ausgang auf, der als Ausgang der Gruppenleseeinheit (GPRD) mit einer (IODB-RD$_n$; $\overline{\text{IODB-RD}}_n$) der Leitungen des Datenleitungspaares (IODB-RD$_n$, $\overline{\text{IODB-RD}}_n$) des Ein-/Ausgabedatenbusses (IODB) verbunden ist,
- in der Normalbetriebsart wird dasjenige Datum auf den mit dem Ein-/Ausgabedatenbus (IODB) verbundenen Ausgang durchgeschaltet, das an der jeweiligen Datenleitung eines solchen Paares der Q Datenleitungspaare anliegt, dessen ihm zugeordnetes Gruppenadreßausgangssignale (GPAD'$_{1,...,Q}$) den ersten logischen Pegel aufweist,
- in der Testbetriebsart wird das an der jeweiligen Datenleitung (GPDB-RD$_{n,1}$; $\overline{\text{GPDB-RD}}_{n,1}$) des ersten Paares (GPDB-RD$_{n,1}$, $\overline{\text{GPDB-RD}}_{n,1}$) von Datenleitungen des Teils (N) des Gruppendatenbusses (GPDB) anliegende Datum auf den jeweiligen Ausgang durchgeschaltet.

**55.** Integrierter Halbleiterspeicher nach Anspruch 54, **dadurch gekennzeichnet,** daß eine logische Einheit (LOGRD) ein NAND-Gatter mit zwei Eingängen ist, daß jeweils zwei logische Einheiten (LOGRD) funktionell so zusammengefaßt sind, daß ihre ersten Eingänge mit einer jeweiligen Datenleitung (GPDB-RD$_{n,2...Q}$, $\overline{\text{GPDB-RD}}_{n,2...Q}$) eines der (Q-1) für Lesen vorgesehenen Datenleitungspaare (GPDB-RD$_{n,2...Q}$, GPDB-RD$_{n,2...Q}$) des Teils (N) des Gruppendatenbusses (GPDB) verbunden sind, daß ihre zweiten Eingänge mit dem Testsignal (Test) verbunden sind und daß ihre Ausgänge gleichzeitig Eingänge der ihr nachgeschalteten Gruppenausgangsstufe (GPOUTRD) sind.

**56.** Integrierter Halbleiterspeicher nach Anspruch 55, **gekennzeichnet** durch folgende Merkmale:
- eine Gruppenausgangsstufe (GPOUTRD) enthält zwei UND-Schaltungen (AND) mit je drei Eingängen und eine beiden UNDSchaltungen (AND) nachgeschaltete Endstufe,
- die ersten Eingänge der UND-Schaltungen (AND) sind über einen Inverter mit dem Ausgang einer jeweiligen logischen Einheit (LOGRD) verbunden,
- die zweiten Eingänge der UND-Schaltungen (AND) sind mit dem Ausgang der jeweils anderen logischen Einheit (LOGRD) verbunden,
- die dritten Eingänge sind mit dem Lesesteuersignal (RD) beaufschlagt,
- der Ausgang der Endstufe ist der Ausgang der Gruppenausgangsstufe (GPOUTRD) welcher gleichzeitig einer der (Q-1) Ausgänge der Gruppenleseeinheit (GPRD) ist.

57. Integrierter Halbleiterspeicher nach Anspruch 40 oder 41, **gekennzeichnet** durch folgende Merkmale:
- beim Halbleiterspeicher sind alle U Ein-/Ausgabedatenbusse (IODB) mit jeweils N Datenleitungspaaren zum Schreiben und Lesen mit ihren Datenleitungspaaren insgesamt eingeteilt in P Zellenfelddatenbusse (MADB) mit jeweils R Paaren von Datenausgangsleitungen zum Schreiben ($\overline{\text{MADB-WR}}_{1...P,1...R}$, $\overline{\text{MADB-WR}}_{1...P,1...R}$) und Dateneingangsleitungen zum Lesen ($\text{MADB-RD}_{1...P,1...R}$, $\overline{\text{MADB-RD}}_{1...P,1...R}$), wobei bezüglich der Gesamtanordnung gilt:
  U.N = P.R, mit N = M/Q,
- die Zellenfeldein-/ausgabeeinheit (MAIO) enthält P Zellenfeldleseeinheiten (MARD) mit jeweils R Leseeinheiten (RDU1; RDU2), P Zellenfeldschreibeinheiten (MAWR), die jeweils einer der P Zellenfeldleseeinheiten (MARD) zugeordnet sind und die jeweils R Schreibeinheiten (WRU1; WRU2) enthalten, sowie eine Zellenfeldsteuerschaltung (MACTRL),
- jede Zellenfeldleseeinheit (MARD) weist die R Paare von Dateneingangsleitungen ($\text{MADB-RD}_{p,r}$, $\overline{\text{MADB-RD}}_{p,r}$) eines der P Zellenfelddatenbusse (MADB) auf,
- jede Zellenfeldschreibeinheit (MAWR) weist die R Paare von Datenausgangsleitungen ($\text{MADB-WR}_{p,r}$, $\overline{\text{MADB-WR}}_{p,r}$) des Zellenfelddatenbusses (MADB) auf, wobei p = 1...P und r = 1...R ist,
- jede Zellenfeldleseeinheit (MARD) ist an einem Ausgang mit einer der I/O-Datenleitungen der ersten Art (IO1) und mit einem Dateneingang der ihr zugeordneten Zellenfeldschreibeinheit (MAWR) verbunden,
- jede Zellenfeldleseeinheit (MARD) hat weiterhin Ausgänge für (R-1) I/O-Datenleitungen der zweiten Art (IO2),
- alle Zellenfeldleseeinheiten (MARD) sind gemeinsam mit dem Lesesteuersignal (RD) beaufschlagt,
- alle Zellenfeldschreibeinheiten (MAWR) sind gemeinsam mit dem Schreibsteuersignal (WR) beaufschlagt,
- alle Zellenfeldleseeinheiten (MARD), alle Zellenfeldschreibeinheiten (MAWR) und die Zellenfeldsteuerschaltung (MACTRL) sind gemeinsam mit dem Testsignal (Test) beaufschlagt,
- alle Zellenfeldleseeinheiten (MARD) und alle Zellenfeldschreibeinheiten (MAWR) sind gemeinsam mit einem Zellenfeldadreßbus (MAAD) verbunden, so daß alle Zellenfeldleseeinheiten (MARD) und alle Zellenfeldschreibeinheiten (MAWR) jeweils gemeinsam betreibbar sind,
- die Zellenfeldsteuerschaltung (MACTRL) ist eine Schaltung zum Generieren des Zellenfeldadreßbusses (MAAD) aus dem I/O-Adreßbus (IOAD) unter Steuerung durch das Testsignal (Test), wobei der Zellenfeldadreßbus (MAAD) R Adreßleitungen ($\text{MAAD}_{1...R}$) umfaßt.

58. Integrierter Halbleiterspeicher nach Anspruch 57, **dadurch gekennzeichnet,** daß jeweils ein Paar von Dateneingangsleitungen ($\text{MADB-RD}_{p,r}$, $\overline{\text{MADB-RD}}_{p,r}$) und ein Paar von Datenausgangsleitungen ($\text{MADB-WR}_{p,r}$, $\overline{\text{MADB-WR}}_{p,r}$) als ein einziges Datenleitungspaar realisiert ist, das bidirektional betreibbar ist.

59. Integrierter Halbleiterspeicher nach Anspruch 57 oder 58, **dadurch gekennzeichnet,** daß die Zellenfeldsteuerschaltung (MACTRL) ein Dekoder ist, der in der Normalbetriebsart den I/O-Adreßbus (IOAD) auf den Zellenfeldadreßbus (MAAD) durchschaltet, und daß in der Testbetriebsart vermittels des Testsignals (Test) eine erste Leitung ($\text{MAAD}_1$) des Zellenfeldadreßbusses (MAAD) einen konstanten logischen Pegel aufweist, während die restlichen Leitungen des Zellenfeldadreßbusses (MAAD) einen zum logischen Pegel der ersten Leitung ($\text{MAAD}_1$) komplementären logischen Pegel aufweisen, der ebenfalls konstant ist.

60. Integrierter Halbleiterspeicher nach Anspruch 59, **dadurch gekennzeichnet,** daß die Zellenfeldsteuerschaltung (MACTRL) eine ODER-Schaltung (OR) aufweist mit zwei Eingängen und einem Ausgang, wobei der eine Eingang mit dem Testsignal (Test) beaufschlagt ist, wobei der andere Eingang mit einer ersten Leitung des I/O-Adreßbusses (IOAD) verbunden ist und wobei der Ausgang mit der ersten Leitung des Zellenfeldadreßbusses (MAAD) verbunden ist, und daß die Zellenfeldsteuerschaltung (MACTRL) (R-1) UND-Schaltungen (AND) aufweist mit jeweils zwei Eingängen und einem Ausgang, wobei jeweils der eine Eingang mit einem zum Testsignal (Test) komplementären Signal beaufschlagt ist, wobei jeder der anderen Eingänge mit einer der restlichen (R-1) Leitungen des I/O-Adreßbusses (IOAD) verbunden ist und wobei jeder der Ausgänge mit einer der restlichen (R-1) Leitungen des Zellenfeldadreßbusses (MAAD) verbunden ist.

61. Integrierter Halbleiterspeicher nach Anspruch 60, **dadurch gekennzeichnet, daß** die ODER-Schaltung (OR) ein NOR-Gatter und einen diesem nachgeschalteten Inverter enthält.

62. Integrierter Halbleiterspeicher nach Anspruch 60, **dadurch gekennzeichnet, daß** eine UND-Schaltung (AND) ein NAND-Gatter und einen diesem nachgeschalteten Inverter enthält.

63. Integrierter Halbleiterspeicher nach einem der Ansprüche 57 bis 62, **dadurch gekennzeichnet, daß** eine erste Leseeinheit (RDU1) jeder Zellenfeldleseeinheit (MARD) zwei Multiplexer (MUXRD) und eine Ausgangsstufe (OUTRD) enthält,
daß jeder Multiplexer (MUXRD) R erste Eingänge aufweist für jeweils eine Dateneingangsleitung ($\overline{\text{MADB-RD}}_{p,r}$; $\overline{\text{MADB-RD}}_{p,r}$) der R Paare von Dateneingangsleitungen (MADB-RD$_{p,r}$, $\overline{\text{MADB-RD}}_{p,r}$) sowie R zweite Eingänge für den Zellenfeldadreßbus (MAAD), dessen Leitungen den Dateneingangsleitungen (MADB-RD$_{p,r}$, $\overline{\text{MADB-RD}}_{p,r}$) zugeordnet sind, und einen Ausgang,
daß bei beiden Multiplexern (MUXRD) in der Normalbetriebsart diejenige der Dateneingangsleitungen (MADB-RD$_{p,r}$, $\overline{\text{MADB-RD}}_{p,r}$) auf den jeweiligen Ausgang durchgeschaltet ist, deren zugeordnete Leitung des Zellenfeldadreßbusses (MAAD) einen aktivierten elektrischen Zustand aufweist,
daß bei beiden Multiplexern (MUXRD) in der Testbetriebsart diejenige der Dateneingangsleitungen (MADB-RD$_{p,r}$, $\overline{\text{MADB-RD}}_{p,r}$) auf den Ausgang durchgeschaltet ist, der die erste Leitung (MAAD$_1$) des Zellenfeldadreßbusses (MAAD) mit ihrem konstanten logischen Pegel zugeordnet ist und
daß die Ausgangsstufe (OUTRD) eine Treiberschaltung ist, deren Ausgang der mit einer der I/O-Datenleitungen der ersten Art (IO1) verbundene Ausgang der gesamten Zellenfeldleseeinheit (MARD) ist und der das am Ausgang des einen Multiplexers (MUXRD) anliegende Signal in verstärkter Form aufweist.

64. Integrierter Halbleiterspeicher nach Anspruch 63, **dadurch gekennzeichnet, daß** jeder Multiplexer (MUXRD) der ersten Leseeinheit (RDU1) R NAND-Gatter mit jeweils zwei Eingängen aufweist, deren einer Eingang jeweils einer der R ersten Eingänge des Multiplexers (MUXRD) ist und deren anderer Eingang jeweils einer der R zweiten Eingänge des Multiplexers (MUXRD) ist,
daß jeder Multiplexer (MUXRD) der ersten Leseeinheit (RDU1) ein zusätzliches NAND-Gatter mit R Eingängen aufweist, die jeweils mit einem Ausgang der R NAND-Gatter verbunden sind, und daß der Ausgang des zusätzlichen NAND-Gatters der Ausgang des jeweiligen Multiplexers (MUXRD) der ersten Leseeinheit (RDU1) ist.

65. Integrierter Halbleiterspeicher nach einem der Ansprüche 63 oder 64, **dadurch gekennzeichnet, daß** die Ausgangsstufe (OUTRD) zwei UND-Schaltungen (AND) aufweist mit jeweils drei Eingängen und einem Ausgang,
daß der jeweilige erste Eingang jeder UND-Schaltung (AND) mit dem Ausgang des jeweils einen Multiplexers (MUXRD) verbunden ist,
daß der jeweilige zweite Eingang jeder UND-Schaltung (AND) mit dem Ausgang des jeweils anderen Multiplexers (MUXRD) über einen Inverter verbunden ist,
daß die dritten Eingänge der UND-Schaltungen (AND) mit dem Lesesteuersignal (RD) beaufschlagt sind und
daß die Ausgangsstufe (OUTRD) eine Endstufe aufweist, die eingangsmäßig mit den Ausgängen der UND-Schaltungen (AND) verbunden ist und deren Ausgang der Ausgang der Ausgangsstufe (OUTRD) und der ersten Leseeinheit (RDU1) ist.

66. Integrierter Halbleiterspeicher nach Anspruch 65, **dadurch gekennzeichnet, daß** wenigstens eine der UND-Schaltungen (AND) ein NAND-Gatter mit einem nachgeschalteten Inverter ist.

67. Integrierter Halbleiterspeicher nach einem der Ansprüche 63 bis 66, **dadurch gekennzeichnet, daß** die restlichen (R-1) Leseeinheiten (RDU2) jeweils eine Ausgangsstufe (OUTRD) enthalten mit zwei Eingängen und einem Ausgang, der jeweils einer der Ausgänge für die (R-1) I/O-Datenleitungen der zweiten Art (IO2) ist, daß jedem Eingang einer Ausgangsstufe (OUTRD) eine NAND-Schaltung mit zwei Eingängen vorgeschaltet ist, deren erster Eingang verbunden ist mit jeweils einer der beiden Dateneingangsleitungen ($\overline{\text{MADB-RD}}_{p,2...R}$, MADB-RD$_{p,2...R}$) eines der R Paare von Dateneingangsleitungen (MADB-RD$_{p,r}$, $\overline{\text{MADB-}}$

$\overline{RD}_{p,r}$) mit Ausnahme des ersten Paares (MADB-$RD_{p,1}$, $\overline{MADB\text{-}RD}_{p,1}$) dieser R Paare und deren zweiter Eingang mit dem Testsignal (Test) beaufschlagt ist,

daß in der Normalbetriebsart die Ausgänge der restlichen (R-1) Leseeinheiten (RDU2) hochohmig geschaltet sind und

daß in der Testbetriebsart am Ausgang jeder der restlichen (R-1) Leseeinheiten (RDU2) das an der einen Dateneingangsleitung (MADB-$RD_{p,2...R}$) des jeweiligen Paares von Dateneingangsleitungen (MADB-$RD_{p,2...R}$, $\overline{MADB\text{-}RD}_{p,2...R}$) anliegende Signal in verstärkter Form anliegt.

68. Integrierter Halbleiterspeicher nach Anspruch 67, **dadurch gekennzeichnet,** daß die Ausgangsstufen (OUTRD) der restlichen (R-1) Leseeinheiten (RDU2) gleich sind der Ausgangsstufe (OUTRD) der ersten Leseeinheit (RDU1) der jeweiligen Zellenfeldleseeinheit (MARD).

69. Integrierter Halbleiterspeicher nach einem der Ansprüche 57 bis 68,
**gekennzeichnet durch** folgende Merkmale:
- jede der P Zellenfeldschreibeinheiten (MAWR) ist an einem ersten Eingang mit einer der P I/O-Datenleitungen der ersten Art (IO1) verbunden und an einem zweiten Eingang mit dem Schreibsteuersignal (WR) beaufschlagt,
- sie enthält weiterhin dritte Eingänge für den Zellenfeldadreßbus (MAAD) und Ausgänge für die R Paare von Datenausgangsleitungen (MADB-$WR_{p,r}$, $\overline{MADB\text{-}WR}_{p,r}$),
- in der Normalbetriebsart gibt sie ein in den Speicher einzuschreibendes, auf der jeweiligen I/O-Datenleitung der ersten Art (IO1) anliegendes Datum und ein dazu komplementäres Datum in Abhängigkeit vom Schreibsteuersignal (WR) und vom Zellenfeldadreßbus (MAAD) auf das jenige Paar von Datenausgangsleitungen (MADB-$WR_{p,r}$, $\overline{MADB\text{-}WR}_{p,r}$) weiter, bezüglich dessen eine Leitung des Zellenfeldadreßbusses (MAAD), und somit eine Leitung des I/O-Adreßbusses (IOAD), aktiviert ist,
- in der Testbetriebsart gibt sie das an der I/O-Datenleitung der ersten Art (IO1) anliegende Datum und das dazu komplementäre Datum auf alle R Paare von Datenausgangsleitungen (MADB-$WR_{p,r}$, $\overline{MADB\text{-}WR}_{p,r}$) weiter.

70. Integrierter Halbleiterspeicher nach Anspruch 69, **gekennzeichnet durch** folgende Merkmale:
- eine Zellenfeldschreibeinheit (MAWR) enthält zwei Demultiplexer (DMUXWR) und eine Eingangsstufe (INWR),
- die Eingangsstufe (INWR) ist an einem ersten Eingang mit der jeweiligen I/O-Datenleitung der ersten Art (IO1) verbunden und an einem zweiten Eingang mit dem Schreibsteuersignal (WR) beaufschlagt,
- die Eingangsstufe (INWR) leitet aus dem an der I/O-Datenleitung der ersten Art (IO1) anliegenden, einzuschreibenden Datum dasselbe Datum und das dazu komplementäre Datum ab und legt diese abgeleiteten Daten an zwei Ausgänge an,
- jeder Demultiplexer (DMUXWR) enthält R UND-Schaltungen (AND) mit jeweils zwei Eingängen und einem Ausgang,
- alle ersten Eingänge der UND-Schaltungen (AND) des einen Demultiplexers (DMUXWR) sind mit dem einen Ausgang der Eingangsstufe (INWR) verbunden und alle ersten Eingänge der UND-Schaltungen (AND) des anderen Demultiplexers (DMUXWR) sind mit dem anderen Ausgang der Eingangsstufe (INWR) verbunden,
- die zweiten Eingänge der UND-Schaltungen (AND) beider Demultiplexer (DMUXWR) sind mit dem Zellenfeldadreßbus (MAAD) verbunden,
- die Ausgänge der Demultiplexer (DMUXWR) sind mit den R Paaren von Datenausgangsleitungen (MADB-$WR_{p,r}$, $\overline{MADB\text{-}WR}_{p,r}$) verbunden.

71. Integrierter Halbleiterspeicher nach Anspruch 70, **dadurch gekennzeichnet,** daß eine Eingangsstufe (INWR) ein Buffer (BF) für das an der I/O-Datenleitung der ersten Art (IO1) anliegende Datum enthält und daß sie zwei UNDSchaltungen (AND) mit jeweils zwei Eingängen und einem Ausgang enthält, die dem Buffer (BF) nachgeschaltet sind, wobei der erste Eingang der einen UND-Schaltung (AND) mit einem Ausgang des Buffers (BF) verbunden ist, wobei der erste Eingang der anderen UND-Schaltung (AND) über einen Inverter mit dem Ausgang des Buffer (BF) verbunden ist und wobei die zweiten Eingänge der UND-Schaltungen (AND) mit dem Schreibsteuersignal (WR) beaufschlagt sind.

72. Integrierter Halbleiterspeicher nach einem der Ansprüche 69 bis 71, **dadurch gekennzeichnet,** daß wenigstens eine der UND-Schaltungen (AND) ein NAND-Gatter mit zwei Eingängen und einen dem NAND-Gatter nachgeschalteten Inverter enthält.

73. Integrierter Halbleiterspeicher nach einem der Ansprüche 57 bis 68,
    **gekennzeichnet durch** folgende Merkmale:
    - jede der P Zellenfeldschreibeinheiten (MAWR) ist an einem ersten Eingang mit einer der P I/O-Datenleitungen der ersten Art (IO1) verbunden,
    - sie ist an weiteren (R-1) ersten Eingängen mit jeweils einer der I/O-Datenleitungen der zweiten Art (IO2) verbunden,
    - ein zweiter Eingang ist mit dem Schreibsteuersignal (WR) beaufschlagt,
    - sie enthält weiterhin dritte Eingänge für den Zellenfeldadreßbus (MAAD) und Ausgänge für die R Paare von Datenausgangsleitungen ($MADB\text{-}WR_{p,r}$, $\overline{MADB\text{-}WR_{p,r}}$) eines der Zellenfelddatenbusse (MADB),
    - in der Normalbetriebsart gibt sie ein in den Speicher einzuschreibendes, auf der jeweiligen I/O-Datenleitung der ersten Art (IO1) anliegendes Datum und ein dazu komplementäres Datum in Abhängigkeit vom Schreibsteuersignal (WR) und vom Zellenfeldadreßbus (MAAD) auf dasjenige Paar von Datenausgangsleitungen ($MADB\text{-}WR_{p,r}$, $\overline{MADB\text{-}WR_{p,r}}$) weiter, bezüglich dessen eine Leitung des I/O-Adreßbusses (IOAD), und somit eine Leitung des Zellenfeldadreßbusses (MAAD), aktiviert ist,
    - in der Testbetriebsart gibt sie zum einen das an der I/O-Datenleitung der ersten Art (IO1) und das dazu komplementäre Datum auf das erste Paar ($MADB\text{-}W_{p,1}$, $\overline{MADB\text{-}WR_{p,1}}$) der R Paare von Datenausgangsleitungen ($MADB\text{-}WR_{p,r}$, $\overline{MADB\text{-}WR_{p,r}}$) weiter,
    - zum anderen gibt sie in der Testbetriebsart an den weiteren (R-1) ersten Eingängen anliegende Daten und ein jeweils dazu komplementäres Datum auf ein jeweiliges Paar ($MADB\text{-}WR_{p,2,...,R}$, $\overline{MAWR_{p,2,...,R}}$ der restlichen (R-1) Paare von Datenausgangsleitungen ($MADB\text{-}WR_{p,2...R}$, $\overline{MADB\text{-}WR_{p,2...R}}$) der R Paare von Datenausgangsleitungen ($MADB\text{-}WR_{p,r}$, $MADB\text{-}WR_{p,r}$) weiter.

74. Integrierter Halbleiterspeicher nach Anspruch 73, **gekennzeichnet durch** folgende Merkmale:
    - eine Zellenfeldschreibeinheit (MAWR) enthält zwei Demultiplexer (DMUXWR) und R Eingangsstufen (INWR),
    - die erste der Eingangsstufen (INWR) ist an einem ersten Eingang mit der I/O-Datenleitung der ersten Art (IO1) verbunden, welche beim Einschreiben mit einem einzuschreibenden Datum beaufschlagt ist,
    - die restlichen (R-1) Eingangsstufen (INWR) sind an einem jeweiligen ersten Eingang mit einer jeweiligen I/O-Datenleitung der zweiten Art (IO2) verbunden, welche beim Einschreiben mit einem jeweiligen einzuschreibenden Datum beaufschlagt ist,
    - jede Eingangsstufe (INWR) ist an einem zweiten Eingang mit dem Schreibsteuersignal (WR) beaufschlagt,
    - jede Eingangsstufe (INWR) weist zwei Ausgänge auf,
    - am einen Ausgang liegt bei aktiviertem Schreibsteuersignal (WR) das an ihrem ersten Eingang anliegende Datum an,
    - am anderen Ausgang liegt bei aktiviertem Schreibsteuersignal (WR) das zu diesem Datum komplementäre Datum an,
    - bei jeder der (R-1) restlichen Eingangsstufen (INWR) ist ihren beiden Ausgängen jeweils eine logische Schaltung (LOGWR) nachgeschaltet mit zwei Eingängen und einem Ausgang ($MAD_{2,...,R}$; $\overline{MAD_{2,...,R}}$), deren einer Eingang mit dem jeweiligen der beiden Ausgänge der Eingangsstufe (INWR) verbunden ist und deren anderer Eingang mit dem Testsignal (Test) beaufschlagt ist,
    - in der Normalbetriebsart liegt an den Ausgängen ($MAD_{2,...,R}$, $\overline{MAD_{2,...,R}}$) aller den (R-1) restlichen Eingangsstufen (INWR) nachgeschalteten logischen Schaltungen (LOGWR) ein Signal mit einem einander gleichen logischen Pegel an, während in der Testbetriebsart bezüglich jeder der (R-1) restlichen Eingangsstufen (INWR) am Ausgang ($MAD_{2,...,R}$; $\overline{MAD_{2,...,R}}$) der einen logischen Schaltung (LOGWR) das jeweils komplementäre Datum und am Ausgang ($\overline{MAD_{2,...,R}}$; $MAD_{2,...,R}$) der anderen logischen Schaltung (LOGWR) das jeweilige einzuschreibende Datum anliegt,
    - jeder Demultiplexer (DMUXWR) enthält eine UND-Schaltung (AND) mit zwei Eingängen und (R-1) logische Einheiten (LU) mit drei Eingängen sowie R Ausgänge,
    - beim einen Demultiplexer (DMUXWR) sind der erste Eingang der UND-Schaltung (AND) und die ersten Eingänge der logischen Einheiten (LU) mit dem einen Ausgang der ersten Eingangsstufe (INWR) verbunden,
    - beim anderen Demultiplexer (DMUXWR) sind der erste Eingang der UND-Schaltung (AND) und die ersten Eingänge der logischen Einheiten (LU) mit dem anderen Ausgang der ersten Eingangsstufe (INWR) verbunden,
    - bei beiden Demultiplexern (DMUXWR) sind die zweiten Eingänge der UND-Schaltungen (AND) und die zweiten Eingänge der logischen Einheiten (LU) mit einer jeweiligen Leitung (MAAD$_{1,...,R}$) des Zellenfeldadreßbusses (MAAD) verbunden,

- beim einen Demultiplexer (DMUXWR) sind die dritten Eingänge der logischen Einheiten (LU) mit dem Ausgang (MAD$_{2,...,R}$) der einen einer jeweiligen der restlichen (R-1) Eingangsstufen (INWR) nachgeschalteten logischen Schaltung (LOGWR) verbunden,
- beim anderen Demultiplexer (DMUXWR) sind die dritten Eingänge der logischen Einheiten (LU) mit dem Ausgang ($\overline{\text{MAD}}_{2,...,R}$) der anderen einer jeweiligen der restlichen (R-1) Eingangsstufen (INWR) nachgeschalteten logischen Schaltung (LOGWR) verbunden,
- jeder Demultiplexer (DMUXWR) weist R Ausgänge auf, die insgesamt die Ausgänge der Zellenfeldschreibeinheit (MAWR) sind.

75. Integrierter Halbleiterspeicher nach Anspruch 74, **dadurch gekennzeichnet,** daß eine Eingangsstufe (INWR) ein Buffer (BF) für das an der I/O-Datenleitung der jeweiligen Art (IO1; IO2) anliegende Datum enthält und daß sie zwei UND-Schaltungen (AND) mit jeweils zwei Eingängen und einem Ausgang enthält, die dem Buffer (BF) nachgeschaltet sind, wobei der erste Eingang der einen UND-Schaltung (AND) mit einem Ausgang des Buffers (BF) verbunden ist, wobei der erste Eingang der anderen UND-Schaltung (AND) über einen Inverter mit dem Ausgang des Buffers (BF) verbunden ist, und wobei die zweiten Eingänge der UND-Schaltungen (AND) mit dem Schreibsteuersignal (WR) beaufschlagt sind.

76. Integrierter Halbleiterspeicher nach Anspruch 74 oder 75, **dadurch gekennzeichnet,** daß wenigstens eine der UND-Schaltungen (AND) ein NAND-Gatter mit zwei Eingängen und einen dem NAND-Gatter nachgeschalteten Inverter enthält.

77. Integrierter Halbleiterspeicher nach einem der vorhergehenden Ansprüche, **dadurch gekennzeichnet,** daß er wenigstens eine redundante Wortleitung (WLred) mit redundanten Speicherzellen (MCred) enthält, die im Redundanzfall über einen redundanten Wortleitungsdekoder (WLDECred) auswählbar ist, und daß im Redundanzfall die redundanten Speicherzellen (MCred) über die Leseverstärker (SA) und Bitschalter (BSW) der ersetzten Speicherzellen (MC) mit den entsprechenden Leitungen des Blockdatenbusses (BKDB) verbindbar sind.

78. Integrierter Halbleiterspeicher nach einem der vorhergehenden Ansprüche, **dadurch gekennzeichnet,** daß er wenigstens eine Gruppe von M Paaren redundanter Bitleitungen (BLred) mit redundanten Speicherzellen (MCred), M redundante Leseverstärker (SAred) und einen redundanten Bitschalterblock (BKBSWred) enthält, die im Redundanzfall über einen Redundanz-Bitgruppendekoder (BITDECred) samt zugehörigem redundanten Bitgruppen-Auswahlsignal (BITSIGred) auswählbar ist und die mit den entsprechenden Leitungen des Blockdatenbusses (BKDB) verbindbar ist.

79. Verfahren zum Ersetzen von Speicherzellen (MC) durch redundante Speicherzellen (MCred) bei einem Halbleiterspeicher nach Anspruch 77 oder 78, bei dem ein computergesteuerter Test- und Reparaturautomat verwendet wird, der Algorithmen und Mittel zum Ersetzen der Speicherzellen (MC) enthält, **dadurch gekennzeichnet,** daß alle Speicherzellen (MC) des Halbleiterspeichers in der Testbetriebsart getestet werden, daß bei jedem erkannten Fehler jede defekte Speicherzellengruppe (MC) über ihre von extern angelegte Adresse (ADR) und die jeweilige I/O-Datenleitung (IO1, IO2, IO3), an der der Fehler erkannt wird, mittels der Paralleltesteinrichtung (PT) und des Testautomaten innerhalb des Halbleiterspeichers identifiziert wird, und daß die so gewonnenen Identifikationsdaten für alle defekten Speicherzellengruppen dem Reparaturautomaten zugeführt werden, der daraufhin unter Verwendung der Identifikationsdaten die Speicherzellengruppen mit defekten Speicherzellen (MC) ersetzt.

80. Verfahren zum Ersetzen von Speicherzellen (MC) durch redundante Speicherzellen (MCred) bei einem Halbleiterspeicher nach Anspruch 77 oder 78, bei dem ein computergesteuerter Test- und Reparaturautomat verwendet wird, der Algorithmen und Mittel zum Ersetzen der Speicherzellen (MC) enthält, **dadurch gekennzeichnet,** alle Speicherzellen (MC) des Halbleiterspeichers in der Testbetriebsart getestet werden, daß bei jedem erkannten Fehler jede defekte Speicherzelle (MC) über ihre von extern angelegte Adresse (ADR) und die jeweilige I/O-Datenleitung (IO1, IO2, IO3), an der der Fehler erkannt wird, mittels der Paralleltesteinrichtung (PT) und des Testautomaten innerhalb des Halbleiterspeichers identifiziert wird, und daß die so gewonnenen Identifikationsdaten für alle defekten Speicherzellen (MC) dem Reparaturautomaten zugeführt werden, der daraufhin unter Verwendung der Identifikationsdaten die defekten Speicherzellen (MC) ersetzt.

## Claims

1.  Integrated semiconductor memory having a parallel test device (PT) and U block groups ($GP_{u=1...U}$), in which, in a test mode, several groups of M memory cells (MC) can be simultaneously tested for operation, each group being arranged along a respective word line (WL) within one respective one of the U block groups ($GP_u$), and
    in which the data read out during this process can be evaluated by the parallel test device (PT), which is characterised by the following features:
    - the parallel test device (PT) is used for writing in and evaluating data to be written into the semiconductor memory and to be read out of it,
    - the result of the evaluation is present, separately for each group of M memory cells (MC), on I/O data lines (IO1, IO2, IO3) of the semiconductor memory.

2.  Integrated semiconductor memory according to Claim 1, having the following features:
    - each block group ($GP_u$) contains V memory blocks ($BK_{v=1...V}$) with memory cells (MC) arranged in matrix form along word lines (WL) and bit lines (BL),
    - in operation, a maximum of one memory block ($BK_v$) per block group ($GP_u$) can be selected,
    - each memory block ($BR_v$) contains the following elements:
        - a block decoder (BDEC) for selecting the respective memory block from the set of memory blocks ($BK_{1...V}$) of its block group ($GP_u$) as a function of block addresses (ADBK) supplied to it, the selection being effected by means of a block selection signal (BKSIG),
        - word line decoders (WLDEC) for selecting the word lines (WL) as a function of word line addresses (ADWL) and of the block selection signal (BKSIG),
        - read amplifiers (SA), to which in each case a pair of bit lines (BL), on the one hand, and, on the other hand, a pair of connecting lines are connected,
        - bit switches (BSW) for an optional connection of the pair of connecting lines to one of M pairs of data lines for reading (BKDB-RD) and for writing (BKDB-WR) of a block databus (BKDB), in each case M bit switches (BSW) being jointly capable of activation as a bit switch block (BKBSW) by a bit group selection signal (BITSIG),
        - the bit group selection signals (BITSIG) are output signals of a bit group decoder (BITDEC) which is activated by bit group addresses (ADBIT), at least one bit group decoder (BITDEC) being provided for all memory blocks ($BK_{1...V}$),
    - each memory block ($BK_v$) of a block group ($GP_u$) is associated with a block databus multiplexer (BKDBMX) which is supplied, on the one hand, with the write data lines (BKDB-WR) and read data lines (BKDB-RD) of the respective block databus (BKDB) and which is connected, on the other hand, to M pairs of data lines for writing (GPDB-WR) and for reading (GPDB-RD) of a group databus (GPDB) which connects all block databus multiplexers (BKDBMX) of a block group ($GP_u$) with one another,
    - each block databus multiplexer (BKDBMX) is controlled by the block selection signal (BKSIG) of the memory block (BKv) associated with the block databus multiplexer (BKDBMX),
    - the parallel test device (PT) contains the following components:
        - for each block group ($GP_u$) a group input/output unit (GPIO) is provided which is connected, on the one hand, to the respective group databus (GPDB) and which is connected, on the other hand, to an input/output databus (IODB),
        - all group input/output units (GPIO) of the U block groups ($GP_{1...U}$) are jointly activated by at least one test signal (Test), by at least one control signal (WR, RD) for writing and reading and by a group address bus (GPAD),
        - a memory array input/output unit (MAIO) associated with all U block groups ($GP_{1...U}$), whose input is connected to the input/output databuses (IODB) of all the group data input/output units (GPIO) and whose output has P I/O data lines of the first type (IO1) and (K - P) I/O data lines of a second type (IO2) and which is activated by the at least one control signal (RD, WR) for reading and writing, by the test signal (Test) and by an I/O address bus (IOAD),
        - the I/O data lines of the first type (IO1) are connected at least indirectly to those pads (PD) of the semiconductor memory which are electrically accessible to a user of the semiconductor memory via connecting devices of the semiconductor memory encapsulated in a case,
        - the I/O data lines of the second type (IO2) are accessible only on the semiconductor chip itself so that they are electrically inaccessible to the user of the semiconductor memory encapsulated in the case,
        - the parallel test device (PT) furthermore contains at least one control unit (CONTROL) having inputs for address signals (ADR) and control signals ($\overline{RAS}$, $\overline{CAS}$, R/$\overline{W}$), which can be supplied to the semiconductor memory from outside, and having outputs for the block addresses (ADBK), the word line addresses (ADWL), the bit group addresses (ADBIT), the at least one control signal for writing and reading (WR, RD), for the test signal (Test), the group address bus (GPAD) and for the I/O address bus (IOAD),

- from the externally suppliable address signals (ADR), the control unit (CONTROL) generates the block addresses (ADBK), the word line addresses (ADWL), the bit group addresses (ADBIT), the group address bus (GPAD) and the I/O address bus (IOAD),
- from the externally suppliable control signals ($\overline{RAS}$, $\overline{CAS}$, R/$\overline{W}$), it generates the at least one control signal for reading and writing (RD, WR),
- from the externally suppliable address signals (ADR) and the control signals ($\overline{RAS}$, $\overline{CAS}$, R/$\overline{W}$), it generates the test signal (Test), particularly in accordance with "JEDEC Standard 21-B" of the JEDEC Committee, the semiconductor memory being operable in the test mode when the test signal (Test) is activated, and otherwise in a normal operating mode.

3. Integrated semiconductor memory according to Claim 2, characterised in that, in the block databuses (BKDB), one pair of data lines for reading (BKDB-RD) is in each case constructed as a separate pair of read data lines and in that one pair of data lines for writing (BKDB-WR) is in each case constructed as a separate pair of write data lines.

4. Integrated semiconductor memory according to Claim 2, characterised in that, in the block databuses (BKDB), one pair of data lines for writing (BKDB-WR) and one pair of data lines for reading (BKDB-RD) is in each case constructed as a single bidirectional pair of data lines.

5. Integrated semiconductor memory according to one of Claims 2 to 4, characterised in that, in the group databuses (GPDB), one pair of data lines for writing (GPDB-WR) and one pair of data lines for reading (GPDB-RD) is in each case constructed as a single bidirectional pair of datalines.

6. Integrated semiconductor memory according to one of Claims 2 to 4, characterised in that, in the group databuses (GPDB), one pair of data lines for writing (GPDB-WR) is in each case constructed as a separate pair of write data lines and in that one pair of data lines for reading (GPDB-RD) is in each case constructed as a separate pair of read data lines.

7. Integrated semiconductor memory according to one of Claims 2 to 6, characterised in that the block addresses (ADBK) are derived from the address signals (ADR), which can be supplied externally, in such a quantity that they can be used for addressing the V block decoders (BDEC) of a block group ($GP_u$).

8. Integrated semiconductor memory according to one of Claims 2 to 7, characterised in that the word line addresses (ADWL) are derived from the address signals (ADR), which can be supplied externally, in such a quantity that they can be used for addressing all the word lines (WL) of a memory block ($BK_v$).

9. Integrated semiconductor memory according to one of Claims 2 to 8, characterised in that the bit group addresses (ADBIT) are derived from the address signals (ADR), which can be supplied externally, in such a quantity that (A:M) bit group selection signals (BITSIG) can be decoded from them, A being equal to the total number of pairs of bit lines (BL) of a memory block ($BK_v$).

10. Integrated semiconductor memory according to one of Claims 2 to 9, characterised in that an input/output databus (IODB) has precisely one data line pair for writing and reading.

11. Integrated semiconductor memory according to one of Claims 2 to 9, characterised in that an input/output databus (IODB) has one data line pair for writing (IODB-WR, $\overline{IODB\text{-}WR}$) and one data line pair for reading (IODB-RD, $\overline{IODB\text{-}RD}$).

12. Integrated semiconductor memory according to Claim 10 or 11, characterised in that the group address bus (GPAD) contains M group address signals ($GPAD_{m=1...M}$), one of which in each case is in a first logic state and the remaining ones is in a second logic state complementary thereto.

13. Integrated semiconductor memory according to Claim 12, characterised in that a group input/output unit (GPIO) contains a group control circuit (GPCTRL), a group write unit (GPWR), a group read unit (GPRD) and a group test unit (GPTest), in that the group control circuit (GPCTRL) is connected to the M group address signals (GPAD,) and the test signal (Test) at the input, in that it has outputs for M group address output signals (GPAD'$_{m=1...M}$), all of which are jointly in one logic level in the test mode and which are in the logic states of the respective group address signals (GPAD$_m$) in the normal operating mode.

14. Integrated semiconductor memory according to Claim 13, characterised in that the group control circuit (GPCTRL) contains M mutually independent OR gates (OR) having in each case two inputs, at one inputs of which jointly the test signal (Test) is present, at the other inputs of which the respective group address signal (GPAD$_m$) is present and the outputs of which are the outputs of the group control circuit (GPCTRL).

15. Integrated semiconductor memory according to Claim 14, characterised in that an OR gate (OR) contains a NOR gate having two inputs and followed by an inverter.

16. Integrated semiconductor memory according to Claim 14 or 15, characterised in that the group write unit (GPWR) contains two demultiplexers (DMUXWR), which in each case have inputs for the group address output signals (GPAD'$_m$) of the group control circuit (GPCTRL) and in each case a further input for one of the two lines (IODB-WR, $\overline{\text{IODB-WR}}$) of the data line pair of the input/output databus (IODB), which are used for writing, and which have in each case M outputs for lines of the M pairs of lines of the group databus (GPDB) associated with the group input/output unit (GPIO), which are used for writing (GPDB-WR$_{1...M}$; $\overline{\text{GPDB-WR}}_{1...M}$), each of the M outputs being associated with exactly one of the inputs for the group address output signals (GPAD'$_{1...M}$) of the group control circuit (GPCTRL) in each demultiplexer (DMUXWR), a data item present at the further input in each demultiplexer (DMUXWR) being connected through, in the normal operating mode, to the output whose associated group address output signal (GPAD',) is at the first logic level of the corresponding group address signal (GPAD$_m$), and the data item present at the respective further input in each demultiplexer (DMUXWR) being switched through in the test mode to all M outputs.

17. Integrated semiconductor memory according to Claim 16, characterised in that each demultiplexer (DMUXWR) contains M mutually independent AND gates (AND) having in each case two inputs, the one inputs of which are jointly connected to the respective one line of the input/output databus (IODB) which is used for writing, and the other inputs of which are in each case connected in each demultiplexer (DMUXWR) to one of the group address output signals (GPAD'$_{1...M}$) of the group control circuit (GPCTRL).

18. Integrated semiconductor memory according to Claim 17, characterised in that at least one AND gate (AND) contains a NAND gate having two inputs, which are the inputs of the AND gate (AND), and having an inverter following the NAND gate.

19. Integrated semiconductor memory according to one of Claims 13 to 18, characterised in that the group read unit (GPRD) contains two multiplexers (MUXRD) having in each case M inputs for lines of the M pairs of lines of the group databus (GPDB) associated with the group input/output unit (GPIO) which are used for reading (GPDB-RD$_{1...M}$; $\overline{\text{GPDB-RD}}_{1...M}$) and in each case further inputs for the M group address output signals (GPAD'$_{1...M}$) of the group control circuit (GPCTRL),
in that each multiplexer (MUXRD) contains one output (GPout1, GPout2),
in that each of the group address output signals (GPAD'$_{1...M}$) in each multiplexer (MUXRD) is associated with exactly one pair of the lines (GPDB-RD$_{1...M}$, $\overline{\text{GPDB-RD}}_{1...M}$) of the group databus (GPDB),
in that, in the normal operating mode, the two multiplexers (MUXRD) switch through to the outputs (GPout1, GPout2) that pair of data lines (GPDB-RD$_1$, $\overline{\text{GPDB-RD}}_1$;...; GPDB-RD$_M$, $\overline{\text{GPDB-RD}}_M$) of the group databus (GPDB), used for reading, whose group address output signal (GPAD'$_m$) associated with this bus is at the first logic level of the corresponding group address signal (GPAD$_m$), and in that, in the test mode, in the case in which all lines (GPDB-RD$_{1...M}$; $\overline{\text{GPDB-RD}}_{1...M}$) for reading, present on a respective multiplexer (MUXRD), exhibit the same data item, the latter is switched to the output (GPout1, GPout2) of the respective multiplexer (MUXRD) so that the outputs (GPout1, GPout2) of the two multiplexers (MUXRD) are at mutually complementary logic levels, and in that, otherwise, the outputs (GPout1, GPout2) of the multiplexers (MUXRD) are at a mutually identical logic level.

20. Integrated semiconductor memory according to Claim 19, characterised in that each multiplexer (MUXRD) contains M NAND gates, having in each case two inputs, and a further NAND gate, having M inputs, which are in each case connected to the output of one of the M NAND gates, in that the output of the further NAND gate is the output (GPout1, GPout2) of the respective multiplexer (MUXRD), in that one input of

37

each of the M NAND gates is connected to one of the read data lines (GPDB-RD$_{1...M}$; $\overline{\text{GPDB-RD}}_{1...M}$) of the group databus (GPDB) and in that the other input of each of the M NAND gates receives the group address output signal (GPAD'$_m$) associated with the respective read data line (GPDB-RD$_{1...M}$; $\overline{\text{GPDB-RD}}_{1...M}$).

21. Integrated semiconductor memory according to Claim 19 or 20, characterised in that
   - the group test unit (GPTest) has a first (GPin1) and a second input (GPin2) which is in each case connected to one of the two outputs (GPout1, GPout2) of the group read unit (GPRD),
   - in that the group test unit (GPTest) has a third input for the test signal (Test) and a fourth input for a comparison data item (DCOMP) at a logic level,
   - in that the group test unit (GPTest) has two outputs which are connected to the read lines (IODB-RD, $\overline{\text{IODB-RD}}$) of the input/output databus (IODB), and
   - in that the group test unit (GPTest) has the following function:
      - in the normal operating mode, the signal present at the respective input (GPin1; GPin2) of the first two inputs (GPin1, GPin2) is present at the outputs,
      - in the test mode, in the one case, in which the outputs (GPout1, GPout2) of the group read unit (GPRD) connected to the first two inputs (GPin1, GPin2) are at mutually complementary logic levels, these complementary levels are present at the outputs of the group test unit (GPTest), and in the other case, in which the outputs (GPout1, GPout2) of the group read unit (GPRD), connected to the first two inputs (GPin1, GPin2), are both at the mutually identical logic level, one of the two outputs of the group test unit (GPTest) is at a logic level which is complementary to the logic level of the comparison data item (DCOMP) whereas the other one of the two outputs is at the logic level of the comparison data item (DCOMP).

22. Integrated semiconductor memory according to Claim 21, characterised in that the group test unit (GPTest) contains six NAND gates (N1...N6) having in each case two inputs and one output, and a NOR gate (NOR) having three inputs and one output, in that the one input of the first NAND gate (N1) is the first input (GPin1) of the group test unit (GPTest), in that the one input of the fourth NAND gate (N4) is the second input (GPin2) of the group test unit (GPTest),
   in that the first input (GPin1) of the group test unit (GPTest) is connected via a first inverter (I1) both to the other input of the fourth NAND gate (N4) and to the first input of the NOR gate (NOR),
   in that the second input (GPin2) of the group test unit (GPTest) is connected via a second inverter (I2) both to the other input of the first NAND gate (N1) and to the second input of the NOR gate (NOR),
   in that the test signal (Test) can be supplied via a third inverter (I3) to the third input of the NOR gate (NOR),
   in that the comparison data item (DCOMP) can be supplied to one input of the third NAND gate (N3) and via a fourth inverter (I4) to one input of the second NAND gate (N2), in that the output of the NOR gate (NOR) is connected to the other inputs of the second and third NAND gates (N2, N3),
   in that the outputs of the first and of the second NAND gates (N1, N2) are connected to the inputs of the fifth NAND gate (N5),
   in that the outputs of the third and of the fourth NAND gates (N3, N4) are connected to the inputs of the sixth NAND gate (N6), and
   in that the outputs of the fifth and of the sixth NAND gates (N5, N6) are the two outputs of the group test unit (GPTest).

23. Integrated semiconductor memory according to Claim 21 or 22, characterised by the following features:
   - the memory array input/output unit (MAIO) contains P memory array read units (MARD) having in each case R read units (RDU1; RDU2), P memory array write units (MAWR) which are in each case allocated to one of the memory array read units (MARD) and which contain in each case R write units (WRU1; WRU2), and a memory array control circuit (MACTRL),
   - each memory array read unit (MARD) has R pairs of data input lines (MARD$_{p,r}$, $\overline{\text{MARD}}_{p,r}$),
   - each memory array write unit (MAWR) has R pairs of data output lines (MAWR$_{p,r}$, $\overline{\text{MAWR}}_{p,r}$), p being constant for in each case R pairs and p = 1...P, r = 1...R,
   - the following correlation applies to the numbers P, R, U: P.R = U,
   - the data input lines (NARD$_{p,r}$, $\overline{\text{MARD}}_{p,r}$) are connected to the read lines (IODB-RD, $\overline{\text{IODB-RD}}$) of the U input/output databuses (IODB),
   - the data output lines (MAWR$_{p,r}$, $\overline{\text{MAWR}}_{p,r}$) are connected to the write lines (IODB-WR, $\overline{\text{IODB-WR}}$) of the U input/output databuses (IODB),

- each memory array read unit (MARD) is connected at one output to one of the I/O data lines of the first type (IO1) and to a data input of its associated memory array write unit (MAWR),
- each memory array read unit (MARD) also has outputs for (R - 1) I/O data lines of the second type (IO2),
- all memory array read units (MARD) jointly receive the read control signal (RD),
- all memory array write units (MAWR) jointly receive the write control signal (WR),
- all memory array read units (MARD), all memory array write units (MAWR) and the memory array control circuit (MACTRL) jointly receive the test signal (Test),
- all memory array read units (MARD) are jointly connected to a memory array read address bus (MAADRD),
- all memory array write units (MAWR) are jointly connected to a memory array write address bus (MAADWR),
- the memory array control circuit (MACTRL) is a circuit for generating the memory array read address bus (MAADRD) and the memory array write address bus (MAADWR) from the I/O address bus (IOAD) under the control of the test signal (Test), the memory array read address bus (MAADRD) and the memory array write address bus (MAADWR) in each case comprising R address lines ($MAADRD_{1...R}$; $MAADWR_{1...R}$).

24. Integrated semiconductor memory according to Claim 23, characterised in that in each case one pair of data input lines ($MARD_{p,r}$, $\overline{MARD}_{p,r}$) and one pair of data output lines ($MAWR_{p,r}$, $\overline{MAWR}_{p,r}$) are implemented as a single data line pair which can be operated bidirectionally.

25. Integrated semiconductor memory according to Claim 23 or 24, characterised in that the memory array control circuit (MACTRL) contains a read decoder (DECRD) and a write decoder (DECWR), both of which switch the I/O address bus (IOAD) through to the memory array read address bus (MAADRD) and to the memory array write address bus (MAADWR) in the normal operating mode,
in that, in the test mode, a first line of the memory array read address bus (MAADRD), by means of the read decoder (DECRD) and the test signal (Test), is at a constant logic level whilst the remaining lines of the memory array read address bus (MAADRD) are at a logic level which is complementary to the logic level of the first line and which is also constant, and
in that, in the test mode, all the lines of the memory array write address bus (MAADWR) are at a constant logic level by means of the write decoder (DECWR) and of the test signal (Test).

26. Integrated semiconductor memory according to Claim 25, characterised in that the read decoder (DECRD) has an OR circuit (OR) having two inputs and one output, one input receiving the test signal (Test), the other input being connected to a first line of the I/O address bus (IOAD) and the output being connected to the first line of the memory array read address bus (MAADRD), and in that the read decoder (DECRD) has (R - 1) AND gates (AND) having in each case two inputs and one output, one input in each case receiving a signal which is complementary to the test signal (Test), each of the other inputs being connected to one of the remaining lines of the I/O address bus (IOAD) and each of the outputs being connected to one of the remaining lines of the memory array read address bus (MAADRD).

27. Integrated semiconductor memory according to Claim 25 or 26, characterised in that the write decoder (DECWR) contains R OR circuits (OR) having in each case two inputs and one output, the one inputs jointly receiving the test signal (Test), the other inputs being connected to the I/O address bus (IOAD) and the outputs being connected to the memory array write address bus (MAADWR).

28. Integrated semiconductor memory according to Claim 26 or 27, characterised in that an OR gate (OR) contains a NOR gate followed by an inverter.

29. Integrated semiconductor memory according to Claim 26, characterised in that an AND gate (AND) contains a NAND gate followed by an inverter.

30. Integrated semiconductor memory according to one of Claims 23 to 29, characterised in that a first read unit (RDU1) of each memory array read unit (MARD) contains two multiplexers (MUXRD) and one output stage (OUTRD),
in that each multiplexer (MUXRD) has R first inputs for in each case one data input line ($MARD_{p,r}$; $\overline{MARD}_{p,r}$) of the R pairs of data input lines ($MARD_{p,r}$, $\overline{MARD}_{p,r}$) and R second inputs for the memory array read address bus (MAADRD), lines of which are associated with the data input lines ($MARD_{p,r}$; $\overline{MARD}_{p,r}$), and

one output,

in that, in both multiplexers (MUXRD), in the normal operating mode, the one of the data input lines (MARD$_{p,r}$; $\overline{MARD}_{p,r}$) whose associated line of the memory array read address bus (MAADRD) is in the activated state, is switched through to the respective output,

in that, in both multiplexers (MUXRD), in the test mode, the one of the data input lines (MARD$_{p,r}$, $\overline{MARD}_{p,r}$) to which the first line (MAADRD$_1$) of the memory array read address bus (MAADRD) with its constant logic level is allocated, is switched through to the output and

in that the output stage (OUTRD) is a driver circuit, whose output is the output of the entire memory array read unit (MARD), connected to one of the I/O data lines of the first type (IO1), which output exhibits in amplified form the signal present at the output of one multiplexer (MUXRD).

31. Integrated semiconductor memory according to Claim 30, characterised in that each multiplexer (MUXRD) of the first read unit (RDU1) has R NAND gates having in each case two inputs, one input of which is in each case one of the R first inputs of the multiplexer (MUXRD) and the other input of which is in each case one of the R second inputs of the multiplexer (MUXRD),

in that each multiplexer (MUXRD) of the first read unit (RDU1) has an additional NAND gate having R inputs which are in each case connected to one output of the R NAND gates, and

in that the output of the additional NAND gate is the output of the respective multiplexer (MUXRD) of the first read unit (RDU1).

32. Integrated semiconductor memory according to Claim 30 or 31, characterised in that the output stage (OUTRD) has two AND gates (AND) having in each case three inputs and one output,

in that the respective first input of each AND gate (AND) is connected to the output of the in each case one multiplexer (MUXRD),

in that the second input of each AND gate (AND) is connected to the output of the in each case other multiplexer (MUXRD) via an inverter,

in that the third inputs of the AND gates (AND) receive the read control signal (RD), and

in that the output stage (OUTRD) has a final stage, whose input is connected to the outputs of the AND gates (AND) and whose output is the output of the output stage (OUTRD) and of the first read unit (RDU1).

33. Integrated semiconductor memory according to Claim 32, characterised in that at least one of the AND gates (AND) is a NAND gate followed by an inverter.

34. Integrated semiconductor memory according to one of Claims 30 to 33, characterised in that the remaining (R - 1) read units (RDU2) in each case contain one output stage (OUTRD) having two inputs and one output which is in each case one of the outputs for the (R - 1) I/O data lines of the second type (IO2),

in that each input of an output stage (OUTRD) is preceded by a NAND gate having two inputs, the first input of which is connected to in each case one of the two data input lines ($\overline{MARD}_{p,2..R}$; MARD$_{p,2..R}$) of the R pairs of data input lines (MARD$_{p,r}$, $\overline{MARD}_{p,r}$) with the exception of the first pair ($\overline{MARD}_{p,1}$, MARD$_{p,1}$) of these R pairs and their second input receives the test signal (Test),

in that, in the normal operating mode, the outputs of the remaining (R - 1) read units (RDU2) are switched to a high impedance, and

in that, in the test mode, the signal present on one data input line (MARD$_{p,2...R}$) of the respective pair of data input lines (MARD$_{p,2...R}$, $\overline{MARD}_{p,2...R}$) is present in amplified form at the output of each of the remaining (R - 1) read units (RDU2).

35. Integrated semiconductor memory according to Claim 34, characterised in that the output stages (OUTRD) of the remaining (R - 1) read units (RDU2) are identical to the output stage (OUTRD) of the first read unit (RDU1) of the respective memory array read unit (MARD).

36. Integrated semiconductor memory according to one of Claims 23 to 35, characterised by the following features:
- each of the P memory array write units (MAWR) is connected at a first input to one of the P I/O data lines of the first type (IO1) and receives at a second input the write control signal (WR),
- it also contains inputs for the memory array write address bus (MAADWR) and outputs for the R pairs of data output lines (MAWR$_{p,r}$, $\overline{MAWR}_{p,r}$),
- in the normal operating mode, it forwards a data item to be written into the memory and present on the respective I/O data line of the first type (IO1), and its complementary data item, as a function of the write control signal (WR) and of the memory array write address bus (MAADWR), to the pair of

data output lines (NAWR$_{p,r}$, $\overline{\text{MAWR}}_{p,r}$) with respect to which one line of the memory array write address bus (MAADWR) is activated,

- in the test mode, it forwards the data item present on the I/O data line of the first type (IO1) and its complementary data item to all R pairs of the data output lines (MAWR$_{p,r}$, $\overline{\text{MAWR}}_{p,r}$).

37. Integrated semiconductor memory according to Claim 36, characterised by the following features:
   - a memory array write unit (MAWR) contains two demultiplexers (DMUXWR) and an input stage (INWR),
   - the input stage (INWR) is connected at a first input to the respective I/O data line of the first type (IO1) and receives the write control signal (WR) at a second input,
   - during the writing in, the input stage (INWR) derives from the data item to be written in and present on the I/O data line of the first type (IO1) the same data item and its complementary data item and applies these derived data items to two outputs,
   - each demultiplexer (DMUXWR) contains R AND gates (AND) having in each case two inputs and one output,
   - all first inputs of the AND gates (AND) of one demultiplexer (DMUXWR) are connected to one output of the input stage (INWR) and all first inputs of the AND gates (AND) of the other demultiplexer (DMUXWR) are connected to the other output of the input stage (INWR),
   - the second inputs of the AND gates (AND) of both demultiplexers (DMUXWR) are connected to the memory array write address bus (MAADWR),
   - the outputs of the demultiplexers (DMUXWR) are connected to the R pairs of data output lines (MAWR$_{p,r}$, $\overline{\text{MAWR}}_{p,r}$).

38. Integrated semiconductor memory according to Claim 37, characterised in that an input stage (INWR) contains a buffer (BF) for the data item present on the I/O data line of the first type (IO1), and in that it contains two AND gates (AND) having in each case two inputs and one output which follow the buffer (BF), the first input of one AND gate (AND) being connected to an output of the buffer (BF), the first input of the other AND gate (AND) being connected to the output of the buffer (BF) via an inverter, and the second inputs of the AND gates (AND) receiving the write control signal (WR).

39. Integrated semiconductor memory according to Claim 37 or 38, characterised in that at least one of the AND gates (AND) contains a NAND gate, having two inputs, and an inverter following the NAND gate.

40. Integrated semiconductor memory according to one of Claims 2 to 9, characterised in that an input/output databus (IODB) has N bidirectional data line pairs for writing and reading, N being an integral fraction of M.

41. Integrated semiconductor memory according to one of Claims 2 to 9, characterised in that an input/output databus (IODB) has N data line pairs for reading (IODB-RD$_{1...N}$, $\overline{\text{IODB-RD}}_{1...N}$) and N data line pairs for writing (IODB-WR$_{1...N}$, $\overline{\text{IODB-WR}}_{1...N}$), N being an integral fraction of M.

42. Integrated semiconductor memory according to Claim 40 or 41, characterised in that the group address bus (GPAD) contains Q group address signals (GPAD$_{q=1...Q}$), one of which is in each case at a first logic state and the remaining ones are at a second logic state complementary thereto, where $Q.N = M$.

43. Integrated semiconductor memory according to one of Claims 40 to 42, characterised in that a group input/output unit (GPIO) contains a group control circuit (GPCTRL), N group write units (GPWR) and N group read units (GPRD),
   in that the group control circuit (GPCTRL) is connected to the Q group address signals (GPAD$_{1...Q}$) and the test signal (Test) at the input,
   in that it has outputs for Q group address output signals (GPAD'$_{q=1...Q}$), the first group address output signal (GPAD'$_1$) being at a first logic level and the remaining group address signals (GPAD'$_{2...Q}$) being at a second logic level which is complementary to the first logic level, in the test mode, and the group address output signals (GPAD'$_{1...Q}$) being at the logic states of the respective group address signals (GPAD$_{1...Q}$) in the normal operating mode.

44. Integrated semiconductor memory according to Claim 43, characterised in that the group control circuit (GPCTRL) contains an OR gate (OR) and (Q - 1) AND gates (AND) having in each case two inputs,
   in that the first (GPAD$_1$) of the group address signals (GPAD$_{1...Q}$) is present at one input of the OR gate (OR), in that in each case one of the remaining ($GPAD_{2...Q}$) of the group address signals ($GPAD_{1...Q}$) is present at the one inputs of the AND gates (AND),

in that the test signal (Test) is present at the other input of the OR gate (OR),

in that a signal complementary to the test signal (Test) is present at the other inputs of the AND gates (AND) and in that the outputs of the OR gate (OR) and of the AND gates (AND) are the outputs of the group control circuit (GPCTRL).

45. Integrated semiconductor memory according to Claim 44, characterised in that the OR gate (OR) contains a NOR gate having two inputs and followed by an inverter.

46. Integrated semiconductor memory according to Claim 44 or 45, characterised in that at least one AND gate (AND) contains a NAND gate having two inputs and followed by an inverter.

47. Integrated semiconductor memory according to one of Claims 43 to 46, characterised by the following features:
   - a group write unit (GPWR) has a pair of inputs for a data line pair ($IODB\text{-}WR_n$, $\overline{IODB\text{-}WR_n}$) of the input/output databus (IODB), which is used for writing,
   - it is also connected to the group address output signals ($GPAD'_{1...Q}$) of the group control circuit (GPCTRL) at the input,
   - it has (Q - 1) group input stages (GPINWR) having in each case one input which is connected to one of (Q - 1) I/O data lines of a third type (IO3),
   - it has a further input for the write control signal (WR),
   - during writing in, each group input stage (GPINWR) derives from a data item to be written into the memory and applied to it via the respective I/O dataline of the third type (IO3), the same data item and its complementary data item, and applies these derived data items to two outputs,
   - each output of a group input stage (GPINWR) is followed by a logic circuit (LOGWR) having two inputs, one input of which is connected to the respective output of the group input stage (GPINWR) and the other input of which receives the test signal (Test),
   - in the normal operating mode, a signal at the same logic level is present at the outputs ($GPD_2$, $\overline{GPD}_2$; ...; $GPD_Q$, $\overline{GPD}_Q$) of both logic circuits (LOGWR) of a group input stage (GPINWR) whilst, in the test mode, the derived complementary data item is present at the output ($GPD_{2,...,Q}$) of one logic circuit (LOGWR) and the derived data item is present at the output ($\overline{GPD_{2,...,Q}}$) of the other logic circuit (LOGWR),
   - each group write unit (GPWR) also contains two demultiplexers (GPDMUXWR), each of which has Q inputs for the group address output signals ($GPAD'_{1...Q}$) and a further input which is one of the two inputs of the pair of inputs for the respective data line pair ($IODB\text{-}WR_n$, $\overline{IODB\text{-}WR_n}$), provided for writing, of the input/output databus (IODB),
   - in addition, each demultiplexer (GPDMUXWR) contains (Q - 1) additional inputs, each of which is connected in one demultiplexer (GPDMUXWR) to the output ($GPD_{2,...,Q}$) of the respective one logic circuit (LOGWR), and each of which is connected in the other demultiplexer (GPDMUXWR) to the output ($\overline{GPD_{2,...,Q}}$) of the respective other logic circuit (LOGWR),
   - each demultiplexer (GPDMUXWR) has Q outputs,
   - the outputs of the demultiplexers (GPDMUXWR) are connected to Q pairs of data lines of the M pairs of data lines, provided for writing, of the group databus (GPDB),
   - during writing in the normal operating mode, each group write unit (GPWR) forwards the data items present on the data line pair ($IODB\text{-}WR_n$, $\overline{IODB\text{-}WR_n}$), connected to its input, of the input/output databus (IODB) to the two outputs with respect to which one of the group address signals ($GPAD_q$), and thus its associated group address output signal ($GPAD'_q$) of the group control circuit (GPCTRL), is activated,
   - during writing in the test mode, each group write unit (GPWR) forwards both the data items present on the data line pair ($IODB\text{-}WR_n$, $\overline{IODB\text{-}WR_n}$), connected to its input, of the input/output databus (IODB) and the data items derived from the data items of the I/O data lines of the third type (IO3), present at its group input stages (GPINWR), to a respective output, and thus overall to a part (N) of the group databus (GPDB).

48. Integrated semiconductor memory according to Claim 47, characterised by the following features:
   - each demultiplexer (GPDMUXWR) contains an AND gate (AND) and (Q - 1) logic units (LU) which in each case have an output which is one of the Q outputs of the respective demultiplexer (GPDMUXWR),
- each AND gate (AND) has two inputs and each logic unit (LU) has three inputs,
- the first inputs of the AND gate (AND) and the logic units (LU) of each demultiplexer (GPDMUXWR) are connected to the one further input of the respective demultiplexer (GPDMUXWR),
- the second inputs of the AND gate (AND) and of the logic units (LU) of the demultiplexers (GPDMUXWR) are connected to in each case one of the Q inputs of the respective demultiplexer (GPDMUXWR),
- the third inputs of the logic units (LU) of the demultiplexers (GPDMUXWR) are the additional (Q - 1) inputs of the respective demultiplexer (GPDMUXWR).

49. Integrated semiconductor memory according to Claim 48, characterised in that an AND gate (AND) contains a NAND gate having the two inputs of the AND gate (AND) and followed by an inverter.

50. Integrated semiconductor memory according to Claim 48 or 49, characterised in that a logic unit (LU) contains a first NAND gate having two inputs which are the first two inputs of the logic unit (LU), in that the first NAND gate is associated with a second NAND gate also having two inputs, one input being connected to the output of the first NAND gate and the other input being the third input of the logic unit (LU).

51. Integrated semiconductor memory according to one of Claims 47 to 50, characterised in that a group input stage (GPINWR) contains a buffer (BF) for temporary storage of the data item present, via the respective I/O data line of the third type (IO3).

52. Integrated semiconductor memory according to one of Claims 47 to 51, characterised in that a group input stage (GPINWR) contains two AND gates (AND) having in each case two inputs, one input of the one AND gate (AND) being supplied with the data item present on the respective I/O data line of the third type (IO3), one input of the other AND gate (AND) being supplied in inverted form with the data item present on the respective I/O data line of the third type (IO3), and the other inputs of the AND gates (AND) receiving the write control signal (WR).

53. Integrated semiconductor memory according to one of Claims 43 to 52, characterised by the following features:
- a group read unit (GPRD) has Q pairs of data inputs which are connected to a corresponding number of data line pairs (GPDB-RD$_{n,1...Q}$, $\overline{\text{GPDB-RD}}_{n,1...Q}$), provided for reading, of the respective group databus (GPDB),
- it has address inputs for the group address output signals (GPAD'$_{1...Q}$) of the group control circuit (GPCTRL), each group address output signal (GPAD'$_{1,...,Q}$) being associated with one of the Q pairs of data inputs, and
- inputs for the read control signal (RD) and for the test signal (Test),
- a group read unit (GPRD) also has a pair of outputs for a data line pair (IODB-RD$_n$, $\overline{\text{IODB-RD}}_n$) of the input/output databus (IODB), which is used for reading,
- it also has (Q - 1) outputs which are connected to the I/O data lines of the third type (IO3),
- in the normal operating mode, data of the pair of Q pairs of data inputs whose associated address input is at the first logic level, which is exhibited by one of the Q group address signals (GPAD$_{1...Q}$), and which is thus also exhibited by one of the Q group address output signals (GPAD'$_{1...Q}$) of the group control circuit (GPCTRL), are switched through to the pair of outputs connected to the one data line pair (IODB-RD$_n$, $\overline{\text{IODB-RD}}_n$) of the input/output databus (IODB),
- in the test mode, data present at the first pair of data inputs are switched through to the pair of outputs connected to the one data line pair (IODB-RD$_n$, $\overline{\text{IODB-RD}}_n$) of the input/output databus (IODB),
- also in the test mode, the data items present at the remaining (Q - 1) data inputs are switched through to the (Q - 1) outputs connected to the I/O data lines of the third type (IO3).

54. Integrated semiconductor memory according to Claim 53, characterised by the following features:
- a group read unit (GPRD) contains two multiplexers (GPMUXRD), 2.(Q - 1) logic units (LOGRD) and (Q - 1) group output stages (GPOUTRD),
- each multiplexer (GPMUXRD) is connected to Q respective data lines (GPDB-RD$_{n,1...Q}$; $\overline{\text{GPDB-RD}}_{n,1...Q}$) of all Q data line pairs (GPDB-RD$_{n,1...Q}$, $\overline{\text{GPDB-RD}}_{n,1...Q}$), provided for reading, of a part (N) of the group databus (GPDB) at the input,
- it is connected to the address inputs of the group read unit (GPRD) for the group address output signals (GPAD'$_{1...Q}$) of the group control circuit (GPCTRL) at the input,

- it has an output which, as the output of the group read unit (GPRD), is connected to one (IODB-RD$_n$; $\overline{\text{IODB-RD}}_n$) of the lines of the data line pair (IODB-RD$_n$, $\overline{\text{IODB-RD}}_n$) of the input/output databus (IODB),
- in the normal operating mode, the data item which is present on the respective data line of such a pair of the Q data line pairs whose associated group address output signal (GPAD'$_{1...Q}$) is at the first logic level, is switched through to the output connected to the input/output databus (IODB),
- in the test mode, the data item present on the respective data line (GPDB-RD$_{n,1}$; $\overline{\text{GPDB-RD}}_{n,1}$) of the first pair (GPDB-RD$_{n,1}$, $\overline{\text{GPDB-RD}}_{n,1}$) of data lines of the part (N) of the group databus (GPDB) is switched through to the respective output.

55. Integrated semiconductor memory according to Claim 54, characterised in that a logic unit (LOGRD) is a NAND gate having two inputs,

in that in each case two logic units (LOGRD) are functionally combined in such a manner that their first inputs are connected to a respective data line GPDB-RD$_{n,2,...,Q}$; $\overline{\text{GPDB-RD}}_{n,2,...,Q}$) of one of the (Q - 1) data line pairs (GPDB-RD$_{n,2...Q}$, $\overline{\text{GPDB-RD}}_{n,2...Q}$), provided for reading, of the part (N) of the group databus (GPDB), in that their second inputs are connected to the test signal (Test), and

in that their outputs are simultaneously inputs of the group output stage (GPOUTRD) following it.

56. Integrated semiconductor memory according to Claim 55, characterised by the following features:
- a group output stage (GPOUTRD) contains two AND gates (AND) having three inputs each and a final stage following the two AND gates (AND),
- the first inputs of the AND gates (AND) are connected via an inverter to the output of a respective logic unit (LOGRD),
- the second inputs of the AND gates (AND) are connected to the output of the other respective logic unit (LOGRD),
- the third inputs receive the read control signal (RD),
- the output of the final stage is the output of the group output stage (GPOUTRD) which, simultaneously, is one of the (Q - 1) outputs of the group read unit (GPRD).

57. Integrated semiconductor memory according to Claim 40 or 41, characterised by the following features:
- in the semiconductor memory, all U input/output databuses (IODB) having in each case N data line pairs for writing and reading are divided with their data line pairs overall into P memory array databuses (MADB) having in each case R pairs of data output lines for writing (MADB-WR$_{1...P,1...R}$, $\overline{\text{MADB-WR}}_{1...P,1...R}$) and data input lines for reading (MADB-RD$_{1...P,1...R}$, $\overline{\text{MADB-RD}}_{1...P,1...R}$), the following being applicable with respect to the overall arrangement: U.N = P.R, where N = M/Q,
- the memory array input/output unit (MAIO) contains P memory array read units (MARD) having in each case R read units (RDU1; RDU2), P memory array write units (MAWR), which are in each case associated with one of the P memory array read units (MARD) and which in each case contain R write units (WRU1; WRU2), and a memory array control circuit (MACTRL),
- each memory array read unit (MARD) has the R pairs of data input lines (MADB-RD$_{p,r}$, MADB-RD$_{p,r}$) of one of the P memory array databuses (MADB),
- each memory array write unit (MAWR) has the R pairs of data output lines (MADB-WR$_{p,r}$, $\overline{\text{MADB-WR}}_{p,r}$) of the memory array databus (MADB), where p = 1...P and r = 1...R,
- each memory array read unit (MARD) is connected at one output to one of the I/O data lines of the first type (IO1) and to a data input of its associated memory array write unit (MAWR),
- each memory array read unit (MARD) also has outputs for (R - 1) I/O data lines of the second type (IO2),
- all the memory array read units (MARD) jointly receive the read control signal (RD),
- all the memory array write units (MAWR) jointly receive the write control signal (WR),
- all the memory array read units (MARD), all the memory array write units (MAWR) and the memory array control circuit (MACTRL) jointly receive the test signal (Test),
- all the memory array read units (MARD) and all the memory array write units (MAWR) are jointly connected to a memory array address bus (MAAD) so that all the memory array read units (MARD) and all the memory array write units (MAWR) can be in each case jointly operated,
- the memory array control circuit (MACTRL) is a circuit for generating the memory array address bus (MAAD) from the I/O address bus (IOAD), controlled by the test signal (Test), the memory array address bus (MAAD) comprising R address lines (MAAD$_{1...R}$).

**58.** Integrated semiconductor memory according to Claim 57, characterised in that in each case one pair of data input lines (MADB-RD$_{p,r}$, $\overline{\text{MADB-RD}}_{p,r}$) and one pair of data output lines (MADB-WR$_{p,r}$, $\overline{\text{MADB-WR}}_{p,r}$) are implemented as a single data line pair which can be operated bidirectionally.

**59.** Integrated semiconductor memory according to Claim 57 or 58, characterised in that the memory array control circuit (MACTRL) is a decoder which, in the normal operating mode, switches the I/O address bus (IOAD) through to the memory array address bus (MAAD), and in that, in the test mode, a first line (MAAD$_1$) of the memory array address bus (MAAD) is at a constant logic level by means of the test signal (Test), whereas the remaining lines of the memory address bus (MAAD) are at a logic level which is complementary to the logic level of the first line (MAAD$_1$) and which is also constant.

**60.** Integrated semiconductor memory according to Claim 59, characterised in that the memory array control circuit (MACTRL) has an OR gate (OR) having two inputs and one output, one input receiving the test signal (Test), the other input being connected to a first line of the I/O address bus (IOAD) and the output being connected to the first line of the memory array address bus (MAAD), and in that the memory array control circuit (MACTRL) has (R - 1) AND gates (AND) having in each case two inputs and one output, one input in each case receiving a signal complementary to the test signal (Test), each of the other inputs being connected to one of the remaining (R - 1) lines of the I/O address bus (IOAD), and each of the outputs being connected to one of the remaining (R - 1) lines of the memory array address bus (MAAD).

**61.** Integrated semiconductor memory according to Claim 60, characterised in that the OR gate (OR) contains a NOR gate which is followed by an inverter.

**62.** Integrated semiconductor memory according to Claim 60, characterised in that an AND gate (AND) contains a NAND gate which is followed by an inverter.

**63.** Integrated semiconductor memory according to one of Claims 57 to 62, characterised in that a first read unit (RDU1) of each memory array read unit (MARD) contains two multiplexers (MUXRD) and an output stage (OUTRD),
in that each multiplexer (MUXRD) has R first inputs for in each case one data input line (MADB-RD$_{p,r}$; $\overline{\text{MADB-RD}}_{p,r}$) of the R pairs of data input lines (MADB-RD$_{p,r}$, $\overline{\text{MADB-RD}}_{p,r}$) and R second inputs for the memory array address bus (MAAD), the lines of which are allocated to the data input lines (MADB-RD$_{p,r}$, $\overline{\text{MADB-RD}}_{p,r}$) and an output, in that, in both multiplexers (MUXRD), in the normal operating mode, the one of the data input lines (MADB-RD$_{p,r}$, $\overline{\text{MADB-RD}}_{p,r}$) whose associated line of the memory array address bus (MAAD) is in an activated electrical state is switched through to the respective output,
in that, in both multiplexers (MUXRD), in the test mode, the one of the data input lines (MADB-RD$_{p,r}$, $\overline{\text{MADB-RD}}_{p,r}$) which is associated with the first line (MAAD$_1$) of the memory array address bus (MAAD) with its constant logic level is switched through to the output, and
in that the output stage (OUTRD) is a driver circuit, the output of which is the output of the entire memory array read unit (MARD), connected to one of the I/O data lines of the first type (IO1), and which exhibits in amplified form the signal present at the output of one multiplexer (MUXRD).

**64.** Integrated semiconductor memory according to Claim 63, characterised in that each multiplexer (MUXRD) of the first read unit (RDU1) has R NAND gates having in each case two inputs, one input of which is in each case one of the R first inputs of the multiplexer (MUXRD) and the other input of which is in each case one of the R second inputs of the multiplexer (MUXRD),
in that each multiplexer (MUXRD) of the first read unit (RDU1) has an additional NAND gate having R inputs which are in each case connected to an output of the R NAND gates, and
in that the output of the additional NAND gate is the output of the respective multiplexer (MUXRD) of the first read unit (RDU1).

**65.** Integrated semiconductor memory according to one of Claims 63 or 64, characterised in that the output stage (OUTRD) has two AND gates (AND) having in each case three inputs and one output,
in that the respective first input of each AND gate (AND) is connected to the output of the in each case one multiplexer (MUXRD),
in that the respective second input of each AND gate (AND) is connected to the output of the respective other multiplexer (MUXRD) via an inverter,
in that the third inputs of the AND gates (AND) receive the read control signal (RD), and
in that the output stage (OUTRD) has a final stage, whose input is connected to the outputs of the AND gates (AND) and whose output is the output of the output stage (OUTRD) and of the first read unit (RDU1).

66. Integrated semiconductor memory according to Claim 65, characterised in that at least one of the AND gates (AND) is a NAND gate followed by an inverter.

67. Integrated semiconductor memory according to one of Claims 63 to 66, characterised in that the remaining (R - 1) read units (RDU2) in each case contain an output stage (OUTRD) having two inputs and one output, which is in each case one of the outputs for the (R - 1) I/O data lines of the second type (IO2), in that each input of an output stage (OUTRD) is preceded by a NAND gate having two inputs, the first input of which is connected to in each case one of the two data input lines ($\overline{\text{MADB-RD}}_{p,2...R}$, MADB-RD$_{p,2...R}$) of one of the R pairs of data input lines (MADB-RD$_{p,r}$, $\overline{\text{MADB-RD}}_{p,r}$), with the exception of the first pair (MADB-RD$_{p,1}$, $\overline{\text{MADB-RD}}_{p,1}$) of these R pairs and the second input of which receives the test signal (Test), in that, in the normal operating mode, the outputs of the remaining (R - 1) read units (RDU2) are switched to high impedance and
in that, in the test mode, the signal present on the one data input line (MADB-RD$_{p,2...R}$) of the respective pair of data input lines (MADB-RD$_{p,2...R}$, $\overline{\text{MADB-RD}}_{p,2...R}$) is present in amplified form at the output of each of the remaining (R - 1) read units (RDU2).

68. Integrated semiconductor memory according to Claim 67, characterised in that the output stages (OUTRD) of the remaining (R - 1) read units (RDU2) are identical to the output stage (OUTRD) of the first read unit (RDU1) of the respective memory array read unit (MARD).

69. Integrated semiconductor memory according to one of Claims 57 to 68, characterised by the following features:
   - each of the P memory array write units (MAWR) is connected at a first input to one of the P I/O data lines of the first type (IO1) and receives the write control signal (WR) at a second input,
   - it also contains third inputs for the memory array address bus (MAAD) and outputs for the R pairs of data output lines (MADB-WR$_{p,r}$, $\overline{\text{MADB-WR}}_{p,r}$),
   - in the normal operating mode, it forwards a data item to be written into the memory and present on the respective I/O data line of the first type (IO1), and its complementary data item, as a function of the write control signal (WR) and of the memory array address bus (MAAD), to the pair of data output lines (MADB-WR$_{p,r}$, $\overline{\text{MADB-WR}}_{p,r}$) with respect to which a line of the memory array address bus (MAAD), and thus a line of the I/O address bus (IOAD), is activated,
   - in the test mode, it forwards the data item present on the I/O data line of the first type (IO1), and its complementary data item, to all R pairs of data output lines (MADB-WR$_{p,r}$, $\overline{\text{MADB-WR}}_{p,r}$).

70. Integrated semiconductor memory according to Claim 69, characterised by the following features:
   - a memory array write unit (MAWR) contains two demultiplexers (DMUXWR) and one input stage (INWR),
   - the input stage (INWR) is connected at a first input to the respective I/O data line of the first type (IO1) and receives the write control signal (WR) at a second input,
   - the input stage (INWR) derives from the data item to be written in and present on the I/O data line of the first type (IO1) the same data item and its complementary data item and applies these derived data items to two outputs,
   - each demultiplexer (DMUXWR) contains R AND gates (AND) having in each case two inputs and one output,
   - all first inputs of the AND gates (AND) of the one demultiplexer (DMUXWR) are connected to the one output of the input stage (INWR), and all first inputs of the AND gates (AND) of the other demultiplexer (DMUXWR) are connected to the other output of the input stage (INWR),
   - the second inputs of the AND gates (AND) of both demultiplexers (DMUXWR) are connected to the memory array address bus (MAAD),
   - the outputs of the demultiplexers (DMUXWR) are connected to the R pairs of data output lines (MADB-WR$_{p,r}$, $\overline{\text{MADB-WR}}_{p,r}$).

71. Integrated semiconductor memory according to Claim 70, characterised in that an input stage (INWR) contains a buffer (BF) for the data item present on the I/O data line of the first type (IO1), and in that it contains two AND gates (AND) having in each case two inputs and one output which follow the buffer (BF), the first input of the one AND gate (AND) being connected to an output of the buffer (BF), the first input of the other AND gate (AND) being connected via an inverter to the output of the buffer (BF), and the second inputs of the AND gates (AND) receiving the write control signal (WR).

72. Integrated semiconductor memory according to one of Claims 69 to 71, characterised in that at least one of the AND gates (AND) contains a NAND gate having two inputs and an inverter following the NAND gate.

73. Integrated semiconductor memory according to one of Claims 57 to 68, characterised by the following features:
   - each of the P memory array write units (MAWR) is connected at a first input to one of the P I/O data lines of the first type (IO1),
   - it is connected at further (R - 1) first inputs to in each case one of the I/O data lines of the second type (IO2),
   - a second input receives the write control signal (WR),
   - it also contains third inputs for the memory array address bus (MAAD) and outputs for the R pairs of data output lines (MADB-WR$_{p,r}$, $\overline{\text{MADB-WR}}_{p,r}$) of one of the memory array databuses (MADB),
   - in the normal operating mode, it forwards a data item to be written into the memory and present on the respective I/O data line of the first type (IO1) and its complementary data item, as a function of the write control signal (WR) and of the memory array address bus (MAAD), to the pair of data output lines (MADB-WR$_{p,r}$), $\overline{\text{MADB-WR}}_{p,r}$) with respect to which one line of the I/O address bus (IOAD), and thus one line of the memory array address bus (MAAD), is activated,
   - in the test mode, it forwards, on the one hand, the data item on the I/O data line of the first type (IO1) and its complementary data item to the first pair (MADB-WR$_{p,1}$, $\overline{\text{MADB-WR}}_{p,1}$) of the R pairs of data output lines (MADB-WR$_{p,r}$, $\overline{\text{MADB-WR}}_{p,r}$.
   - on the other hand, in the test mode, it forwards data items present at the further (R - 1) first inputs and their respective complementary data items to a respective pair (MADB-WR$_{p,2,...,R}$, $\overline{\text{MAWR}}_{p,2,...,R}$) of the remaining (R - 1) pairs of data output lines (MADB-WR$_{p,2...R}$, $\overline{\text{MADB-WR}}_{p,2...R}$) of the R pairs of data output lines (MADB-WR$_{p,r}$, $\overline{\text{MADB-WR}}_{p,r}$).

74. Integrated semiconductor memory according to Claim 73, characterised by the following features:
   - a memory array write unit (MAWR) contains two demultiplexers (DMUXWR) and R input stages (INWR),
   - the first one of the input stages (INWR) is connected at a first input to the I/O data line of the first type (IO1) which receives a data item to be written in during the writing-in,
   - the remaining (R - 1) input stages (INWR) are connected at a respective first input to a respective I/O data line of the second type (IO2) which receives a respective data item to be written in during the writing-in,
   - each input stage (INWR) receives the write control signal (WR) at a second input,
   - each input stage (INWR) has two outputs,
   - at one output, the data item present at its first input is present when the write control signal (WR) is activated,
   - at the other output, the data item complementary to this data item is present when the write control signal (WR) is activated,
   - in each of the (R - 1) remaining input stages (INWR), the two outputs are in each case followed by a logic circuit (LOGWR) having two inputs and one output (MAD$_{2,...,R}$; $\overline{\text{MAD}}_{2,...,R}$), one input of which is connected to the respective one of the two outputs of the input stage (INWR) and the other input of which receives the test signal (Test),
   - in the normal operating mode, a signal at a mutually identical logic level is present at the outputs (MAD$_{2,...,R}$, $\overline{\text{MAD}}_{2,...,R}$) of all the logic circuits (LOGWR) following the (R - 1) remaining input stages (INWR), whereas, in the test mode, the in each case complementary data item is present at the output (MAD$_{2,...,R}$; $\overline{\text{MAD}}_{2,...,R}$) of the one logic circuit (LOGWR) with respect to each of the (R - 1) remaining input stages (INWR), and the respective data item to be written in is present at the output ($\overline{\text{MAD}}_{2,...,R}$; MAD$_{2,...,R}$) of the other logic circuit (LOGWR),
   - each demultiplexer (DMUXWR) contains an AND gate (AND) having two inputs and (R - 1) logic units (LU) having three inputs and R outputs,
   - in a demultiplexer (DMUXWR), the first input of the AND gate (AND) and the first inputs of the logic units (LU) are connected to the one output of the first input stage (INWR),
   - in the other demultiplexer (DMUXWR), the first input of the AND gate (AND) and the first inputs of the logic units (LU) are connected to the other output of the first input stage (INWR),

- in both demultiplexers (DMUXWR), the second inputs of the AND gates (AND) and the second inputs of the logic units (LU) are connected to a respective line (MAAD$_{1,...,R}$) of the memory array address bus (MAAD),
- in one demultiplexer (DMUXWR) the third inputs of the logic units (LU) are connected to the output (MAD$_{2,...,R}$) of the one logic circuit (LOGWR) following a respective one of the remaining (R - 1) input stages (INWR),
- in the other demultiplexer (DNUXWR), the third inputs of the logic units (LU) are connected to the output ($\overline{MAD}_{2,...,R}$) of the other logic circuit (LOGWR) following a respective one of the remaining (R - 1) input stages (INWR),
- each demultiplexer (DMUXWR) has R outputs which, overall, are the outputs of the memory array write unit (MAWR).

75. Integrated semiconductor memory according to Claim 74, characterised in that an input stage (INWR) contains a buffer (BF) for the data item present on the I/O data line of the respective type (IO1; IO2) and in that it contains two AND gates (AND) having in each case two inputs and one output which follow the buffer (BF), the first input of one AND gate (AND) being connected to an output of the buffer (BF), the first input of the other AND gate (AND) being connected via an inverter to the output of the buffer (BF), and the second inputs of the AND gates (AND) receiving the write control signal (WR).

76. Integrated semiconductor memory according to Claim 74 or 75, characterised in that at least one of the AND gates (AND) contains a NAND gate, having two inputs, and an inverter following the NAND gate.

77. Integrated semiconductor memory according to one of the preceding claims, characterised in that it contains at least one redundant word line (WLred) having redundant memory cells (MCred), which word line, in the case of redundancy, is selected via a redundant word line decoder (WLDECred), and in that, in the case of redundancy, the redundant memory cells (MCred) can be connected via the read amplifiers (SA) and bit switches (BSW) of the replaced memory cells (MC) to the corresponding lines of the block databus (BKDB).

78. Integrated semiconductor memory according to one of the preceding claims, characterised in that it contains at least one group of M pairs of redundant bit lines (BLred) with redundant memory cells (MCred), M redundant read amplifiers (SAred) and a redundant bit switch block (BKBSWred) which, in the case of redundancy, is selected via a redundancy bit group decoder (BITDECred) and associated redundant bit group selection signal (BITSIGred) and which can be connected to the corresponding lines of the block databus (BKDB).

79. Method for replacing memory cells (MC) with redundant memory cells (MCred) in a semiconductor memory according to Claim 77 or 78, in which a computer-controlled automatic testing and repair device is used which contains algorithms and means for replacing the memory cells (MC), characterised in that all the memory cells (MC) of the semiconductor memory are tested in the test mode, in that, with each detected fault, each defective memory cell group (MC) is identified via its address (ADR) applied from the outside, and the respective I/O data line (IO1, IO2, IO3), on which the fault is detected, by means of the parallel test device (PT) and the automatic testing device within the semiconductor memory, and in that the identification data thus obtained for all defective memory cell groups are supplied to the automatic repair device which thereupon replaces the memory cell groups having defective memory cells (MC), using the identification data.

80. Method for replacing memory cells (MC) with redundant memory cells (MCred) in a semiconductor memory according to Claim 77 or 78, in which a computer-controlled automatic testing and repair device is used which contains algorithms and means for replacing the memory cells (MC), characterised in that all the memory cells (MC) of the semiconductor memory are tested in the test mode, in that, with each detected fault, each defective memory cell (MC) is identified via its address (ADR) applied from the outside, and the respective I/O data line (IO1, IO2, IO3), on which the fault is detected, by means of the parallel testing device (PT) and the automatic testing device within the semiconductor memory, and in that the identification data thus obtained for all defective memory cells (MC) are supplied to the automatic repair device which thereupon replaces the defective memory cells (MC), using the identification data.

**Revendications**

1. Mémoire intégrée à semiconducteurs comportant un dispositif de test en parallèle (PT) et U groupes de blocs (GP$_u$ = $_{1...U}$), et

   dans laquelle, dans un type de fonctionnement de test, le fonctionnement de plusieurs groupes de M cellules de mémoire (MC) peut être testé simultanément, chaque groupe étant disposé le long d'une ligne de transmission de mots (WL) à l'intérieur de l'un respectif des U groupes de blocs (GP$_u$), et

   dans laquelle les données lues peuvent être évaluées au moyen du dispositif de test en parallèle (PT), caractérisée par les particularités suivantes :
   - le dispositif de test en parallèle (PT) utilise un enregistrement et une évaluation de données à enregistrer dans la mémoire à semiconducteurs et à lire à partir de cette mémoire,
   - le résultat de l'évaluation est appliqué, séparément pour chaque groupe de M cellules de mémoire (MC), à des lignes de données d'entrée/sortie (IO1, IO2, IO3) de la mémoire à semiconducteurs.

2. Mémoire intégrée à semiconducteurs suivant la revendication 1 présentant les caractéristiques suivantes :
   - chaque groupe de blocs (GP$_u$) comporte V blocs de mémoire (BK$_{v=1...V}$) ayant des cellules de mémoire (MC) qui sont disposées suivant une matrice le long de lignes de transmission de mots (WL) et de lignes de transmission de bits (BL),
   - en fonctionnement, au maximum un bloc de mémoire (BK$_v$) par groupe de blocs (GP$_u$) peut être sélectionné,
   - chaque bloc de mémoire (BK$_v$) comporte les éléments suivants :
     - un décodeur de blocs (BDEC) destinés à sélectionner le bloc de mémoire respectif à partir de la quantité des blocs de mémoire (BK$_{1...V}$) de son groupe de blocs (GP$_u$) en fonction des adresses de blocs (ADBK), qui lui sont envoyées, la sélection s'effectuant à l'aide d'un signal de sélection de bloc (BKSIG),
     - des décodeurs de lignes de transmission de mots (WLDEC) destinés à sélectionner les lignes de transmission de mots (WL) en fonction d'adresses (ADWL) de lignes de transmission de mots et du signal de sélection de bloc (BKSIG),
     - des amplificateurs de lecture (SA), auxquels sont reliés, d'une part, un couple des lignes de transmission de bits (BL) et, d'autre part, un couple de lignes de jonction,
     - des commutateurs de bits (BSW) pour établir une liaison, au choix, du couple de lignes de jonction avec l'un des M couples de lignes de transmission de données pour la lecture (BKDB-RD) et pour l'enregistrement (BKDB-WR) d'un bus de transmission de données de blocs (BKDB), M commutateurs de bits (BSW) pouvant être commandés en commun, en tant que blocs de commutateurs de bits (BKBSW), par un signal de sélection de groupes de bits (BITSIG),
     - les signaux de sélection de groupes de bits (BITSIG) sont des signaux de sortie d'un décodeur de groupes de bits (BITDEC), qui est commandé par des adresses de groupes de bits (ADBIT), au moins un décodeur de groupes de bits (BITDEC) étant prévu pour tous les blocs de mémoire (BK$_{1...V}$),
   - à chaque bloc de mémoire (BK$_v$) d'un groupe de blocs (GP$_u$) est associé un multiplexeur (BKDBMX) du bus de transmission de données de blocs, auquel, d'une part, sont reliées les lignes de transmission de données d'enregistrement (BKDB-WR) et les lignes de transmission de données de lecture (BKDB-RD) du bus respectif de transmission de données de blocs (BKDB) et qui, d'autre part, est relié à M couples de lignes de transmission de données pour l'enregistrement (GPDB-WR) et pour la lecture (GPDB-RD) d'un bus de données de groupes (GPDB), qui relie entre eux tous les multiplexeurs (BKDBMX) de bus de transmission de données de blocs d'un groupe de blocs (GB$_u$),
   - chaque multiplexeur (BKDBMX) d'un bus de transmission de données de blocs est commandé par le signal de sélection de bloc (BKSIG) du bloc de mémoire (BK$_v$), auquel est associé le multiplexeur (BKDBMX) du bus de transmission de données de blocs,
   - le dispositif de test en parallèle (PT) comporte les éléments suivants :
     - pour chaque groupe de blocs (GP$_u$), il est prévu une unité d'entrée/sortie de groupe (GPIO), qui est reliée, d'une part, au bus respectif de transmission de données de groupes (GPDB) et, d'autre part, à un bus de transmission de données d'entrée/sortie (IODB),
     - toutes les unités d'entrée/sortie (GPIO) des U groupes de blocs (GP$_{1...U}$) sont commandés en commun par au moins un signal de test (Test), par au moins un signal de commande (WR, RD) pour l'enregistrement et la lecture et par un bus de transmission d'adresses de groupe (GPAD),
     - une unité d'entrée/sortie de cellules (MAIO), qui est associée à l'ensemble des U groupes de blocs (GP$_{1...U}$), qui est reliée, côté entrée, aux bus de transmission de données d'entrée/sortie (IODB) de toutes les unités d'entrée/sortie de groupes (GPIO), qui comporte, côté sortie, P lignes de données d'entrée/sortie d'un premier type (IO1) et (K-P) lignes de données d'entrée/sortie d'un second type (IO2), et qui est commandée par le au moins un signal de commande (RD, WR) pour la lecture et l'enregistrement, par le signal de test (Test) et par un bus de transmission d'adresses d'entrée/sortie (IOAD),

- les lignes de données d'entrée/sortie du premier type (IO1) sont reliées, au moins indirectement, à des surfaces de raccordement (PD) de la mémoire à semiconducteurs, qui sont accessibles électriquement pour un utilisateur de la mémoire à semiconducteurs, par l'intermédiaire de dispositifs de raccordement de la mémoire à semiconducteurs placée dans un boîtier de blindage,

- les lignes de données d'entrée/sortie du second type (IO2) sont accessibles uniquement sur la microplaquette à semiconducteurs elle-même, en sorte qu'elles ne sont pas accessibles électriquement pour l'utilisateur de la mémoire à semiconducteurs placée dans le boîtier de blindage,

- le dispositif de test en parallèle (PT) comporte, en outre, au moins une unité de commande (CONTROL) comportant des entrées pour des signaux d'adresses (ADR) et de signaux de commande ($\overline{RAS}$, $\overline{CAS}$, R/$\overline{W}$), pouvant être envoyés de l'extérieur à la mémoire à semiconducteurs, et des sorties pour les adresses de blocs (ADBK), les adresses de lignes de transmission de mots (ADWL), les adresses de groupes de bits (ADBIT), le au moins un signal de commande pour l'enregistrement et la lecture (WR, RD), pour le signal de test (Test), le bus de transmission d'adresses de groupes (GPAD) et pour le bus de transmission d'adresses d'entrée/sortie (IOAD),

- l'unité de commande (CONTROL) produit, à partir des signaux d'adresses (AD) pouvant être envoyés de l'extérieur, les adresses de blocs (ADBK), les adresses de lignes de transmission de mots (ADWL), les adresses de groupes de bits (ADBIT), le bus de transmission d'adresses de groupes (GPAD) et le bus de transmission d'adresses d'entrée/sortie (IOAD),

- elle produit, à partir des signaux de commande ($\overline{RAS}$, $\overline{CAS}$, R/$\overline{W}$) pouvant être envoyés de l'extérieur, le au moins un signal de commande pour la lecture et l'enregistrement (RD, WR),

- elle produit le signal de test (Test), notamment conformément à la norme "JEDEC Standard 21-B" du Comité JEDEC, à partir des signaux d'adresses (ADR) pouvant être envoyés de l'extérieur, et des signaux de commande ($\overline{RAS}$, $\overline{CAS}$, R/$\overline{W}$), la mémoire à semiconducteurs pouvant fonctionner dans le mode de test lorsque le signal de test (Test) est activé, et pouvant fonctionner par ailleurs dans un type de fonctionnement normal.

3. Mémoire intégrée suivant la revendication 2, caractérisée par le fait que pour les bus (BKDB) de transmission de données de blocs, respectivement un couple de lignes de transmission de données pour la lecture (BKDB-RD) est réalisé sous la forme d'un couple distinct de lignes de transmission de données de lecture, et que respectivement un couple de lignes de transmission de données pour l'enregistrement (DKDB-WR) est réalisé sous la forme d'un couple distinct de lignes de transmission de données d'enregistrement.

4. Mémoire intégrée à semiconducteurs suivant la revendication 2, caractérisée par le fait que pour les bus (BKDB) de transmission de données de blocs, respectivement un couple de lignes de transmission de données pour l'enregistrement (BKDB-WR) et un couple de lignes de transmission de données pour la lecture (BKDB-RD) sont réalisés sous la forme d'un seul couple, pouvant fonctionner de façon bidirectionnelle, de lignes de transmission de données.

5. Mémoire intégrée à semiconducteurs suivant l'une des revendications 2 à 4, caractérisée par le fait que pour les bus (GPDB) de transmission de données de groupe, respectivement un couple de lignes de transmission de données pour l'enregistrement (GPDB-WR) et un couple de lignes de transmission de données pour la lecture (GPDB-RD) sont réalisés sous la forme d'un seul couple, pouvant fonctionner de façon bidirectionnelle, de lignes de transmission de données.

6. Mémoire intégrée à semiconducteurs suivant l'une des revendications 2 à 4, caractérisée par le fait que, pour les bus (GPDB) de transmission de données de groupe, respectivement un couple de lignes de transmission de données pour l'enregistrement (GPDB-WR) est réalisé sous la forme d'un couple distinct de lignes de transmission de données d'enregistrement, et que respectivement un couple de lignes de transmission de données pour la lecture (GPDB-RD) est réalisé sous la forme d'un couple distinct de lignes de transmission de données de lecture.

7. Mémoire intégrée à semiconducteurs suivant l'une des revendications 2 à 6, caractérisée par le fait que

50

les adresses de blocs (ADBK) sont dérivées des signaux d'adresses (ADR) pouvant être envoyés de l'extérieur, en un nombre tel qu'avec ces signaux, les V décodeurs de blocs (BDEC) d'un groupe de blocs (GP$_u$) peuvent être adressés.

8. Mémoire intégrée à semiconducteurs suivant l'une des revendications 2 à 7, caractérisé par le fait que les adresses de lignes de transmission de mots (ADWL) sont dérivées des signaux d'adresses (ADBR) pouvant être envoyés de l'extérieur, en un nombre tel qu'avec ces signaux, toutes les lignes de transmission de mots (WL) d'un bloc de mémoire (BK$_v$) peuvent être adressées.

9. Mémoire à semiconducteurs suivant l'une des revendications 2 à 8, caractérisée par le fait que les adresses de groupes de bits (ADBIT) sont dérivées des signaux d'adresses (ADR) pouvant être envoyés de l'extérieur, en un nombre tel qu'à partir de ces signaux, (A:M) signaux de sélection de groupes de bits (BITSIG) peuvent être décodés, A étant égal au nombre total des couples de lignes de transmission de bits (BL) d'un bloc de mémoire (BK$_v$).

10. Mémoire intégrée à semiconducteurs suivant l'une des revendications 2 à 9, caractérisée par le fait qu'un bus de transmission de données d'entrée/sortie (IODB) comporte précisément un couple de lignes de transmission de données pour l'enregistrement et la lecture.

11. Mémoire intégrée à semiconducteurs suivant l'une des revendications 2 à 9, caractérisé par le fait qu'un bus de transmission de données d'entrée/sortie (IODB) comporte un couple de lignes de transmission de données pour l'enregistrement (IODB-WR, $\overline{\text{IODB-WR}}$) et un couple de lignes de transmission de données pour la lecture (IODB-RD, $\overline{\text{IODB-RD}}$).

12. Mémoire intégrée à semiconducteurs suivant la revendication 10 ou 11, caractérisée par le fait que le bus de transmission d'adresses de groupes (GPAD) comporte M signaux d'adresses de groupes (GPAD$_{m=1...M}$), parmis lesquels l'un d'eux présente un premier état logique et les autres présentent un second état logique complémentaire du premier.

13. Mémoire intégrée à semiconducteurs suivant la revendication 12, caractérisée par le fait qu'une unité d'entrée/sortie de groupes (GPIO) comporte un circuit de commande de groupes (GPCTRL), une unité d'enregistrement de groupes (GPWR), une unité de lecture de groupes (GPRD) et une unité de test de groupes (GPTest), que le circuit de commande de groupes (GPCTRL) est relié, côté entrée, aux M signaux de transmission d'adresses de groupes (GPAD$_m$) et au signal de test (Test),
qu'elle comporte des sorties pour M signaux de sortie d'adresses de groupes (GPAD'$_{m=1...M}$), qui présentent, dans le mode de fonctionnement de test, tous en commun un niveau logique et qui présentent, dans le mode de fonctionnement normal, les états logiques des signaux respectifs d'adresses de groupes (GPAD$_m$).

14. Mémoire intégrée à semiconducteurs suivant la revendication 13, caractérisée par le fait que le circuit de commande de groupes (GPCTRL) comporte M circuits OU (OR) indépendants les uns des autres et comportant chacun deux entrées, aux premières entrées desquels est appliqué en commun le signal de test (Test), aux autres entrées desquels est appliqué le signal respectif d'adresse de groupe (GPAD$_m$) et dont les sorties constituent les sorties du circuit de commande de groupe (GPCTRL).

15. Mémoire intégrée à semiconducteurs suivant la revendication 14, caractérisée par le fait qu'un circuit OU (OR) comporte une porte NON-OU à deux entrées et un inverseur branché en aval de cette porte.

16. Mémoire intégrée à semiconducteurs suivant la revendication 14 ou 15, caractérisée par le fait que l'unité d'enregistrement de groupe (GPWR) comporte deux démultiplexeurs (DMUXWR), qui ont respectivement des entrées pour les signaux de sortie d'adresses de groupes (GPAD'$_m$) du circuit de commande de groupes (GPCTRL), ainsi que respectivement une autre entrée pour une des deux lignes (IODB-WR , $\overline{\text{IODB-WR}}$) du couple de lignes de transmission de données du bus de transmission de données d'entrée/sortie (IODB), qui servent à l'enregistrement, et qui comportent respectivement M sorties pour des lignes des M couples de lignes du bus de transmission de données de groupes (GPDB), associé à l'unité d'entrée/sortie de groupe (GPIO), couples de lignes qui servent à l'enregistrement (GPDB-WR$_{1...M}$; $\overline{\text{GPDB-WR}}_{1...M}$), auquel cas, dans chaque démultiplexeur (DMUXWR), précisément l'une des entrées pour les signaux de sortie d'adresses de groupes (GPAD'$_{1...M}$) du circuit de commande de groupe (GPCTRL) est associée à chacune des M sorties, et, dans chaque démultiplexeur (DMUXWR), dans le cas du mode de fonctionnement normal, une donnée présente à l'autre entrée est transférée à la sortie, dont le signal de sortie d'adresses de groupes (GPAD'$_m$) lui étant associé présente le premier niveau logique du signal correspondant d'adresse de groupe (GPAD$_m$), et, dans chaque démultiplexeur (DMUXWR), pendant le mode de fonctionnement de test, la donnée présente à l'autre entrée respective est transférée à l'ensemble des M sorties.

17. Mémoire intégrée à semiconducteurs suivant la revendication 16, caractérisée par le fait que chaque démultiplexeur (DMUXWR) comporte M circuits ET (AND), qui sont indépendant les uns des autres, qui comportent chacun deux entrées, dont les premières entrées sont reliées en commun à une ligne respective du bus de transmission de données d'entrée/sortie (IODB), qui sert à l'enregistrement, tandis que leurs autres entrées sont reliées, dans chaque démultiplexeur (DMUXWR), respectivement à l'un des signaux de sortie d'adresses de groupes (GPAD'$_{1...M}$) du circuit de commande de groupe (GPCTRL).

18. Mémoire intégrée à semiconducteurs suivant la revendication 17, caractérisée par le fait qu'au moins un circuit ET (AND) comporte une porte NON-ET à deux entrées, qui constituent les entrées du circuit ET (AND), et un inverseur branché en aval de la porte NON-ET.

19. Mémoire intégrée à semiconducteurs suivant l'une des revendications 13 à 18, caractérisée par le fait que l'unité de lecture de groupes (GPRD) comporte deux multiplexeurs (MUXDRD) comportant chacun M entrées pour des lignes des M couples de lignes du bus de transmission de données de groupes (GPDB), associé à l'unité d'entrée/sortie de groupes (GPIO), couples de lignes qui servent à la lecture (GPDB-RD$_{1...M}$; $\overline{\text{GPDB-RD}}_{1...M}$), ainsi que respectivement d'autres entrées pour les M signaux de sortie d'adresses de groupes (GPAD'$_{1...M}$) du circuit de commande de groupe (GPCTRL),
que chaque multiplexeur (MUXRD) comporte une sortie (GPout1, GPout2),
que chacun des signaux de sortie d'adresses de groupe (GPAD'$_{1...M}$) est associé précisément, dans chaque multiplexeur (MUXRD), à un couple des lignes (GPDB-RD$_{1...M}$, $\overline{\text{GPDB-RD}}_{1...M}$) du bus de transmission de données de groupes (GPDB),
que dans le mode de fonctionnement normal, les deux multiplexeurs (MUXRD) interconnectent directement le couple de lignes de transmission de données (GPDB-RD1, $\overline{\text{GPDB-RD1}}$; ...; GPDB-RD$_M$, $\overline{\text{GPDB-RD}}_M$) pour la lecture du bus de transmission de données de groupes (GPDB) aux sorties (GPout1, GPout2), couple dont le signal associé de sortie d'adresses de groupes (GPAD'$_m$) présente le premier niveau logique du signal correspondant d'adresse de groupe (GPAD$_m$), que dans le mode de fonctionnement de test, dans le cas où toutes les lignes (GPDB-RD$_{1...M}$; $\overline{\text{GPDB-RD}}_{1...M}$), qui sont reliées à un multiplexeur respectif (MUXRD), comportent la même donnée pour la lecture, cette dernière est transmise à la sortie (GPout1; GPout2) du multiplexeur respectif (MUXRD), en sorte que les sorties (GPout1, GPout2) des deux multiplexeurs (MUXRD) présentent des niveaux logiques réciproquement complémentaires, et que, sinon, les sorties (GPout1, GPout2) du multiplexeur (MUXRD) présentent le même niveau logique.

20. Mémoire intégrée à semiconducteurs suivant la revendication 19, caractérisée par le fait que chaque multiplexeur (MUXRD) comporte M portes NON-ET à chacune deux entrées, ainsi qu'une autre porte NON-ET à M entrées, qui sont reliées respectivement à la sortie de l'une des M portes NON-ET, que la sortie de l'autre porte NON-ET constitue la sortie (GPout1; GPout2) du multiplexeur respectif (MUXRD), qu'une entrée de chacune des M portes NON-ET est reliée à l'une des lignes de transmission de données de lecture (GPDB-RD$_{1...M}$; $\overline{\text{GPDB-RD}}_{1...M}$) du bus de transmission de données de groupes (GPDB) et que l'autre entrée de chacune des M portes NON-ET est chargée par le signal de sortie d'adresses de groupes (GPAD'$_m$), qui est associé à la ligne respective de transmission de données de lecture (GPDB-RD$_{1...M}$; $\overline{\text{GPDB-RD}}_{1...M}$.

21. Mémoire intégrée à semiconducteurs suivant la revendication 19 ou 20, caractérisée par le fait
    - que l'unité de test de groupes (GPTest) comporte une première entrée (GPin1) et une deuxième entrée (GPin2) qui sont reliées respectivement à l'une des deux sorties (GPToutl; GPout2) de l'unité de lecture de groupe (GPRD),
    - que l'unité de test de groupe (GPTest) comporte une troisième entrée pour le signal de test (Test) et une quatrième entrée pour une donnée de référence (DCOMP) ayant un niveau logique,
    - que l'unité de test de groupe (GPTest) comporte deux sorties, qui sont reliées aux lignes de lecture (IODB-RD, $\overline{\text{IODB-RD}}$) du bus de transmission de données d'entrée/sortie (IODB), et
    - que l'unité de test de groupe (GPTest) présente la fonction suivante :
      - dans le mode de fonctionnement normal, aux sorties est appliqué le signal qui est appliqué à l'en-

trée respective (GPin1; GPin2) des deux premières entrées (GPin1, GPin2),
- dans le mode de fonctionnement de test, dans le cas où les sorties (GPout1, GPout2) de l'unité de lecture de groupe (GPAD), qui sont reliées aux deux premières entrées (GPin1, GPin2), présentent les niveaux logiques réciproquement complémentaires, ces niveaux logiques complémentaires sont appliqués aux sorties de l'unité de test de groupe (GPTest), et dans l'autre cas, où les sorties (GPout1, GPout2) de l'unité de lecture de groupe (GPRD), qui sont reliées aux deux premières entrées (GPin1, GPin2), présentent toutes deux un même niveau logique, l'une des deux sorties de l'unité de test de groupe (GPTest) présente un niveau logique complémentaire au niveau logique de la donnée de référence (DCOMP), tandis que l'autre des deux sorties présente le niveau logique de la donnée de référence (DCOMP).

22. Mémoire intégrée à semiconducteurs suivant la revendication 21, caractérisée par le fait que l'unité de test de groupe (GPTest) comporte six portes NON-ET (N1...N6) à chacune deux entrées et une sortie, ainsi qu'une porte NON-OU (NOR) à trois entrées et une sortie,

que l'une des entrées de la première porte NON-ET (N1) constitue la première entrée (GPin1) de l'unité de test de groupe (GPTest),

que l'une des entrées de la quatrième porte NON-ET (N4) constitue la seconde entrée (GPin2) de l'unité de test de groupes (GPTest),

que la première entrée (GPin1) de l'unité de test de groupes (GPTest) est reliée, par l'intermédiaire d'un premier inverseur (I1), aussi bien à l'autre entrée de la quatrième porte NON-ET (N4) qu'à la première entrée de la porte NON-OU (NOR),

que la seconde entrée (GPin2) de l'unité de test de groupes (GPTest) est reliée, par l'intermédiaire d'un deuxième inverseur (I2) aussi bien à l'autre entrée de la première porte NON-ET (N1) qu'à la deuxième entrée de la porte NON-OU (NOR),

que le signal de test (Test) peut être envoyé, par l'intermédiaire d'un troisième inverseur (I3), à la troisième entrée de la porte NON-OU (NOR),

que la donnée de référence (DCOMP) peut être envoyée à l'une des entrées de la troisième porte NON-ET (N3) et, par l'intermédiaire d'un quatrième inverseur (I4), à l'une des entrées de la deuxième porte NON-ET (N2),

que la sortie de la porte NON-OU (NOR) est reliée aux autres entrées des deuxième et troisième portes NON-ET (N2, N3), que les sorties des première et deuxième portes NON-ET (N1, N2) sont reliées aux entrées de la cinquième porte NON-ET (N5),

que les sorties des troisième et quatrième portes NON-ET (N3, N4) sont reliées aux entrées de la sixième porte NON-ET (N6), et

que les sorties des cinquième et sixième portes NON-ET (N5, N6) constituent les deux sorties de l'unité de test de groupe (GPTest).

23. Mémoire intégrée à semiconducteurs suivant la revendication 21 ou 22, caractérisée par les particularités suivantes :
- l'unité d'entrée/sortie de cellules (MAIO) comporte P unités de lecture de zones de cellules (MARD) comportant chacune R unités de lecture (RDU1; RDU2), P unités d'enregistrement de zones de cellules (MAWR), qui sont associées respectivement à l'une des unités de lecture des zones de cellules (MARD) et qui comportent respectivement R unités d'enregistrement (WRU1; WRU2), ainsi qu'un circuit de commande de zones de cellules (MACTRL),
- chaque unité de lecture de zones de cellules (MARD) comporte R couples de lignes d'entrée de données ($MARD_{p,r}$, $\overline{MARD}_{p,r}$),
- chaque unité d'enregistrement de zones de cellules (MAWR) comporte R couples de lignes de sortie de données ($MAWR_{p,r}$, $\overline{MAWR}_{p,r}$), p étant constant pour R couples et p = 1...P, r = 1...R,
- pour les nombres P, R, U, on a la relation suivante : P.R = U,
- les lignes d'entrée de données ($MARD_{p,r}$, $\overline{MARD}_{p,r}$) sont reliées aux lignes de lecture (IODB-RD, $\overline{IODB\text{-}RD}$) des U bus de transmission de données d'entrée/sortie (IODB),
- les lignes de sortie de données ($NAWR_{p,r}$, $\overline{NAWR}_{p,r}$) sont reliées aux lignes d'enregistrement (IODB-WR, $\overline{IODB\text{-}WR}$) des U bus de transmission de données d'entrée/sortie (IODB),
- chaque unité de lecture de zones de cellules (MARD) est reliée, par une sortie, à l'une des lignes de transmission de données d'entrée/sortie du premier type (IO1) et à une entrée de données de l'unité d'enregistrement de zones de cellules (MAWR), qui lui est associée,
- chaque unité de lecture de zones de cellules (MARD) comporte, en outre, des sorties pour (R-1) lignes de transmission de données d'entrée/sortie du second type (IO2),

- toutes les unités de lecture de zones d'adresses (MARD) sont chargées en commun par le signal de commande de lecture (RD),
- toutes les unités d'enregistrement de zones de cellules (MAWR) sont chargées en commun par le signal de commande d'enregistrement (WR),
- toutes les unités de lecture de zones de cellules (MARD), toutes les unités d'enregistrement de zones de cellules (MAWR) et le circuit de commande de zones de cellules (MACTRL) sont chargées en commun par le signal de test (Test),
- toutes les unités de lecture de zones d'adresses (MARD) sont reliées en commun à un bus de transmission d'adresses de lecture de zones de cellules (MAADRD),
- toutes les unités de zones d'enregistrement de cellules (MAWR) sont reliées en commun à un bus de transmission d'adresses d'enregistrement de zones de cellules (MAADWR),
- le circuit de commande de zones de cellules (MACTRL) est un circuit servant à générer le bus de transmission d'adresses de lecture de zones de cellules (MAADRD) et le bus de transmission d'adresses d'enregistrement de zones de cellules (MAADWR) à partir du bus de transmission d'adresses d'entrée/sortie (IOAD) sous la commande du signal de test (Test), le bus de transmission d'adresses de lecture de zones de cellules (MAADRD) et le bus de transmission d'adresses d'enregistrement de zones de cellules (MAADWR) comportant respectivement R lignes de transmission d'adresses ($\text{MAADRD}_{1...R}$; $\text{MAADWR}_{1...R}$.

24. Mémoire intégrée à semiconducteurs suivant la revendication 23, caractérisée par le fait que respectivement un couple de lignes d'entrée de données ($\text{MARD}_{p,r}$, $\overline{\text{MARD}}_{p,r}$) et un couple de lignes de sortie de données ($\text{MAWR}_{p,r}$, $\overline{\text{MAWR}}_{p,r}$) sont réalisés sous la forme d'un seul couple de lignes de transmission de données, qui peut fonctionner de façon bidirectionnelle.

25. Mémoire intégrée à semiconducteurs suivant la revendication 23 ou 24, caractérisée par le fait que le circuit de commande de zones de cellules (MACTRL) comporte un décodeur de lecture (DECRD) et un décodeur d'enregistrement (DECWR), qui, dans le mode de fonctionnement normal, interconnectent directement tous deux le bus de transmission d'adresses d'entrée/sortie (IOAD) au bus de transmission d'adresses de lecture de zones de cellules (MAADRD) et au bus de transmission d'adresses d'enregistrement de zones de cellules (MAADWR), que dans le mode de fonctionnement de test, au moyen du décodeur de lecture (DECRD) et du signal de test (Test), une première ligne du bus de transmission d'adresses de lecture de zones de cellules (MAADRD) présente un niveau logique constant, tandis que les autres lignes du bus de transmission d'adresses de lecture de zones de cellules (MAADRD) présentent un niveau logique qui est complémentaire du niveau logique de la première ligne et qui est également constant, et que, dans le mode de fonctionnement de test, au moyen du décodeur d'enregistrement (DECWR) et du signal de test (Test), toutes les lignes du bus de transmission d'adresses d'enregistrement de zones de cellules (MAADWR) présentent un niveau logique constant.

26. Mémoire intégrée à semiconducteurs suivant la revendication 25, caractérisée par le fait que le décodeur de lecture (DECRD) comporte un circuit OU (OR) comportant deux entrées et une sortie, l'une des entrées étant chargée par le signal de test (Test), tandis que l'autre entrée est reliée à une première ligne du bus de transmission d'adresses d'entrée/sortie (IOAD), alors que la sortie est reliée à la première ligne du bus de transmission d'adresses de lecture de zones de cellules (MAADRD), et que le décodeur de lecture (DECRD) comporte (R-1) circuits ET (AND) comportant chacun deux entrées et une sortie, respectivement l'une des entrées étant chargée par un signal complémentaire du signal de test (Test), tandis que chacune des autres entrées est reliée à l'une des autres lignes du bus de transmission d'adresses d'entrée/sortie (IOAD), et que chacune des sorties est reliée à l'une des autres lignes du bus de transmission d'adresses de lecture de zones de cellules (MAADRD).

27. Mémoire intégrée à semiconducteurs suivant la revendication 25 ou 26, caratérisée par le fait que le décodeur d'enregistrement (DECWR) comporte R circuits OU (OR) comportant chacun deux entrées et une sortie, les premières entrées étant chargées en commun par le signal de test (Test), tandis que les autres entrées sont reliées au bus de transmission d'adresses d'entrée/sortie (IOAD) et que les sorties sont reliées au bus de transmission d'adresses d'enregistrement de zones de cellules (MAADWR).

28. Mémoire intégrée à semiconducteurs suivant la revendication 26 ou 27, caractérisée par la fait qu'un circuit OU (OR) comporte une porte NON-OU et un inverseur branché en aval de cette porte.

29. Mémoire intégrée à semiconducteurs suivant la revendication 26, caractérisée par le fait qu'un circuit ET (AND) comporte une porte NON-ET et un inverseur branché en aval de cette porte.

30. Mémoire intégrée à semiconducteurs suivant l'une des revendications 23 à 29, caractérisée par le fait qu'une première unité de lecture (RDU1) de chaque unité de lecture de zones de cellules (MARD) comporte deux multiplexeurs (MUXRD) et un étage de sortie (OUTRD),
que chaque multiplexeur (MUXRD) comporte R premières entrées pour respectivement une ligne d'entrée de données ($MARD_{p,r}$; $\overline{MARD}_{p,r}$) des R couples de lignes d'entrée de données ($MARD_{p,r}$, $\overline{MARD}_{p,r}$) ainsi que R secondes entrées pour le bus de transmission d'adresses de lecture de zones de cellules (MAADRD), dont les lignes sont associées aux lignes d'entrée de données ($MARD_{p,r}$; $\overline{MARD}_{p,r}$), et une sortie,
que dans les deux multiplexeurs (MUXRD), dans le mode de fonctionnement normal, celle des lignes d'entrée de données ($MARD_{p,r}$; $\overline{MARD}_{p,r}$), dont la ligne associée du bus de transmission d'adresses de lecture de zones de cellules (MAADRD) présente l'état activé, est interconnectée directement à la sortie respective,
que dans les deux multiplexeurs (MUXRD), dans le mode de fonctionnement de test, celle des lignes d'entrée de données ($MARD_{p,r}$; $\overline{MARD}_{p,r}$), à laquelle est associée la première ligne ($MAADRD_1$) du bus de transmission d'adresses de lecture de zones de cellules (MAADRD) avec son niveau logique constant, est interconnectée directement à la sortie,
que l'étage de sortie (OUTRD) est un étage d'attaque, dont la sortie constitue la sortie de l'ensemble de l'unité de lecture de zones de cellules de mémoire (AD), qui est reliée à l'une des lignes de transmission de données d'entrée/sortie du premier type (IO1) et qui présente sous forme amplifiée le signal, appliqué à la sortie de l'un des multiplexeurs (MUXRD).

31. Mémoire intégrée à semiconducteurs suivant la revendication 30, caractérisée par le fait que chaque multiplexeur (MUXRD) de la première unité de lecture (RDU1) comporte R portes NON-ET comportant chacune deux entrées, dont l'une constitue respectivement l'une des R premières entrées du multiplexeur (MUXRD) et dont l'autre constitue respectivement l'une des R secondes entrées du multiplexeur (MUXRD),
que chaque multiplexeur (MUXRD) de la première unité de lecture (RDU1) comporte une porte NON-ET supplémentaire comportant R entrées, qui sont reliées respectivement à une sortie des R portes NON-ET, et
que la sortie de la porte NON-ET supplémentaire constitue la sortie du multiplexeur respectif (MUXRD) de la première unité de lecture (RDU1).

32. Mémoire intégrée à semiconducteurs suivant la revendication 30 ou 31, caractérisée par le fait que l'étage de sortie (OUTRD) comporte deux circuits ET (AND) ayant chacun trois entrées et une sortie,
que la première entrée de chaque circuit ET (AND) est reliée à la sortie de l'un des multiplexeurs respectif (MUXRD), que la deuxième entrée de chaque circuit ET (AND) est reliée à la sortie de l'autre multiplexeur respectif (MUXRD), par l'intermédiaire d'un inverseur,
que les troisièmes entrées des circuits ET (AND) sont chargées par le signal de commande de lecture (RD), et
que l'étage de sortie (OUTRD) comporte un étage final, qui est relié, côté entrée, aux sorties des circuits ET (AND) et
dont la sortie constitue la sortie de l'étage de sortie (OUTRD) et de la première unité de lecture (RDU1).

33. Mémoire intégrée à semiconducteurs suivant la revendication 32, caractérisée par le fait qu'au moins l'un des circuits ET (AND) est une porte NON-ET en aval de laquelle est branché un inverseur.

34. Mémoire intégrée à semiconducteurs suivant l'une des revendications 30 à 33, caractérisée par le fait que les (R-1) autres unités de lecture (RDU2) comportent chacune un étage de sortie (OUTRD) comportant deux entrées et une sortie, qui constitue respectivement l'une des sorties pour les (R-1) lignes de transmission de données d'entrée/sortie du second type (IO2),
qu'en amont de chaque entrée d'un étage de sortie (OUTRD) est branché un circuit NON-ET comportant deux entrées, dont la première est reliée respectivement à l'une des deux lignes d'entrée de données ($\overline{MARD}_{p,2...R}$; $MARD_{p,2...R}$) des R couples de lignes d'entrée de données ($MARD_{p,r}$, $\overline{MARD}_{p,r}$) à l'exception du premier couple ($\overline{MAAD}_{p,1}$, $MARD_{p,1}$) de ces R couples et dont la seconde entrée est chargée par le signal de test (Test),

que dans le mode de fonctionnement normal, les sorties des (R-1) unités de lecture restantes (RDU2) sont branchées avec une forme valeur ohmique, et

que dans le mode de fonctionnement de test, à la sortie de chacune des (R-1) autres unités de lecture (RDU2) est présent, sous forme amplifiée, le signal qui est présent dans une ligne d'entrée de données ($MARD_{p,2..R}$) du couple respectif de lignes d'entrée de données ($MARD_{p,2..R}$, $\overline{MARD}_{p,2..R}$).

35. Mémoire intégrée à semiconducteurs suivant la revendication 34, caractérisée par le fait que les étages de sortie (OUTRD) des (R-1) autres unités de lecture (RDU2) sont identiques à l'étage de sortie (OUTRD) de la première unité de lecture (RDU1) de l'unité respective de lecture de zones de cellules (MARD).

36. Mémoire intégrée à semiconducteurs suivant l'une des revendications 23 à 35, caractérisée par les caractéristiques suivantes :
   - chacune des P unités d'enregistrement de zones de cellules (MAWR) est reliée, par une première entrée, à l'une des P lignes de transmission de données d'entrée/sortie du premier type (IO1) et est chargée, par une seconde entrée, par le signal de commande d'enregistrement (WR),
   - elle comporte, en outre, des entrées pour le bus de transmission d'adresses d'enregistrement de zones de cellules (MAADWR) et des sorties pour les R couples de lignes de sortie de données ($MAWR_{p,r}$, $\overline{MAWR}_{p,r}$),
   - dans le mode de fonctionnement normal, elle transmet une donnée, qui doit être enregistrée dans la mémoire et qui est appliquée sur la ligne respective de transmission de données d'entrée/sortie du premier type (IO1), et une donnée, complémentaire de la précédente, en fonction du signal de commande d'enregistrement (WR) et du bus de transmission d'adresses d'enregistrement de zones de cellules (MAADWR), au couple de lignes de sortie de données ($MAWR_{p,r}$, $\overline{MAWR}_{p,r}$), par rapport auquel une ligne du bus de transmission d'adresses d'enregistrement de zones de cellules (MAADWR) est activée,
   - dans le mode de fonctionnement de test, elle transmet la donnée appliquée à la ligne de transmission de données d'entrée/sortie du premier type (IO1), et la donnée complémentaire de la précédente, à l'ensemble des R couples de lignes de sortie de données ($MAWR_{p,r}$, $\overline{MAWR}_{p,r}$).

37. Mémoire intégrée à semiconducteurs suivant la revendication 36, caractérisée par les caractéristiques suivantes :
   - une unité d'enregistrement de zones de cellules (MAWR) comporte deux démultiplexeurs (DMUXWR) et un étage d'entrée (INWR),
   - l'étage d'entrée (INWR) est relié, par une première entrée, à la ligne respective de transmission d'entrée/sortie du premier type (IO1), et est chargée, par une seconde entrée, par le signal de commande d'enregistrement (WR),
   - lors de l'enregistrement, l'étage d'entrée (INWR) tire la même donnée et la donnée complémentaire de la donnée précédente, à partir de la donnée qui est à enregistrer et qui est appliquée sur la ligne de transmission de données d'entrée/sortie du premier type (IO1), et applique ces données ainsi dérivées, à deux sorties,
   - chaque démultiplexeur (DMUXWR) comporte R circuits ET (AND) comportant chacun deux entrées et une sortie,
   - toutes les premières entrées des circuits ET (AND) d'un démultiplexeur (DMUXWR) sont reliées à une sortie de l'étage d'entrée (INWR), et toutes les premières entrées des circuits ET (AND) de l'autre démultiplexeur (DMUXWR) sont reliées à l'autre sortie de l'étage d'entrée (INWR),
   - les secondes entrées des circuits ET (AND) des démultiplexeurs (DMUXWR) sont reliées au bus de transmission d'adresses d'enregistrement de zones de cellules (MAADWR),
   - les sorties des démultiplexeurs (DMUXWR) sont reliées aux R couples de lignes de sortie de données ($MAWR_{p,r}$, $\overline{MAWR}_{p,r}$)

38. Mémoire intégrée à semiconducteurs suivant la revendication 37, caractérisée par le fait qu'un étage d'entrée (INWR) comporte un dispositif tampon (BF) pour la donnée appliquée sur la ligne de transmission de données d'entrée/sortie du premier type (IO1), et qu'il comporte deux circuits ET (AND) comportant chacun deux entrées et une sortie, qui sont branchés en aval au dispositif tampon (BF), la première entrée d'un circuit ET (AND) étant reliée à une sortie du dispositif tampon (BF), tandis que la première entrée de l'autre circuit ET (AND) est reliée, par l'intermédiaire d'un inverseur, à la sortie du dispositif tampon (BF) et que les secondes entrées des circuits ET (AND) sont chargées par le signal de commande d'enregistrement (WR).

**39.** Mémoire intégrée à semiconducteurs suivant la revendication 37 ou 38, caractérisée par le fait qu'au moins l'un des circuits ET (AND) comporte une porte NON-ET à deux entrées, et un inverseur branché en aval de la porte NON-ET.

**40.** Mémoire intégrée à semiconducteurs suivant l'une des revendications 2 à 9, caractérisée par le fait qu'un bus de transmission de données d'entrée/sortie (IODB) comporte N couples de lignes de transmission de données, qui peuvent fonctionner de façon bidirectionnelle, pour l'enregistrement et la lecture, N étant une fraction entière de M.

**41.** Mémoire intégrée à semiconducteurs suivant l'une des revendications 2 à 9, caractérisée par le fait qu'un bus de transmission de données d'entrée/sortie (IODB) comporte N couples de lignes de transmission de données pour la lecture (IODB-RD$_{1...N}$, $\overline{\text{IODB-RD}}_{1...N}$) et N couple de lignes de transmission de données pour l'enregistrement (IODB-WR$_{1...N}$, $\overline{\text{IODB-WR}}_{1...N}$), N étant une fraction entière de M.

**42.** Mémoire intégrée à semiconducteurs suivant la revendication 40 ou 41, caractérisée par le fait que le bus de transmission d'adresses de groupes (GPAD) comporte Q signaux d'adresses de groupes (GPAD$_{q=1...Q}$), dont respectivement l'un d'eux présente un premier état logique et les autres un second état logique complémentaire du précédent, avec Q.N = M.

**43.** Mémoire intégrée à semiconducteurs suivant l'une des revendications 40 à 42, caractérisée par le fait qu'une unité d'entrée/sortie de groupes (GPIO) comporte un circuit de commande de groupes (GPCTRL), N unités d'enregistrement de groupes (GPWR) et N unités de lecture de groupes (GPRD), que le circuit de commande de groupes (GPCTRL) est relié, côté entrée, aux Q signaux de transmission d'adresses de groupes (GPAD$_{1...Q}$) et au signal de test (Test), qu'elle comporte des sorties pour Q signaux de sortie d'adresses de groupes (GPAD'$_{q=1...Q}$), auquel cas, dans le mode de fonctionnement de test, le premier signal de sortie d'adresses de groupes (GPAD'$_1$) présente un premier niveau logique et les autres signaux d'adresses de groupes (GPAD'$_{2...Q}$) présentent un second niveau logique, qui est complémentaire du premier niveau logique, et que, dans le mode de fonctionnement normal, les signaux de sortie d'adresses de groupes (GPAD'$_{1...Q}$) présentent les états logiques des signaux respectifs d'adresses de groupes (GPAD$_{1...Q}$).

**44.** Mémoire intégrée à semiconducteurs suivant la revendication 43, caractérisée par le fait que le circuit de commande de groupes (GPCTRL) comporte un circuit OU (OR) et Q-1 circuits ET (AND) ayant chacun deux entrées, que le premier (GPAD$_1$) des signaux d'adresses de groupes (GPAD$_{1...Q}$) est appliqué à une entrée du circuit OU (OR), que respectivement l'un des autres (GPAD$_{2...Q}$) signaux d'adresses de groupes (GPAD$_{1...Q}$) est appliqué aux premières entrées des circuits ET (AND), que le signal de test (Test) est appliqué à l'autre entrée du circuit OU (OR), qu'un signal complémentaire du signal de test (Test) est appliqué aux autres entrées des circuits ET (AND) et que les sorties du circuit OU (OR) et des circuits ET (AND) constituent les sorties du circuit de commande de groupes (GPCTRL).

**45.** Mémoire intégrée à semiconducteurs suivant la revendication 44, caractérisée par le fait que le circuit OU (OR) comporte une porte NON-OU à deux entrées, et un inverseur branché en aval de cette porte.

**46.** Mémoire intégrée à semiconducteurs suivant la revendication 44 ou 45, caractérisée par le fait qu'au moins un circuit ET (AND) comporte une porte NON-ET à deux entrées, et un inverseur branché en aval de cette porte.

**47.** Mémoire intégrée à semiconducteurs suivant l'une des revendications 43 à 46, caractérisée par les caractéristiques suivantes :
- une unité d'enregistrement de groupes (GPWR) comporte un couple d'entrées pour un couple de lignes de transmission de données (IODB-WR$_n$, $\overline{\text{IODB-WR}}_n$) du bus de transmission de données d'entrée/sortie IODB, qui est utilisé pour l'enregistrement,
- elle est, en outre, chargée, côté entrée, par les signaux de sortie d'adresses de groupes (GPAD'$_{1...Q}$) du circuit de commande de groupes (GPCTRL),
- elle comporte (Q-1) étages d'entrée de groupes (GPINWR) à une entrée qui est reliée à l'une de (Q-1) lignes de transmission de données d'entrée/sortie d'un troisième type (IO3),

- elle comporte une autre entrée pour le signal de commande d'enregistrement (WR),
- lors de l'enregistrement, chaque étage d'entrée de groupe (GPINWR) dérive, à partir d'une donnée qui doit être enregistrée dans la mémoire et qui est appliquée à cet étage d'entrée par l'intermédiaire de la ligne respective de transmission de données d'entrée/sortie du troisième type (IO3), la même donnée et une donnée complémentaire de la précédente, et applique ces données dérivées aux deux sorties,
- en aval de chaque sortie d'un étage d'entrée de groupes (GPINWR) est branché un circuit logique (LOGWR) à deux entrées, dont l'une est reliée à la sortie respective de l'étage d'entrée de groupes (GPINWR) et dont l'autre est chargée par le signal de test (Test),
- dans le mode de fonctionnement normal, aux sorties (GPD$_2$, $\overline{GPD}_2$; ..., GPD$_Q$, $\overline{GPD}_Q$) de deux circuits logiques (LOGWR) d'un étage d'entrée de groupes (GPINWR) est appliqué un signal présentant le même niveau logique, tandis que dans le mode de fonctionnement de test, la donnée dérivée complémentaire est appliquée à la sortie (GPD$_{2...Q}$) d'un circuit logique (LOGWR) et que la donnée dérivée est appliquée à la sortie ($\overline{GP}_{2...Q}$) de l'autre circuit logique (LOGWR),
- chaque unité d'enregistrement de groupes (GPWR) comporte, en outre, deux démultiplexeurs (GPDMUXWR), dont chacun a Q entrées pour les signaux de sortie d'adresses de groupes (GPAD'$_{1...Q}$), ainsi qu'une autre entrée, qui constitue l'une des deux entrées du couple d'entrées pour le couple respectif de lignes de transmission de données (IODB-WR$_n$, $\overline{IODB\text{-}WR}_n$), prévu pour l'enregistrement, du bus de transmission de données d'entrée/sortie (IODB),
- en outre, chaque démultiplexeur (GPDMUXWR) comporte (Q-1) entrées supplémentaires, dont chacune, dans un démultiplexeur (DPDMUXWR), est reliée à la sortie (GPD$_{2...Q}$) d'un circuit logique respectif (LOGWR) et dont chacune, dans l'autre démultiplexeur (GPDMUXWR), est reliée à la sortie ($\overline{GPD}_{2...Q}$) de l'autre circuit logique respectif (LOGWR),
- chaque démultiplexeur (GMDMUXWR) comporte Q sorties,
- les sorties des démultiplexeurs (GPDMUXWR) sont reliées à Q couples de lignes de transmission de données de M couples de lignes de transmission de données, prévus pour l'enregistrement, du bus de transmission de données de groupes (GPDB),
- dans le mode de fonctionnement normal, lors de l'enregistrement, chaque unité d'enregistrement de groupes (GPWR) transmet directement les données, qui sont appliquées au couple de lignes de transmission de données (IODB-WR$_n$, $\overline{IODB\text{-}WR}_n$), reliés côté entrée à cette unité, du bus de transmission de données d'entrée/sortie (IODB), aux deux sorties, par rapport auxquelles l'un des signaux d'adresses de groupes (GPAD$_q$) et ainsi le signal de sortie d'adresses de groupes (GPAD'$_q$), associé au signal précédent, du circuit de commande de groupe (CPCTRL) sont activés,
- dans le mode de fonctionnement de test, lors de l'enregistrement, chaque unité d'enregistrement de groupes (GPWR) transmet les données qui sont appliquées au couple de lignes de transmission de données (IODB-WR$_n$, $\overline{IODB\text{-}WR}_n$), relié côté entrée à cette unité, du bus de transmission de données d'entrée/sortie (IODB), ainsi que les données dérivées des données, qui sont appliquées à leurs étages d'entrée de groupes (GPINWR), des lignes de transmission de données d'entrée/sortie du troisième type (IO3), à une sortie respective, et ainsi globalement à une partie (N) du bus de transmission de données de groupes (GPDB). 48.

48. Mémoire intégrée à semiconducteurs suivant la revendication 47, caractérisée par les caractéristiques suivantes :
   - chaque démultiplexeur (GPDMUXWR) comporte un circuit ET (AND) et (Q-1) unités logiques (LU), qui comportent chacune une sortie, qui constitue l'une des Q sorties du démultiplexeur respectif (GPDMUXWR),
   - chaque circuit ET (AND) comporte deux entrées et chaque unité logique (LU) comporte trois entrées,
   - les premières entrées du circuit ET (AND) et des unités logiques (LU) de chaque démultiplexeur (GPDMUXW) sont reliées à une autre entrée du démultiplexeur respectif (GPDMUXWR),
   - les secondes entrées du circuit ET (AND) et des unités logiques (LU) des démultiplexeurs (GPDMUXWR) sont reliées respectivement à l'une des Q entrées du démultiplexeur respectif (GPDMUXWR),
   - les troisièmes entrées des unités logiques (LU) des démultiplexeurs (GPDMUXWR) constituent les (Q-1) entrées supplémentaires du démultiplexeur respectif (GPDMUXWR).

49. Mémoire intégrée à semiconducteurs suivant la revendication 48, caractérisée par le fait qu'un circuit ET (AND) comporte une porte NON-ET comportant les deux entrées du circuit ET (AND), ainsi qu'un inverseur branché en aval de cette porte.

EP 0 527 866 B1

**50.** Mémoire intégrée à semiconducteurs suivant la revendication 48 ou 49, caractérisée par le fait qu'une unité logique (LU) comporte une première porte NON-ET à deux entrées, qui constituent les deux premières entrées de l'unité logique (LU), qu'à la première porte NON-ET est associée une seconde porte NON-ET comportant également deux entrées, une première entrée étant reliée à la sortie de la première porte NON-ET tandis que l'autre entrée constitue la troisième entrée de l'unité logique (LU).

**51.** Mémoire intégrée à semiconducteurs suivant l'une des revendications 47 à 50, caractérisée par le fait qu'un étage d'entrée de groupes (GPINWR) comporte un dispositif tampon (BF) servant à mémoriser temporairement la donnée appliquée par l'intermédiaire de la ligne respective de transmission de données d'entrée/sortie du troisième type (IO3).

**52.** Mémoire intégrée à semiconducteurs suivant l'une des revendications 47 à 51, caractérisée par le fait qu'un étage d'entrée de groupe (GPINWR) comporte deux circuits ET (AND) ayant chacun deux entrées, la donnée appliquée à la ligne respective de transmission de données d'entrée/sortie du troisième type (IO3) étant envoyée à une entrée d'un circuit ET (AND), la donnée appliquée à la ligne respective de transmission de données d'entrée/sortie du troisième type (IO3) étant envoyée, sous forme inversée, à une entrée de l'autre circuit ET (AND), et les autres entrées des circuits ET (AND) étant chargées par le signal de commande d'enregistrement (WR).

**53.** Mémoire intégrée à semiconducteurs suivant l'une des revendications 43 à 52, caractérisée par les caractéristiques suivantes :
- une unité de lecture de groupes (GPRD) comporte Q couples d'entrée de données, qui sont reliés à un nombre correspondant de couples de lignes de transmission de données (GPDB-RD$_{n,1...Q}$, $\overline{\text{GPDB-RD}}_{n,1...Q}$), prévus pour la lecture, du bus respectif de transmission de données de groupes (GPDB),
- elle comporte des entrées d'adresses pour les signaux de sortie d'adresses de groupes (GPAD'$_{1...Q}$) du circuit de commande de groupes (GPCTRL), chaque signal de sortie d'adresses de groupes (GPAD'$_{1...Q}$) étant associé à l'un des Q couples d'entrée de données, ainsi que
- des entrées pour le signal de commande de lecture (RD) et pour le signal de test (Test),
- une unité de lecture de groupes (GPRD) comporte, en outre, un couple de sorties pour un couple de lignes de transmission de données (IODB-RD$_n$, $\overline{\text{IODB-RD}}_n$) du bus de transmission de données d'entrée/sortie (IODB), qui est utilisé pour la lecture,
- en outre, elle comporte (Q-1) sorties, qui sont reliées aux lignes de transmission de données d'entrée/sortie du troisième type (IO3),
- dans le mode de fonctionnement normal, des données de celui des Q couples d'entrée de données, dont l'entrée d'adresses associée présente le premier niveau logique, que présentent l'un des Q signaux d'adresses de groupes (GPAD$_{1...Q}$) et ainsi également l'un des Q signaux de sortie d'adresses de groupes (GPAD'$_{1...Q}$) du circuit de commande de groupes (GPCTRL), sont transmises au couple de sorties, qui est relié à un couple de lignes de transmission de données (IODB-RD$_n$, $\overline{\text{IODB-RD}}_n$) du bus de transmission de données d'entrée/sortie (IODB),
- dans le mode de fonctionnement de test, des données appliquées au premier couple des entrées de données, sont transmises au couple de sorties, qui est relié à un couple de lignes de transmission de données (IODB-RD$_n$, $\overline{\text{IODB-RD}}_n$) du bus de transmission de données d'entrée/sortie (IODB),
- en outre, dans le mode de fonctionnement de test, les données appliquées aux (Q-1) autres entrées de données sont transmises aux (Q-1) sorties qui sont reliées aux lignes de transmission de données d'entrée/sortie du troisième type (IO3).

**54.** Mémoire intégrée à semiconducteurs suivant la revendication 53, caractérisée par les carctéristiques suivantes :
- une unité de lecture de groupes (GPRD) comporte deux multiplexeurs (GPMUXRD), 2.(Q-1) unités logiques (LOGRD) et (Q-1) étages de sortie de groupes (GPOUTRD),
- chaque multiplexeur (GPMUXRD) est relié, côté entrée, à Q lignes respectives de transmission de données (GPDB-RD$_{n,1...Q}$; $\overline{\text{GPDB-RD}}_{n,1...Q}$) de l'ensemble des Q couples de lignes de transmission de donnéees (GPDB-RD$_{n,1...Q}$; $\overline{\text{GPDB-RD}}_{n,1...Q}$), prévus pour la lecture, d'une partie (N) du bus de transmission de données de groupes (GPDB),
- il est relié, côté entrée, aux entrées d'adresses de l'unité de lecture de groupes (GPRD) pour les signaux de sortie d'adresses de groupes (GPAD'$_{1...Q}$) du circuit de commande de groupes (GPCTRL),
- il comporte une sortie, qui, en tant que sortie de l'unité de lecture de groupes (GPRD), est reliée à l'une (IODB-RD$_n$; $\overline{\text{IODB-RD}}_n$) des lignes du couple de lignes de transmission de données (IODB-RD$_n$;

$\overline{\text{IODB-RD}}_n$) du bus de transmission de données d'entrée/sortie (IODB),

- dans le mode de fonctionnement normal, la donnée, qui est appliquée à la ligne respective de transmission de données d'un tel couple faisant partie des Q couples de lignes de transmission de données, dont le signal associé de sortie d'adresses de groupes (GPAD'$_{1...Q}$) présente le premier niveau logique, est transmise à la sortie reliée au bus de transmission de données d'entrée/sortie (IODB),
- dans le mode de fonctionnement de test, la donnée, qui est appliquée à la ligne respective de transmission de données (GPDB-RD$_{n,1}$; $\overline{\text{GPDB-RD}}_n,1$) du premier couple (GPDB-RD$_{n,1}$; $\overline{\text{GPDB-RD}}_n,1$) de lignes de transmission de données de la partie (N) du bus de transmission de données de groupes (GPDB), est transmise à la sortie respective.

55. Mémoire intégrée à semiconducteurs suivant la revendication 54, caractérisée par le fait qu'une unité logique (LOGRD) est une porte NON-ET à deux entrées,

que respectivement deux unités logiques (LOGRD) sont réunies de façon fonctionnelle de telle sorte que leurs premières entrées sont reliées à une ligne respective de transmission de données (GPDB-RD$_{n,2,...Q}$; $\overline{\text{GPDB-RD}}_{n,2,...Q}$) de l'un des (Q-1) couples de lignes de transmission de données (GPDB-RD$_{n,2,...Q}$; $\overline{\text{GPDB-}}$ $\overline{\text{RD}}_{n,2,...Q}$), prévus pour la lecture, de la partie (N) du bus de transmission de données de groupes (GPDB), que leurs secondes entrées sont reliées au signal de test (Test),

que leurs sorties constituent simultanément des entrées de l'étage de sortie de groupes (GPOUTRD), branché en aval de cette unité.

56. Mémoire intégrée à semiconducteurs suivant la revendication 55, caractérisée par les caractéristiques suivantes :
   - un étage de sortie de groupes (GPOUTRD) comporte deux circuits ET (AND) comportant chacun trois entrées, et un étage final branché en aval des deux circuits ET (AND),
   - les premières entrées des circuits ET (AND) sont reliées, par l'intermédiaire d'un inverseur, à la sortie d'une unité logique respective (LOGRD),
   - les deuxièmes entrées des circuits ET (AND) sont reliées à la sortie de l'autre unité logique respective (LOGRD),
   - les troisièmes entrées sont chargées par le signal de commande de lecture (RD),
   - la sortie de l'étage final constitue la sortie de l'étage de sortie de groupes (GPOUTRD), qui constitue simultanément l'une des (Q-1) sorties de l'unité de lecture de groupes (GPRD).

57. Mémoire intégrée à semiconducteurs suivant la revendication 40 ou 41, caractérisée par les caractéristiques suivantes :
   - dans le cas de la mémoire à semiconducteurs, la totalité des U bus de transmission de données d'entrée/sortie (IODB) munis de N couples respectifs de lignes de transmission de données pour l'enregistrement et la lecture sont globalement répartis, avec leurs couples de lignes de transmission de données, en P bus de transmission de données de zones de cellules (MADB), comportant respectivement R couples de lignes de transmission de sortie de données pour l'enregistrement (MADB-WR$_{1...P,1...R}$, $\overline{\text{MADB-WR}}_{1...P,1...R}$) et de lignes d'entrée de données pour la lecture (MADB-RD$_{1...P,1...R}$, $\overline{\text{MADB-RD}}_{1...P,1...R}$), avec pour ce qui concerne l'ensemble du dispositif :
   U.N = P.R, avec N = M/Q,
   - l'unité d'entrée/sortie de zones de cellules (MAIO) comporte P unités de lecture de zones de cellules (MARD) comportant respectivement R unités de lecture (RDU1; RDU2), P unités d'enregistrement de zones de cellules (MAWR), qui sont associées respectivement à l'une des P unités de lecture de zones de cellules (MARD), et qui comportent respectivement R unités d'enregistrement (WRU1; WRU2), ainsi qu'un circuit de commande de zones de cellules (MACTRL),
   - chaque unité de lecture de zones de cellules (MARD) comporte les R couples de lignes d'entrée de données (MADB-RD$_{p,r}$, $\overline{\text{MADB-RD}}_{p,r}$) de l'un des P bus de transmission de données de zones de cellules (MADB),
   - chaque unité d'enregistrement de zones de cellules (MAWR) comporte les R couples de lignes de sortie de données (MADB-WR$_{p,r}$, $\overline{\text{MADB-WR}}_{p,r}$) du bus de transmission de données de zones de cellules (MADB), avec p = 1...P et r = 1... R,
   - chaque unité de lecture de zones de cellules (MARD) est reliée, par une sortie, à l'une des lignes de transmission de données d'entrée/sortie du premier type (IO1) et à une entrée de données de l'unité d'enregistrement de zones de cellules (MAWR), qui lui est associée,
   - chaque unité de lecture de zones de cellules (MARD) comporte en outre des sorties pour (R-1) lignes de transmission de données d'entrée/sortie du second type (IO2),

EP 0 527 866 B1

- toutes les unités de lecture de zones de cellules (MARD) sont chargées en commun par le signal de commande de lecture (RD),
- toutes les unités d'enregistrement de zones de cellules (MAWR) sont chargées en commun par le signal de commande d'enregistrement (WR),
- toutes les unités de lecture de zones de cellules (MARD), toutes les unités d'enregistrement de zones de cellules (MAWR) et le circuit de commande de zones de cellules (MACTRL) sont chargés en commun par le signal de test (Test),
- toutes les unités de lecture de zones de cellules (MARD) et toutes les unités d'enregistrement de zones de cellules (MAWR) sont reliées en commun à un bus de transmission d'adresses de zones de cellules (MAAD), en sorte que toutes les unités de lecture de zones de cellules (MARD) et toutes les unités d'enregistrement de zones de cellules (MAWR) peuvent fonctionner en commun,
- le circuit de commande de zones de cellules (MACTRL) est un circuit servant à générer le bus de transmission d'adresses de zones de cellules (MAAD) à partir du bus de transmission d'adresses d'entrée/sortie (IOAD), sous la commande du signal de test (Test), le bus de transmission d'adresses de zones de cellules (MAAD) comportant R lignes de transmission d'adresses $(MAAD_{1...R})$.

58. Mémoire intégrée à semiconducteurs suivant la revendication 57, caractérisée par le fait que respectivement un couple de lignes d'entrée de données $(MADB\text{-}RD_{p,r}, \overline{MADB\text{-}RD}_{p,r})$ et un couple de lignes de sortie de données $(MADB\text{-}WR_{p,r}, \overline{MADB\text{-}WR}_{p,r})$, sont réalisés sous la forme d'un seul couple de lignes de transmission de données, que l'on peut faire fonctionner de façon bidirectionnelle.

59. Mémoire intégrée à semiconducteurs suivant la revendication 57 ou 58, caractérisée par le fait que le circuit de commande de zones de cellules (MACTRL) est un décodeur, qui, dans le mode de fonctionnement normal, interconnecte le bus de transmission d'adresses d'entrée/sortie (IOAD) au bus de transmission d'adresses de zones de cellules (MAAD), et que dans le mode de fonctionnement de test, au moyen du signal de test (Test), une première ligne $(MAAD_1)$ du bus de transmission d'adresses de zones de cellules (MAAD) présente un niveau logique constant, tandis que les autres lignes du bus de transmission d'adresses de zones de cellules (MAAD) présentent un niveau logique qui est complémentaire du niveau logique de la première ligne $(MAAD_1)$ et qui est également constant.

60. Mémoire intégrée à semiconducteurs suivant la revendication 59, caractérisée par le fait que le circuit de commande de zones de cellules (MACTRL) comporte un circuit OU (OR) à deux entrées et une sortie, l'une des entrées étant chargée par le signal de test (Test), tandis que l'autre entrée est reliée à une première ligne du bus de transmission d'adresses d'entrée/sortie (IOAD) et la sortie est reliée à la première ligne du bus de transmission d'adresses de zones de cellules (MAAD), et que le circuit de commande de zones de cellules (MACTRL) comporte (R-1) circuits ET (AND) à respectivement deux entrées et une sortie, respectivement l'une des entrées étant chargée par un signal complémentaire du signal de test (Test), tandis que chacune des autres entrées est reliée à l'une des (R-1) autres lignes du bus de transmission d'adresses d'entrée/sortie (IOAD) et que chacune des sorties est reliée à l'une des (R-1) autres lignes du bus de transmission d'adresses de zones de cellules (MAAD).

61. Mémoire intégrée à semiconducteurs suivant la revendication 60, caractérisée par le fait que le circuit OU (OR) comporte une porte NON-OU et un inverseur branché en aval de cette porte.

62. Mémoire intégrée à semiconducteurs suivant la revendication 60, caractérisé par le fait qu'un circuit ET (AND) comporte une porte NON-ET et un inverseur branché en aval de cette porte.

63. Mémoire intégrée à semiconducteurs suivant l'une des revendications 57 à 62, caractérisée par le fait qu'une première unité de lecture (RDU1) de chaque unité de lecture de zones de cellules (MARD) comporte deux multiplexeurs (MUXRD) et un étage de sortie (OUTRD),
que chaque multiplexeur (MUXRD) comporte R premières entrées pour respectivement une ligne d'entrée de données $(MADB\text{-}RD_{p,r}; \overline{MADB\text{-}RD}_{p,r})$ des R couples de lignes d'entrée de données $(MADB\text{-}RD_{p,r}; \overline{MADB\text{-}RD}_{p,r})$ ainsi que R secondes entrées pour le bus de transmission d'adresses de zones de cellules (MAAD), dont les lignes sont associées aux lignes d'entrée de données $(MADB\text{-}RD_{p,r}; \overline{MADB\text{-}RD}_{p,r})$, et une sortie,
que dans les deux multiplexeurs (MUXRD), dans le mode de fonctionnement normal, celle des lignes d'entrée de données $(MADB\text{-}RD_{p,r}; \overline{MADB\text{-}RD}_{p,r})$, dont la ligne associée du bus de transmission d'adresses de zones de cellules (MAAD) présente un état électrique activé, est interconnectée directement à la sortie respective,

61

que dans le cas des deux multiplexeurs (MUXRD), dans le mode de fonctionnement de test, celle des lignes d'entrées de données (MADB-RD$_{p,r}$; $\overline{\text{MADB-RD}}_{p,r}$), à laquelle est associée la première ligne (MAAD$_1$) du bus de transmission d'adresses de zones de cellules (MAAD) ayant un niveau logique constant, est interconnectée directement à la sortie,

que l'étage de sortie (OUTRD) est un étage d'attaque, dont la sortie constitue la sortie, reliée à l'une des lignes de transmission de données d'entrée/sortie du premier type (IO1), de l'ensemble de l'unité de lecture de zones de cellules (MARD) et fournit, sous forme amplifiée, le signal présent à la sortie d'un multiplexeur (MUXRD).

64. Mémoire intégrée à semiconducteurs suivant la revendication 63, caractérisée par le fait que chaque multiplexeur (MUXRD) de la première unité de lecture (RDU1) comporte R portes NON-ET ayant chacune deux entrées, dont l'une constitue respectivement l'une des R premières entrées du multiplexeur (MUXRD) et dont l'autre constitue respectivement l'une des R secondes entrées du multiplexeur (MUXRD),

que chaque multiplexeur (MUXRD) de la première unité de lecture (RDU1) comporte une porte NON-ET supplémentaire à R entrées, qui sont reliées respectivement à une sortie des R portes NON-ET, et

que la sortie de la porte NON-ET supplémentaire constitue la sortie du multiplexeur respectif (MUXRD) de la première unité de lecture (RDU1).

65. Mémoire intégrée à semiconducteurs suivant l'une des revendications 63 ou 64, caractérisée par le fait que l'étage de sortie (OUTRD) comporte deux circuits ET (AND) ayant chacun trois entrées et une sortie,

que la première entrée respective de chaque circuit ET (AND) est reliée à la sortie d'un multiplexeur respectif (MUXRD), que la seconde entrée respective de chaque circuit ET (AND) est reliée à la sortie de l'autre multiplexeur respectif (MUXRD), par l'intermédiaire d'un inverseur,

que les troisièmes entrées des circuits ET (AND) sont chargées par le signal de commande de lecture (RD), et

que l'étage de sortie (OUTRD) comporte un étage final, qui est relié, côté entrée, aux sorties des circuits ET (AND), et

dont la sortie constitue la sortie de l'étage de sortie (OUTRD) et de la première unité de lecture (RDU1).

66. Mémoire intégrée à semiconducteurs suivant la revendication 65, caractérisée par le fait qu'au moins l'un des circuits ET (AND) est une porte NON-ET en aval de laquelle est branché un inverseur.

67. Mémoire intégrée à semiconducteurs suivant l'une des revendications 63 à 66, caractérisé par le fait que les (R-1) autres unités de lecture (RDU2) comportent chacune un étage de sortie (OUTRD) à deux entrées et une sortie, qui constitue respectivement l'une des sorties pour les (R-1) lignes de transmission de données d'entrée/sortie du deuxième type (IO2),

qu'en amont de chaque entrée d'un étage de sortie (OUTRD) est branché un circuit NON-ET à deux entrées, dont la première entrée est reliée à l'une des deux lignes d'entrée de données ($\overline{\text{MADB-RD}}_{p,2...R}$, MADB-RD$_{p,2...R}$) de l'un des R couples de lignes d'entrée de données (MADB-RD$_{p,r}$, $\overline{\text{MADB-RD}}_{p,r}$), à l'exception du premier couple (MADB-RD$_{p,1}$, $\overline{\text{MADB-RD}}_{p,1}$) de ces R couples et dont la seconde entrée est chargée par le signal de test (Test),

que dans le mode de fonctionnement normal, les sorties des (R-1) autres unités de lecture (RDU2) sont branchées avec une forte valeur ohmique, et

que dans le mode de fonctionnement de test, à la sortie de chacune des (R-1) autres unités de lecture (RDU2) est appliqué, sous forme amplifiée, le signal appliqué à une ligne de transmission d'entrée de données (MADB-RD$_{p,2...R}$) du couple respectif de lignes de transmission de données ( MADB-RD$_{p,2...R}$, $\overline{\text{MADB-RD}}_{p,2...R}$)

68. Mémoire intégrée à semiconducteurs suivant la revendication 67, caractérisée par le fait que les étages de sortie (OUTRD) des (R-1) autres unités de lecture (RDU2) sont identiques à l'étage de sortie (OUTRD) de la première unité de lecture (RDU1) de l'unité respective de lecture de zones de cellules (MARD).

69. Mémoire intégrée à semiconducteurs suivant l'une des revendications 57 à 68, caractérisée par les caractéristiques suivantes :
   - chacune des P unités d'enregistrement de zones de cellules (MAWR) est reliée, par une première entrée, à l'une des P lignes de transmission de données d'entrée/sortie du premier type (IO1) et est chargée, au niveau de sa seconde entrée, par le signal de commande d'enregistrement (WR),
   - elle comporte, en outre, des troisièmes entrées pour le bus de transmission d'adresses de zones de cellules (MAAD) et des sorties pour les R couples de lignes de sortie de données (MADB-WR$_{p,r}$, $\overline{\text{MADB-WR}}_{p,r}$),

- dans le mode de fonctionnement normal, elle transmet une données, qui doit être enregistrée dans la mémoire et est appliquée sur la ligne respective de transmission de données d'entrée/sortie du premier type (IO1) et une donnée complémentaire de la précédente, en fonction du signal de commande d'enregistrement (WR) et du bus de transmission d'adresses de zones de cellules (MAAD), au couple de lignes de sorties de données (MADB -WR$_{p,r}$, $\overline{\text{MADB-WR}}_{p,r}$), par rapport auquel sont activées une ligne du bus de transmission d'adresses de zones de cellules (MAAD) et ainsi une ligne du bus de transmission d'adresses d'entrée/sortie (IOAD),

- dans le mode de fonctionnement de test, elle transmet la donnée appliquée sur la ligne de transmission de données d'entrée/sortie du premier type (IO1), et la donnée, complémentaire de la précédente, à l'ensemble des R couples de lignes de sortie de données (MADB-WR$_{p,r}$, $\overline{\text{MADB-WR}}_{p,r}$).

70. Mémoire intégrée à semiconducteurs suivant la revendication 69, caractérisée par les caractéristiques suivantes :
- une unité d'enregistrement de zones de cellules (MAWR) comporte deux démultiplexeurs (DMUXWR) et un étage d'entrée (INWR),
- l'étage d'entrée (INWR) est relié, par une première entrée, à la ligne respective de transmission de données d'entrée/sortie du premier type (IO1) et est chargé, au niveau d'une seconde entrée, par le signal de commande d'enregistrement (WR),
- l'étage d'entrée (INWR) dérive, à partir de la donnée à enregistrer et appliquée sur la ligne de transmission de données d'entrée/sortie du premier type (IO1), cette même donnée et la donnée qui en est complémentaire, et applique ces données dérivées à deux sorties,
- chaque démultiplexeur (DMUXWR) comporte R circuits ET (AND) ayant chacun deux entrées et une sortie,
- toutes les premières entrées des circuits ET (AND) d'un démultiplexeur (DMUXWR) sont reliées à une sortie de l'étage d'entrée (INWR), et toutes les premières entrées des circuits ET (AND) de l'autre démultiplexeur (DMUXWR) sont reliées à l'autre entrée de l'étage d'entrée (INWR),
- les secondes entrées des circuits ET (AND) des deux démultiplexeurs (DMUXWR) sont reliées au bus de transmission d'adresses de zones de cellules (MAAD),
- les sorties des démultiplexeurs (DMUXWR) sont reliées aux R couples de lignes de transmission de sortie de données (MADB-WR$_{p,r}$, $\overline{\text{MADB-WR}}_{p,r}$).

71. Mémoire intégrée à semiconducteurs suivant la revendication 70, caractérisée par le fait qu'un étage d'entrée (INWR) comporte un dispositif tampon (BF) pour la donnée appliquée sur la ligne de transmission de données d'entrée/sortie du premier type (IO1), et qu'il comporte deux circuits ET (AND) qui ont chacun deux entrées et une sortie et qui sont branchés en aval du dispositif tampon (BF), la première entrée d'un circuit ET (AND) étant reliée à une sortie du dispositif tampon (BF), tandis que la première entrée de l'autre circuit ET (AND) est reliée, par l'intermédiaire d'un inverseur, à la sortie du dispositif tampon (BF) et que les secondes entrées des circuits ET (AND) sont chargées par le signal de commande d'enregistrement (WR).

72. Mémoire intégrée à semiconducteurs suivant l'une des revendications 69 à 71, caractérisée par le fait qu'au moins l'un des circuits ET (AND) comporte une porte NON-ET comportant deux entrées et un inverseur branché en aval de la porte NON-ET.

73. Mémoire intégrée à semiconducteurs suivant l'une des revendications 57 à 68, caractérisée par les caractéristiques suivantes :
- chacune des P unités d'enregistrement de zones de cellules (MAWR) est reliée, par une première entrée, à l'une des P lignes de transmission de données d'entrée/sortie du premier type (IO1),
- elle est reliée, au niveau de (R-1) autres premières entrées, à respectivement l'une des lignes de transmission de données d'entrée/sortie du deuxième type (IO2),
- une seconde entrée est chargée par le signal de commande d'enregistrement (WR),
- elle comporte, en outre, des troisièmes entrées pour le bus de transmission d'adresses de zones de cellules (MAAD) et des sorties pour les R couples de lignes de sortie de données (MADB-WR$_{p,r}$, $\overline{\text{MADB-WR}}_{p,r}$), de l'un des bus de transmission de données de zones de cellules (MADB),
- dans le mode de fonctionnement normal, elle transmet une donnée, qui doit être enregistrée dans la mémoire et qui est appliquée sur la ligne respective de transmission de données d'entrée/sortie

du premier type (IO1), et une donnée complémentaire à la précédente, en fonction du signal de commande de mémoire (WR) et du bus de transmission d'adresses de zones de cellules (MAAD), au couple de lignes de transmission de données (MADB-WR$_{p,r}$, $\overline{\text{MADB-WR}}_{p,r}$), par rapport à laquelle sont activées une ligne du bus de transmission d'adresses d'entrée/sortie (IOAD) et ainsi une ligne du bus de transmission d'adresses de zones de cellules (MAAD),

- dans le mode de fonctionnement de test, elle transmet, d'une part, la donnée appliquée à la ligne de transmission de données d'entrée/sortie du premier type IO1, et la donnée complémentaire de la précédente, au premier couple (MADB-WR$_{p,1}$, $\overline{\text{MADB-WR}}_{p,1}$) des R couples de lignes de sortie de données (MADB-WR$_{p,r}$, $\overline{\text{MADB-WR}}_{p,r}$),

- d'autre part, dans le mode de fonctionnement de test, elle transmet des données appliquées aux (R-1) autres premières entrées, et une donnée respectivement complémentaire de la précédente, à un couple respectif (MADB-WR$_{p,2...,R}$, $\overline{\text{MADB-WR}}_{p,2...,R}$) des (R-1) autres couples de lignes de sortie de données (MADB-WR$_{p,2...,R}$, $\overline{\text{MADB-WR}}_{p,2...,R}$) des R couples de lignes de sortie de données (MADB-WR$_{p,1}$, $\overline{\text{MADB-WR}}_{p,1}$).

74. Mémoire intégrée à semiconducteurs suivant la revendication 73, caractérisée par les caractéristiques suivantes :

- une unité d'enregistrement de zones de cellules (MAWR) comporte deux démultiplexeurs (DMUXWR) et R étages d'entrée (INWR),

- le premier des étages d'entrée (INWR) est relié, au niveau d'une première entrée, à la ligne de transmission de données d'entrée/sortie du premier type (IO1), qui est chargée, lors de l'enregistrement, par une donnée à enregistrer,

- les (R-1) autres étages d'entrée (INWR) sont reliés, par une première entrée respective, à une ligne respective de transmission de données d'entrée/sortie du deuxième type (IO2), qui, lors de l'enregistrement, est chargée par une donnée respective à enregistrer,

- chaque étage d'entrée (INWR) est chargé, au niveau d'une seconde entrée, par le signal de commande d'enregistrement (WR),

- chaque étage d'entrée (INWR) comporte deux sorties,

- dans le cas où le signal de commande d'enregistrement (WR) est activé, la donnée appliquée à la première entrée de cet étage est appliquée à une sortie,

- dans le cas où le signal de commande d'enregistrement (WR) est activé, la donnée complémentaire de la donnée précédente est appliquée à l'autre sortie,

- dans chacun des (R-1) autres étages d'entrée (INWR), en aval des deux sorties de ces étages, est branché respectivement un circuit logique (LOGWR) comportant deux entrées et une sortie (MAD$_{2,...,R}$; $\overline{\text{MAD}}_{2,...,R}$), dont une entrée est reliée à la sortie respective qui fait partie des deux sorties de l'étage d'entrée (INWR) et dont l'autre entrée est chargée par le signal de test (Test),

- dans le mode de fonctionnement normal, aux sorties (MAD$_{2,...,R}$; $\overline{\text{MAD}}_{2,...,R}$') de tous les circuits logiques (LOGW1), qui sont branchés en aval des (R-1) autres étages d'entrée (INWR), sont appliqués des signaux présentant des niveaux logiques identiques, tandis que dans le mode de fonctionnement de test, en rapport avec chacun des (R-1) autres étages d'entrée (INWR), la donnée respectivement complémentaire est appliquée à la sortie (MAD$_{2,...,R}$; $\overline{\text{MAD}}_{2,...,R}$) d'un circuit logique (LOGWR) et la donnée respective à enregistrer est appliquée à la sortie (MAD$_{2,...,R}$; $\overline{\text{MAD}}_{2,...,R}$) de l'autre circuit logique (LOGWR),

- chaque démultiplexeur (DMUXWR) comporte un circuit ET (AND) à deux entrées et (R-1) unités logiques (LU) à trois entrées ainsi que R sorties,

- dans un démultiplexeur (DMUXWR), la première entrée du circuit ET (AND) et les premières entrées des unités logiques (LU) sont reliées à une sortie du premier étage d'entrée (INWR), dans l'autre démultiplexeur (DMUXWR), la première entrée du circuit ET (AND) et les premières entrées des unités logiques (LU) sont reliées à l'autre sortie du premier étage d'entrée (INWR),

- dans les deux démultiplexeurs (DMUXWR), les secondes entrées des circuits ET (AND) et les secondes entrées des unités logiques (LU) sont reliées à une ligne respective (MAD$_{1,...,R}$) du bus de transmission d'adresses de zones de cellules (MAAD),

- dans un démultiplexeur (DMUXWR), les troisièmes entrées des unités logiques (LU) sont reliées à la sortie (MAD$_{2...R}$) d'un circuit logique (LOGWR) branché en aval de l'un respectif des (R-1) autres étages d'entrée (WR),

- dans l'autre démultiplexeur (DMUXWR), les troisièmes entrées des unités logiques (LU) sont reliées à la sortie ($\overline{\text{MAD}}_{2,...,R}$) de l'autre circuit logique (LOGWR) branché en aval de l'un respectif des (R-1) autres étages d'entrée (INWR),

- chaque démultiplexeur (DMUXWR) comporte R sorties, qui sont globalement les sorties de l'unité d'enregistrement de zones de cellules (MAWR).

75. Mémoire intégrée à semiconducteurs suivant la revendication 74, caractérisée par le fait qu'un étage d'entrée (INWR) comporte un dispositif tampon (BF) pour la donnée appliquée sur la ligne de transmission de données d'entrée/sortie du type respectif (IO1; IO2), et qu'il comporte deux circuits ET (AND) qui ont chacun deux entrées et une sortie et qui sont branchés en aval du dispositif tampon (BF), la première entrée d'un circuit ET (AND) étant reliée à la sortie du dispositif tampon (BF), tandis que la première entrée de l'autre circuit ET (AND) est reliée, par l'intermédiaire d'un inverseur, à la sortie du dispositif tampon (BF) et que les secondes entrées des circuits ET (AND) sont chargées par le signal de commande d'enregistrement (WR).

76. Mémoire intégrée à semiconducteurs suivant la revendication 74 ou 75, caractérisée par le fait qu'au moins l'un des circuits ET (AND) comporte une porte NON-ET à deux entrées, et un inverseur branché en aval de la porte NON-ET.

77. Mémoire intégrée à semiconducteurs suivant l'une des revendications précédentes, caractérisée par le fait qu'elle comporte au moins une ligne redondante de transmission de mots (WLred) qui comporte des cellules de mémoire redondantes (MCred), et qui, dans le cas d'une redondance, peut être sélectionnée par l'intermédiaire d'un décodeur (WCDECred) redondant de lignes de transmission de mots et que dans le cas d'une redondance, les cellules de mémoire redondantes (MCred) peuvent être reliées aux lignes correspondantes du bus de transmission de données de blocs (BKDB), par l'intermédiaire des amplificateurs de lecture (SA) et des interrupteurs de transmission de bits (BSW) des cellules de mémoire remplacées (MC).

78. Mémoire intégrée à semiconducteurs suivant l'une des revendications précédentes, caractérisée par le fait qu'elle comporte au moins un groupe de M couples de lignes redondantes (BLred) de transmission de bits à cellules de mémoire redondantes (MCred), M amplificateurs de lecture redondants (SAred) et un bloc redondant d'interrupteurs de transmission de bits (BKBSWred), groupe qui, dans le cas d'une redondance, peut être sélectionné par l'intermédiaire d'un décodeur de groupes de bits de redondance (BITDECred) conjointement avec le signal redondant associé de sélection de groupes de bits (BITSIGred) et qui peut être relié aux lignes correspondantes du bus de transmission de données de blocs (BKDB).

79. Procédé pour remplacer des cellules de mémoire (MC) par des cellules de mémoire redondantes (MCred) dans une mémoire à semiconducteurs suivant la revendication 77 ou 78, selon lequel on utilise un automate de test et de réparation, qui est commandé par ordinateur et qui comporte des algorithmes et des moyens pour remplacer les cellules de mémoire (MC),
caractérisé par le fait que toutes les cellules de mémoire (MC) de la mémoire à semiconducteurs sont testées dans le mode de fonctionnement de test, que lors de chaque identification d'un défaut, chaque groupe défectueux de cellules de mémoire (MC) est identifié, par l'intermédiaire de son adresse (ADR) appliquée de l'extérieur et par l'intermédiaire de la ligne respective de transmission de données d'entrée/sortie (IO1, IO2, IO3), dans laquelle le défaut est identifié, au moyen du dispositif de test en parallèle (PT) et de l'automate de test, à l'intérieur de la mémoire à semiconducteurs, et que les données d'identification ainsi obtenues pour tous les groupes défectueux de cellules de mémoire sont envoyées à l'automate de réparation, qui remplace alors les groupes de cellules de mémoire comportant des cellules de mémoire défectueuses (MC), moyennant l'utilisation des données d'identification.

80. Procédé pour remplacer des cellules de mémoire (MC) par des cellules de mémoire redondante (MCred) dans une mémoire à semiconducteurs suivant la revendication 77 ou 78, selon lequel on utilise un automate de test et de réparation qui est commandé par ordinateur et qui comporte des algorithmes et des moyens pour remplacer les cellules de mémoire (MC),
caractérisé par le fait que toutes les cellules de mémoire (MC) de la mémoire à semiconducteurs sont testées dans le mode de fonctionnement de test, que pour chaque défaut identifié, chaque cellule de mémoire défectueuse (MC) est identifiée, par l'intermédiaire de son adresse (ADR) appliquée de l'extérieur et par l'intermédiaire de la ligne respective de transmission de données d'entrée/sortie (IO1, IO2, IO3), dans laquelle le défaut est identifié, au moyen du dispositif de test en parallèle (PT) et de l'automate de test, à l'intérieur de la mémoire à semiconducteurs, et que les données d'identification ainsi obtenues pour toutes les cellules de mémoire défectueuses (MC) sont envoyées à l'automate de réparation, qui remplace alors les cellules de mémoire défectueuses (MC), moyennant l'utilisation des données d'identification.

65

# FIG 1

# FIG 2

# FIG 3

# FIG 4

GPIO

# FIG 5

GPCTRL

# FIG 6

GPWR

GPDB-WR$_1$ ←

AND

GPDB-WR$_M$ ←

AND

DMUXWR

← IODB-WR

← GPAD'$_1$

← GPAD'$_M$

$\overline{GPDB\text{-}WR_1}$ ←

AND

$\overline{GPDB\text{-}WR_M}$ ←

AND

DMUXWR

← $\overline{IODB\text{-}WR}$

← GPAD'$_1$

← GPAD'$_M$

EP 0 527 866 B1

# FIG 7

GPRD

GPDB-RD$_1$
GPAD'$_1$
⋮
GPDB-RD$_M$
GPAD'$_M$

GPout1

MUXRD

$\overline{GPDB\text{-}RD}_1$
GPAD'$_1$
⋮
$\overline{GPDB\text{-}RD}_M$
GPAD'$_M$

GPout2

MUXRD

72

# FIG 8

GPTest

# FIG 9

MAIO

$$U = R * P$$

# F I G 10

MACTRL

DECRD

DECWR

# FIG 11

MARD

# FIG 12

MAWR

F I G 13

# FIG 14

# FIG 15

GPIO

M = Q*N

# FIG 16

GPCTRL

# FIG 17

# FIG 18

GPRD

GPDB-RD$_{n,1}$ →

GPAD'$_1$ →

GPDB-RD$_{n,Q}$ →

GPAD'$_Q$ →

→ IODB-RD$_n$

GPMUXRD

$\overline{GPDB-RD}_{n,1}$ →

GPAD'$_1$ →

$\overline{GPDB-RD}_{n,Q}$ →

GPAD'$_Q$ →

→ $\overline{IODB-RD}_n$

GPMUXRD

$\overline{GPDB-RD}_{n,2}$ →

LOGRD

GPDB-RD$_{n,2}$ →

AND

AND

B

IO3

GPOUTRD

$\overline{GPDB-RD}_{n,Q}$ →

LOGRD

GPDB-RD$_{n,Q}$ →

AND

AND

B

IO3

GPOUTRD

Test

RD

# FIG 19

MAIO

# FIG 20

MACTRL

# FIG 21

# FIG 22

## MAWR

# FIG 23

# FIG 24